# EUROPEAN PATENT APPLICATION

(11) **EP 2 717 333 A2**
(43) Date of publication of application: **09.04.2014**
(21) Application number: 13187076.8
(22) Date of filing: 02.10.2013
(51) Int. Cl.: H01L 33/00, H01L 33/54

(54) **Encapsulating sheet-covered semiconductor element, producing method thereof, semiconductor device, and producing method thereof**

(30) Priority: 03.10.2012 JP 2012221655; 28.08.2013 JP 2013176712
(71) Applicant: NITTO DENKO CORPORATION, Ibaraki-shi, Osaka 567-8680 (JP)
(72) Inventor: Katayama, Hiroyuki, Osaka, 567-8680 (JP); Kondo, Takashi, Osaka, 567-8680 (JP); Ebe, Yuki, Osaka, 567-8680 (JP); Mitani, Munehisa, Osaka, 567-8680 (JP); Ooyabu, Yasunari, Osaka, 567-8680 (JP)
(74) Representative: HOFFMANN EITLE

(57) **Abstract**

A method for producing an encapsulating sheet-covered semiconductor element includes a semiconductor element disposing step of disposing a plurality of semiconductor elements at spaced intervals to each other and an encapsulating sheet disposing step of disposing an encapsulating sheet so as to cover a plurality of the semiconductor elements and to form a space over the semiconductor elements adjacent to each other.

## Description

### BACKGROUND OF THE INVENTION

### Field of the Invention

The present invention relates to an encapsulating sheet-covered semiconductor element, a producing method thereof, a semiconductor device, and a producing method thereof, to be specific, to a method for producing an encapsulating sheet-covered semiconductor element, an encapsulating sheet-covered semiconductor element obtained by the method, a method for producing a semiconductor device using the encapsulating sheet-covered semiconductor element, and a semiconductor device obtained by the method.

### Description of Related Art

As a method for producing an optical semiconductor device including an optical semiconductor element or an electronic device including an electronic element, a method in which first, a plurality of semiconductor elements (the optical semiconductor elements or the electronic elements) are mounted on a substrate and next, an encapsulating layer is provided so as to cover a plurality of the semiconductor elements has been known.

Among all, when the optical semiconductor element and the optical semiconductor device are an LED and an LED device, respectively, unevenness in emission wavelength and luminous efficiency is generated between a plurality of the LEDs, so that in such an LED device mounted with the LED, there is a disadvantage that unevenness in light emission is generated between a plurality of the LEDs.

In order to solve such a disadvantage, it has been considered that, for example, a plurality of LEDs are covered with a phosphor layer to fabricate a plurality of phosphor layer-covered LEDs and thereafter, the phosphor layer-covered LED is selected in accordance with the emission wavelength and the luminous efficiency to be then mounted on a substrate.

For example, a chip component obtained by the following method has been proposed (ref: for example, Japanese Unexamined Patent Publication No. 2001-308116). In the method, a chip is attached onto a silica glass substrate via a pressure-sensitive adhesive sheet; next, a resin is applied onto the chip so as to be in contact with the upper surface of the silica glass substrate to fabricate dummy wafers made of the chips covered with the resin; thereafter, the dummy wafers are peeled from the silica glass substrate and the pressure-sensitive adhesive sheet; and then, the obtained dummy wafers are subjected to dicing on a chip basis to be singulated so as to produce the chip component. The chip component in Japanese Unexamined Patent Publication No. 2001-308116 is to be then mounted on a substrate, so that a semiconductor device can be obtained.

### SUMMARY OF THE INVENTION

The resin applied onto the chip, however, may be relatively hard in accordance with the purpose and use. In such a case, large stress is applied from the resin that is applied so as to be in contact with the upper surface of the silica glass substrate to the chip in the plane direction of the silica glass substrate. Then, in the chip, a shift of position (a chip shift) in which the chip is shifted from the predetermined position that is initially set in the silica glass substrate is generated and thus, a great unevenness in a size of the resin that encapsulates the chip after being subjected to dicing is generated. As a result, there is a disadvantage that unevenness in various properties in the semiconductor device is generated.

Among all, when the chip is covered using a resin sheet that is formed from a resin into a sheet shape, the above-described chip shift is obvious.

It is an object of the present invention to provide a method for producing an encapsulating sheet-covered semiconductor element in which a shift of position of a semiconductor element is capable of being suppressed, an encapsulating sheet-covered semiconductor element obtained by the method, a method for producing a semiconductor device using the encapsulating sheet-covered semiconductor element, and a semiconductor device obtained by the method.

A method for producing an encapsulating sheet-covered semiconductor element of the present invention includes a semiconductor element disposing step of disposing a plurality of semiconductor elements at spaced intervals to each other and an encapsulating sheet disposing step of disposing an encapsulating sheet so as to cover a plurality of the semiconductor elements and to form a space over the semiconductor elements adjacent to each other.

In the present invention, the encapsulating sheet is disposed so as to cover a plurality of the semiconductor elements and to form a space over the semiconductor elements that are adjacent to each other, so that when the encapsulating sheet is brought into contact with a plurality of the semiconductor elements, the stress applied from the encapsulating sheet to a plurality of the semiconductor elements is capable of being released to the space. Thus, the stress applied from the encapsulating sheet to a plurality of the semiconductor elements is capable of being reduced. As a result, the encapsulating sheet-covered semiconductor element in which the shift of position of the semiconductor element is suppressed is capable of being produced.

In the method for producing an encapsulating sheet-covered semiconductor element of the present invention, it is preferable that the encapsulating sheet exposes a portion of opposed surfaces of the semiconductor elements that are opposed to each other.

According to the present invention, a portion of the opposed surfaces of the semiconductor elements that are opposed to each other is exposed, so that the above-described space is capable of being surely formed.

In the method for producing an encapsulating sheet-covered semiconductor element of the present invention, it is preferable that the semiconductor element is an optical semiconductor element; it is preferable that the optical semiconductor element is an LED; and it is preferable that the encapsulating sheet is a phosphor sheet containing a phosphor.

According to the present invention, the optical semiconductor element is covered with the phosphor sheet containing the phosphor, so that a wavelength of light emitted from the optical semiconductor element is converted by the phosphor sheet and thus, light having high energy is capable of being emitted.

An encapsulating sheet-covered semiconductor element of the present invention is obtained by the above-described method for producing an encapsulating sheet-covered semiconductor element.

In the encapsulating sheet-covered semiconductor element of the present invention, a shift of position of the semiconductor element is suppressed, so that unevenness in size is suppressed. Thus, stable properties are capable of being ensured.

A method for producing a semiconductor device of the present invention includes the steps of preparing the above-described encapsulating sheet-covered semiconductor element and mounting the semiconductor element of the encapsulating sheet-covered semiconductor element on a substrate or mounting a plurality of the semiconductor elements on a substrate in advance.

The method for producing a semiconductor device of the present invention includes the step of preparing the encapsulating sheet-covered semiconductor element in which stable properties are ensured, so that the semiconductor device having stable properties is capable of being produced.

A semiconductor device of the present invention is obtained by the above-described method for producing a semiconductor device.

The semiconductor device of the present invention is capable of ensuring stable properties.

According to the method for producing a semiconductor device of the present invention, the encapsulating sheet-covered semiconductor element in which a shift of position of the semiconductor element is suppressed is capable of being produced.

The encapsulating sheet-covered semiconductor element of the present invention is capable of ensuring stable properties.

### BRIEF DESCRIPTION OF THE DRAWINGS

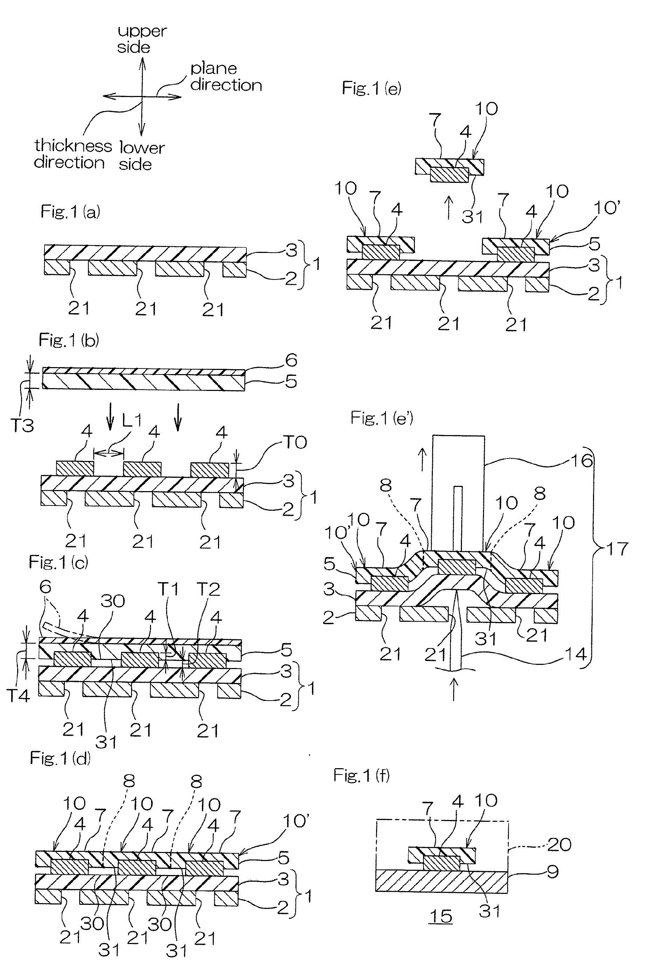

FIG. 1 shows process drawings for illustrating a first embodiment of a method for producing an encapsulating sheet-covered semiconductor element and a method for producing a semiconductor device of the present invention:
   FIG. 1 (a) illustrating a step of preparing a support sheet (a support sheet preparing step),
   FIG. 1 (b) illustrating a step of disposing LEDs on the upper surface of the support sheet (an LED disposing step),
   FIG. 1 (c) illustrating a step of disposing a phosphor sheet so as to cover the LEDs and to form a space over the LEDs that are adjacent to each other (a phosphor sheet disposing step),
   FIG. 1 (d) illustrating a step of encapsulating the upper portions of the LEDs by the phosphor sheet (an LED encapsulating step) and a step of cutting the phosphor sheet (a cutting step),
   FIG. 1 (e) illustrating a step of peeling phosphor layer-covered LEDs from the support sheet (an LED peeling step),
   FIG. 1 (e') illustrating a step of describing the details of a state of peeling the phosphor layer-covered LEDs from a pressure-sensitive adhesive layer using a pick-up device in the LED peeling step in FIG. 1 (e), and
   FIG. 1 (f) illustrating a step of mounting the phosphor layer-covered LED on a substrate (a mounting step).
FIG. 2 shows a plan view of the support sheet shown in FIG. 1 (a).
FIG. 3 shows process drawings for illustrating a modified example of the first embodiment:
   FIG. 3 (a) illustrating a step of disposing a phosphor sheet so as to cover LEDs and to form a space over the LEDs that are adjacent to each other (a phosphor sheet disposing step),
   FIG. 3 (b) illustrating a step of encapsulating the upper surfaces of the LEDs by the phosphor sheet (an LED encapsulating step) and a step of cutting the phosphor sheet (a cutting step),
   FIG. 3 (c) illustrating a step of peeling phosphor layer-covered LEDs from a support sheet (an LED peeling step), and
   FIG. 3 (d) illustrating a step of mounting the phosphor layer-covered LED on a substrate (a mounting step).
FIG. 4 shows process drawings for illustrating a modified example of the first embodiment:
   FIG. 4 (a) illustrating a step of disposing a phosphor sheet so as to cover LEDs and to form a space over the LEDs that are adjacent to each other (a phosphor sheet disposing step),
   FIG. 4 (b) illustrating a step of encapsulating the surfaces of the LEDs by the phosphor sheet (an LED encapsulating step) and a step of cutting the phosphor sheet (a cutting step),
   FIG. 4 (c) illustrating a step of peeling phosphor layer-covered LEDs from a support sheet (an LED peeling step), and
   FIG. 4 (d) illustrating a step of mounting the phosphor layer-covered LED on a substrate (a mounting step).
FIG. 5 shows a modified example of the LED peeling step shown in FIGS. 1 (e) and 1 (e') and shows a modified example of peeling a plurality of phosphor layer-covered LEDs that are not singulated.
FIG. 6 shows process drawings for illustrating a second embodiment of a method for producing an encapsulating sheet-covered semiconductor element and a method for producing a semiconductor device of the present invention:
   FIG. 6 (a) illustrating a step of preparing a support sheet (a support sheet preparing step),
   FIG. 6 (b) illustrating a step of disposing LEDs on the support sheet (an LED disposing step),
   FIG. 6 (c) illustrating a step of disposing a phosphor sheet so as to cover the LEDs and to form a space over the LEDs that are adjacent to each other (a phosphor sheet disposing step),
   FIG. 6 (d) illustrating a step of encapsulating the upper portions of the LEDs by the phosphor sheet (an LED encapsulating step) and a step of cutting the phosphor sheet (a cutting step),
   FIG. 6 (e) illustrating a step of peeling phosphor layer-covered LEDs from the support sheet (an LED peeling step), and
   FIG. 6 (f) illustrating a step of mounting the phosphor layer-covered LED on a substrate (a mounting step).
FIG. 7 shows a plan view of the support sheet shown in FIG. 6 (a).
FIG. 8 shows process drawings for illustrating a third embodiment of a method for producing an encapsulating sheet-covered semiconductor element and a method for producing a semiconductor device of the present invention:
   FIG. 8 (a) illustrating a step of preparing a support sheet (a support sheet preparing step),
   FIG. 8 (b) illustrating a step of disposing LEDs on the support sheet (an LED disposing step),
   FIG. 8 (c) illustrating a step of disposing a phosphor sheet so as to cover the LEDs and to form a space over the LEDs that are adjacent to each other (a phosphor sheet disposing step),
   FIG. 8 (d) illustrating a step of encapsulating the upper portions of the LEDs by the phosphor sheet (an LED encapsulating step) and a step of cutting the phosphor sheet (a cutting step),
   FIG. 8 (e) illustrating a step of peeling a support substrate from a pressure-sensitive adhesive layer (a support substrate peeling step),
   FIG. 8 (f) illustrating a step of peeling phosphor layer-covered LEDs from the pressure-sensitive adhesive layer (an LED peeling step),

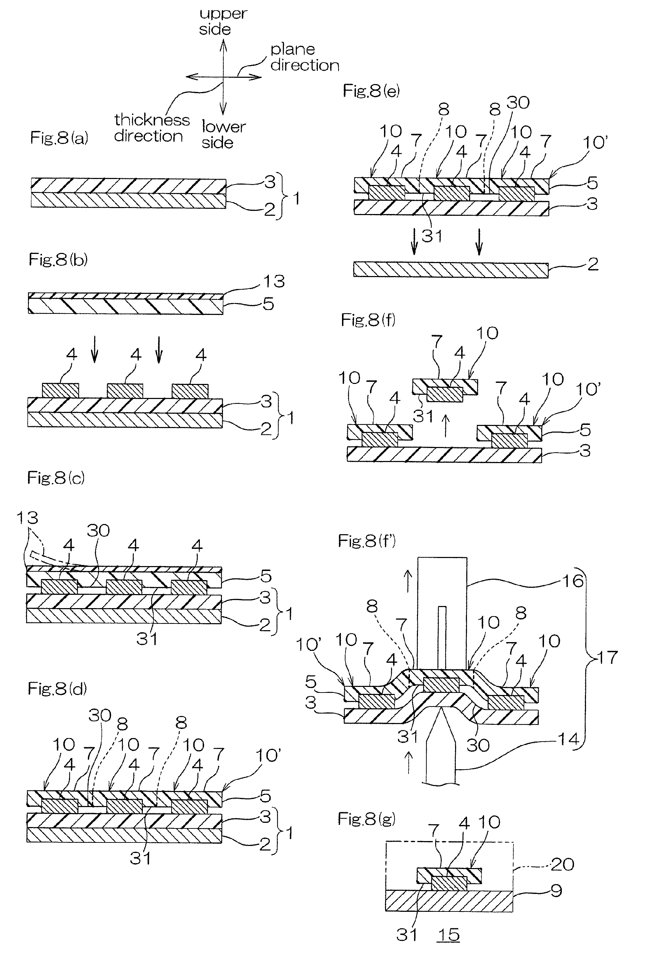

   FIG. 8 (f') illustrating a step of describing the details of a state of peeling the phosphor layer-covered LEDs from the pressure-sensitive adhesive layer using a pick-up device in the LED peeling step in FIG. 8 (f), and
FIG. 8 (g) illustrating a step of mounting the phosphor layer-covered LED on a substrate (a mounting step).

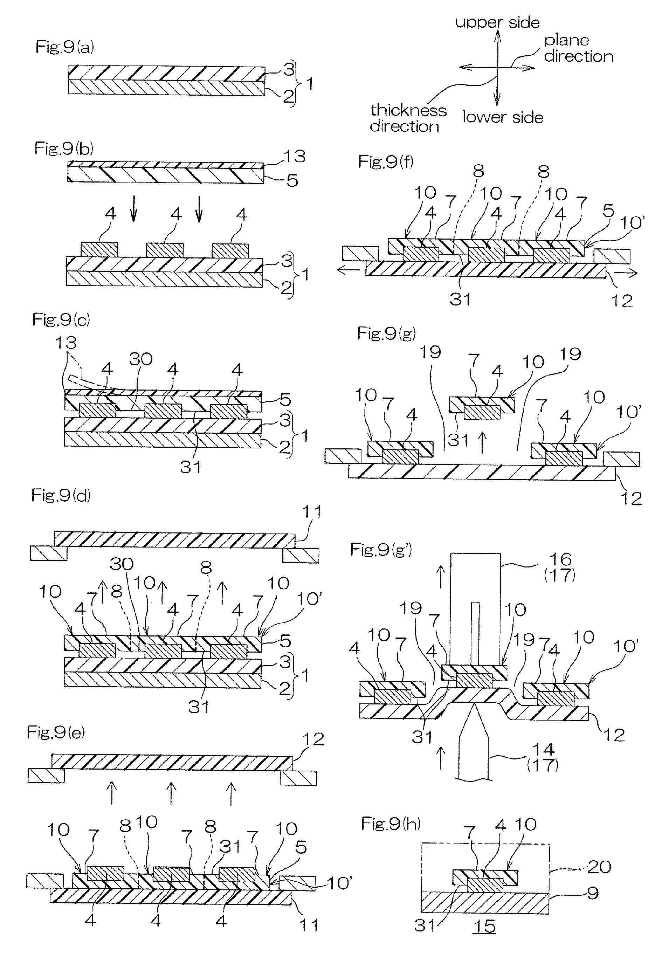

FIG. 9 shows process drawings for illustrating a fourth embodiment of a method for producing an encapsulating sheet-covered semiconductor element and a method for producing a semiconductor device of the present invention:
   FIG. 9 (a) illustrating a step of preparing a support sheet (a support sheet preparing step),
   FIG. 9 (b) illustrating a step of disposing LEDs on the support sheet (an LED disposing step),
   FIG. 9 (c) illustrating a step of disposing a phosphor sheet so as to cover the LEDs and to form a space over the LEDs that are adjacent to each other (a phosphor sheet disposing step),
   FIG. 9 (d) illustrating a step of encapsulating the upper portions of the LEDs by the phosphor sheet (an LED encapsulating step) and a step of cutting the phosphor sheet (a cutting step),
   FIG. 9 (e) illustrating a step of transferring phosphor layer-covered LEDs onto a transfer sheet (a first transfer step),
   FIG. 9 (f) illustrating a step of transferring the phosphor layer-covered LEDs onto a stretchable support sheet (a second transfer step),
   FIG. 9 (g) illustrating a step of peeling the phosphor layer-covered LEDs from the stretchable support sheet (a re-releasing step),
   FIG. 9 (g') illustrating a step of describing the details of a state of peeling the phosphor layer-covered LEDs from the stretchable support sheet using a pick-up device in the re-releasing step in FIG. 9 (g), and
   FIG. 9 (h) illustrating a step of mounting the phosphor layer-covered LED on a substrate (a mounting step).

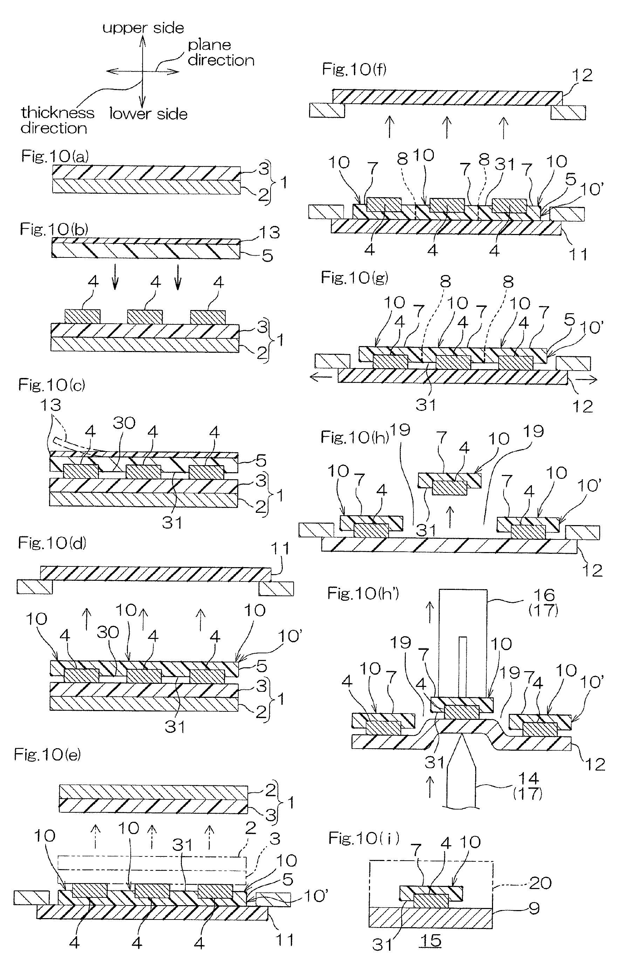

FIG. 10 shows process drawings for illustrating a fifth embodiment of a method for producing an encapsulating sheet-covered semiconductor element and a method for producing a semiconductor device of the present invention:
   FIG. 10 (a) illustrating a step of preparing a support sheet (a support sheet preparing step),
   FIG. 10 (b) illustrating a step of disposing LEDs on the support sheet (an LED disposing step),
   FIG. 10 (c) illustrating a step of disposing a phosphor sheet so as to cover the LEDs and to form a space over the LEDs that are adjacent to each other (a phosphor sheet disposing step),
   FIG. 10 (d) illustrating a step of encapsulating the upper portions of the LEDs by the phosphor sheet (an LED encapsulating step),
   FIG. 10 (e) illustrating a step of transferring phosphor layer-covered LEDs onto a transfer sheet (a first transfer step),
   FIG. 10 (f) illustrating a step of cutting the phosphor sheet (a cutting step),
   FIG. 10 (g) illustrating a step of transferring the phosphor layer-covered LEDs onto a stretchable support sheet (a second transfer step),
   FIG. 10 (h) illustrating a step of peeling the phosphor layer-covered LEDs from the stretchable support sheet (a re-releasing step),
   FIG. 10 (h') illustrating a step of describing the details of a state of peeling the phosphor layer-covered LEDs from the stretchable support sheet using a pick-up device in the re-releasing step in FIG. 10 (h), and
   FIG. 10 (i) illustrating a step of mounting the phosphor layer-covered LED on a substrate (a mounting step).

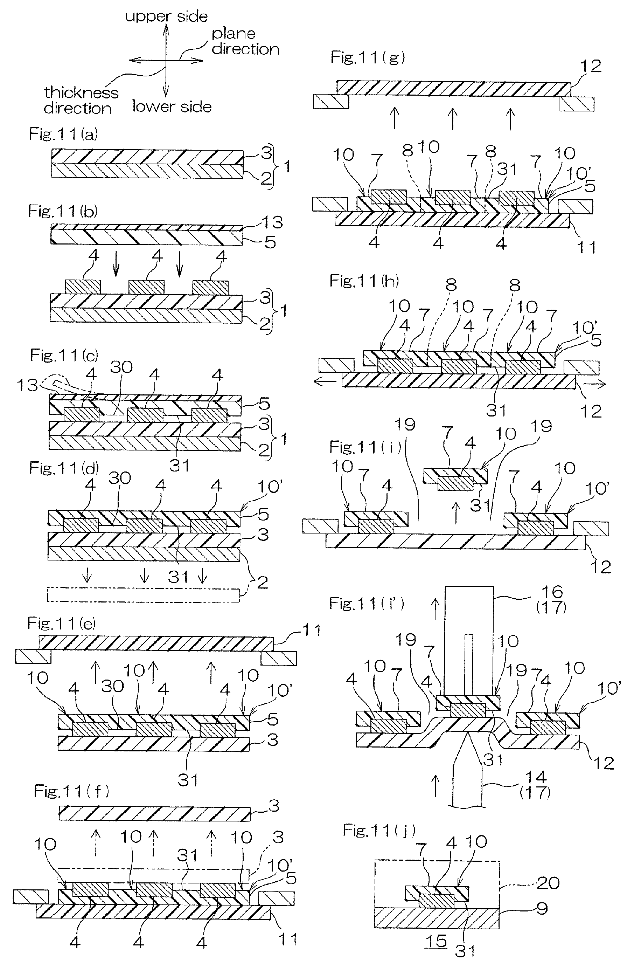

FIG. 11 shows process drawings for illustrating a sixth embodiment of a method for producing an encapsulating sheet-covered semiconductor element and a method for producing a semiconductor device of the present invention:
   FIG. 11 (a) illustrating a step of preparing a support sheet (a support sheet preparing step),
   FIG. 11 (b) illustrating a step of disposing LEDs on the support sheet (an LED disposing step),
   FIG. 11 (c) illustrating a step of disposing a phosphor sheet so as to cover the LEDs and to form a space over the LEDs that are adjacent to each other (a phosphor sheet disposing step),
   FIG. 11 (d) illustrating a step of encapsulating the upper portions of the LEDs by the phosphor sheet (an LED encapsulating step),
   FIG. 11 (e) illustrating a step of peeling a support substrate from a pressure-sensitive adhesive layer (a support substrate peeling step),
   FIG. 11 (f) illustrating a step of transferring phosphor layer-covered LEDs onto a transfer sheet (a first transfer step),
   FIG. 11 (g) illustrating a step of peeling the pressure-sensitive adhesive layer from the phosphor layer-covered LEDs (a pressure-sensitive adhesive layer peeling step) and a step of cutting the phosphor sheet (a cutting step),
   FIG. 11 (h) illustrating a step of transferring the phosphor layer-covered LEDs onto a stretchable support sheet (a second transfer step),
   FIG. 11 (i) illustrating a step of peeling the phosphor layer-covered LEDs from the stretchable support sheet (a re-releasing step),
   FIG. 11 (i') illustrating a step of describing the details of a state of peeling the phosphor layer-covered LEDs from the stretchable support sheet using a pick-up device in the re-releasing step in FIG. 11 (i), and
   FIG. 11 (j) illustrating a step of mounting the phosphor layer-covered LED on a substrate (a mounting step).

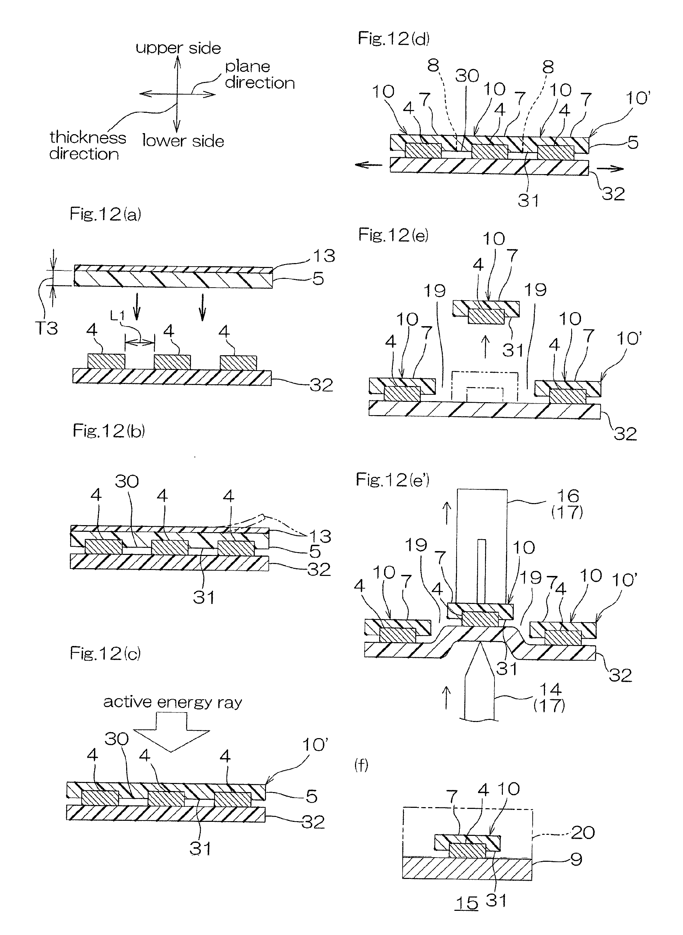

FIG. 12 shows process drawings for illustrating a seventh embodiment of a method for producing an encapsulating sheet-covered semiconductor element and a method for producing a semiconductor device of the present invention:
   FIG. 12 (a) illustrating a step of disposing LEDs on the upper surface of a support sheet (an LED disposing step),
   FIG. 12 (b) illustrating a step of disposing a phosphor sheet so as to cover the LEDs and to form a space over the LEDs that are adjacent to each other (a phosphor sheet disposing step),
   FIG. 12 (c) illustrating a step of applying an active energy ray to the phosphor sheet to be cured and encapsulating the upper portions of the LEDs by the phosphor sheet (an LED encapsulating step),
   FIG. 12 (d) illustrating a step of cutting the phosphor sheet (a cutting step),
   FIG. 12 (e) illustrating a step of peeling phosphor layer-covered LEDs from the support sheet (an LED peeling step),
   FIG. 12 (e') illustrating a step of describing the details of a state of peeling the phosphor layer-covered LEDs from the support sheet using a pick-up device in the LED peeling step in FIG. 12 (e), and
   FIG. 12 (f) illustrating a step of mounting the phosphor layer-covered LED on a substrate (a mounting step).

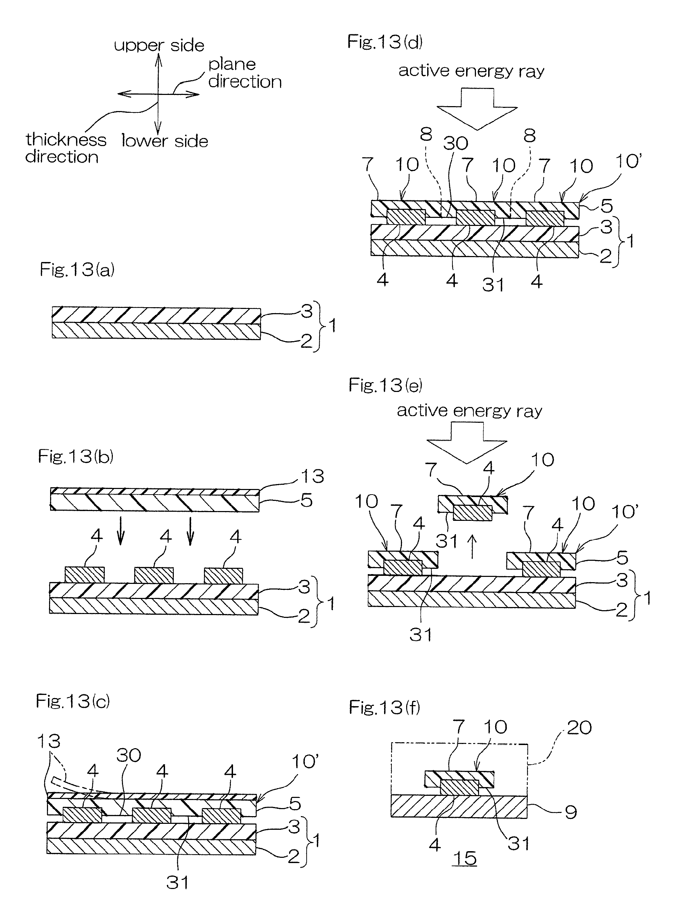

FIG. 13 shows process drawings for illustrating an eighth embodiment of a method for producing an encapsulating sheet-covered semiconductor element and a method for producing a semiconductor device of the present invention:
   FIG. 13 (a) illustrating a step of preparing a support sheet (a support sheet preparing step),
   FIG. 13 (b) illustrating a step of disposing LEDs on the support sheet (an LED attaching step),
   FIG. 13 (c) illustrating a step of disposing a phosphor sheet so as to cover the LEDs and to form a space over the LEDs that are adjacent to each other (a phosphor sheet disposing step),
   FIG. 13 (d) illustrating a step of encapsulating the upper portions of the LEDs by the phosphor sheet (an LED encapsulating step) and a step of cutting the phosphor sheet (a cutting step),
   FIG. 13 (e) illustrating a step of peeling phosphor layer-covered LEDs from the support sheet (an LED peeling step), and
   FIG. 13 (f) illustrating a step of mounting the phosphor layer-covered LED on a substrate (a mounting step).

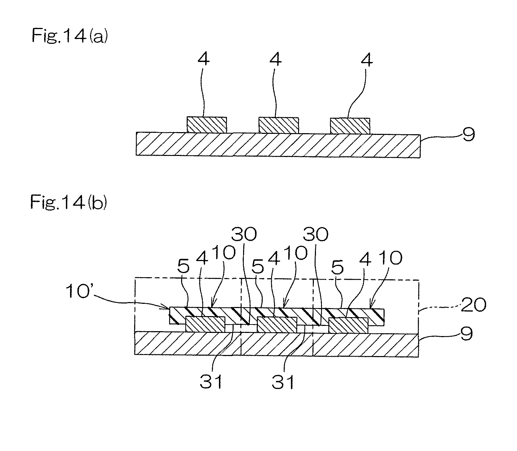

FIG. 14 shows process drawings for illustrating a ninth embodiment of a method for producing an encapsulating sheet-covered semiconductor element and a method for producing a semiconductor device of the present invention:
   FIG. 14 (a) illustrating a step of mounting LEDs on a substrate in advance and
   FIG. 14 (b) illustrating a step of disposing a phosphor sheet so as to cover the LEDs and to form a space over the LEDs that are adjacent to each other to obtain an LED device.

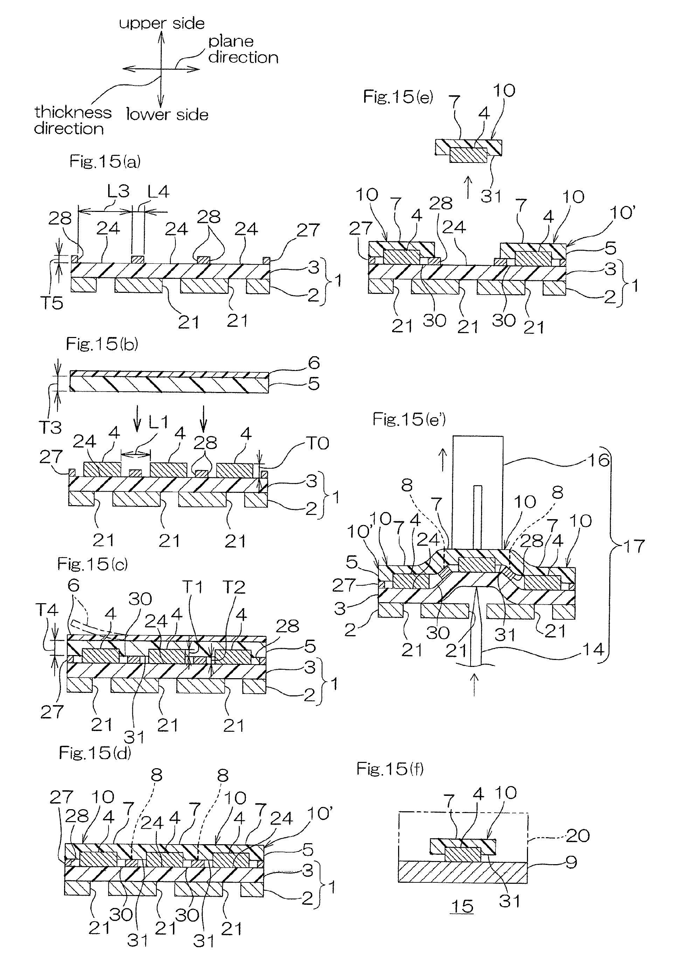

FIG. 15 shows process drawings for illustrating a tenth embodiment of a method for producing an encapsulating sheet-covered semiconductor element and a method for producing a semiconductor device of the present invention:
   FIG. 15 (a) illustrating a step of preparing a support sheet (a support sheet preparing step) and a step of disposing a spacer on the support sheet (a spacer disposing step),
   FIG. 15 (b) illustrating a step of disposing LEDs on the upper surface of the support sheet (an LED disposing step),
   FIG. 15 (c) illustrating a step of disposing a phosphor sheet so as to cover the LEDs and to form a space over the LEDs that are adjacent to each other (a phosphor sheet disposing step),
   FIG. 15 (d) illustrating a step of encapsulating the upper portions of the LEDs by the phosphor sheet (an LED encapsulating step) and a step of cutting the phosphor sheet (a cutting step),
   FIG. 15 (e) illustrating a step of peeling phosphor layer-covered LEDs from the support sheet (an LED peeling step),
   FIG. 15 (e') illustrating a step of describing the details of a state of peeling the phosphor layer-covered LEDs from a pressure-sensitive adhesive layer using a pick-up device in the LED peeling step in FIG. 15 (e), and
   FIG. 15 (f) illustrating a step of mounting the phosphor layer-covered LED on a substrate (a mounting step).

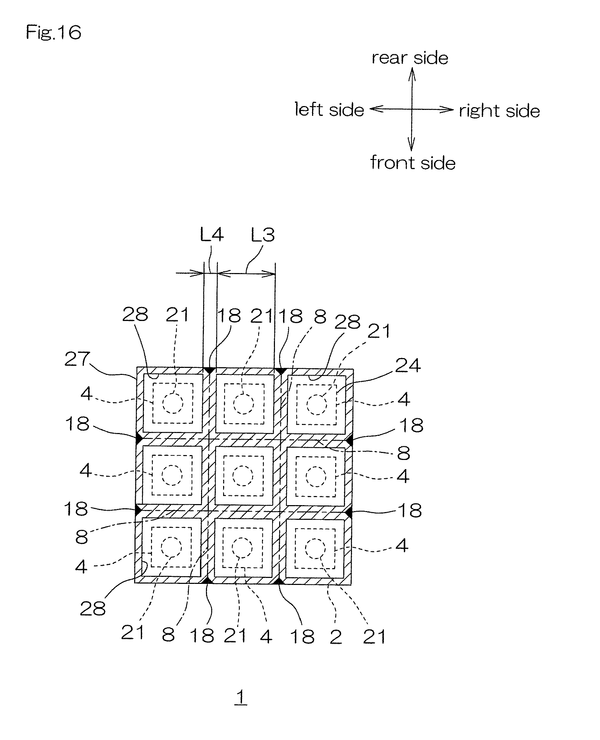

FIG. 16 shows a plan view of the support sheet on which the spacer is disposed shown in FIG. 15 (a).

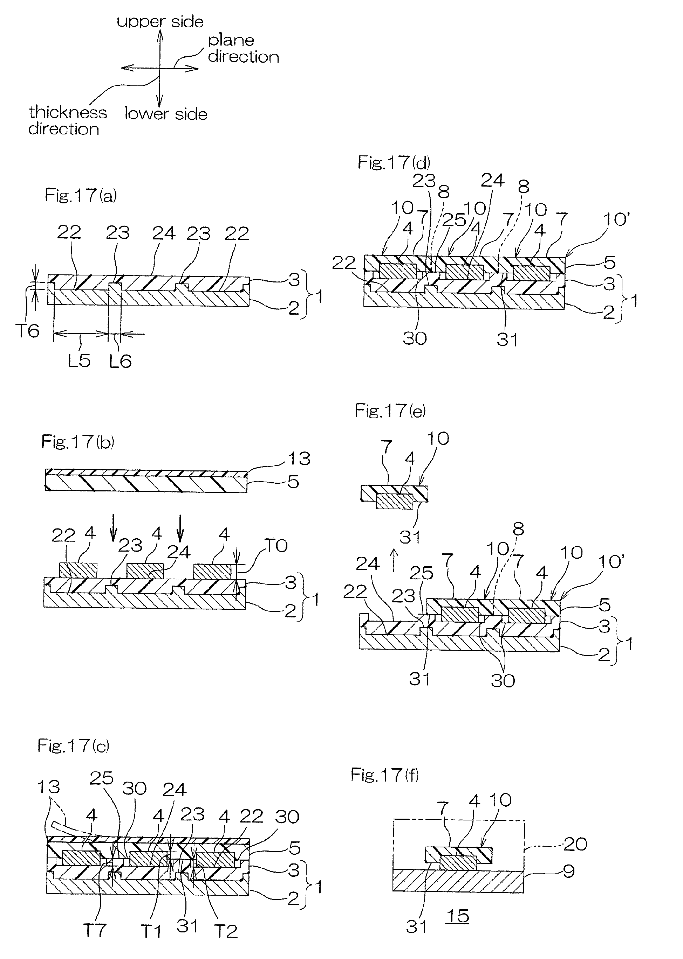

FIG. 17 shows process drawings for illustrating an eleventh embodiment of a method for producing an encapsulating sheet-covered semiconductor element and a method for producing a semiconductor device of the present invention:
   FIG. 17 (a) illustrating a step of preparing a support sheet including a support substrate in which support concave portions are provided (a support sheet preparing step),
   FIG. 17 (b) illustrating a step of disposing LEDs on the upper surface of the support sheet (an LED disposing step),
   FIG. 17 (c) illustrating a step of forming pressure-sensitive adhesive protruding portions and disposing a phosphor sheet so as to cover the LEDs and to form a space over the LEDs that are adjacent to each other (a phosphor sheet disposing step),
   FIG. 17 (d) illustrating a step of encapsulating the upper portions of the LEDs by the phosphor sheet (an LED encapsulating step) and a step of cutting the phosphor sheet (a cutting step),
   FIG. 17 (e) illustrating a step of peeling phosphor layer-covered LEDs from the support sheet (an LED peeling step), and
   FIG. 17 (f) illustrating a step of mounting the phosphor layer-covered LED on a substrate (a mounting step).

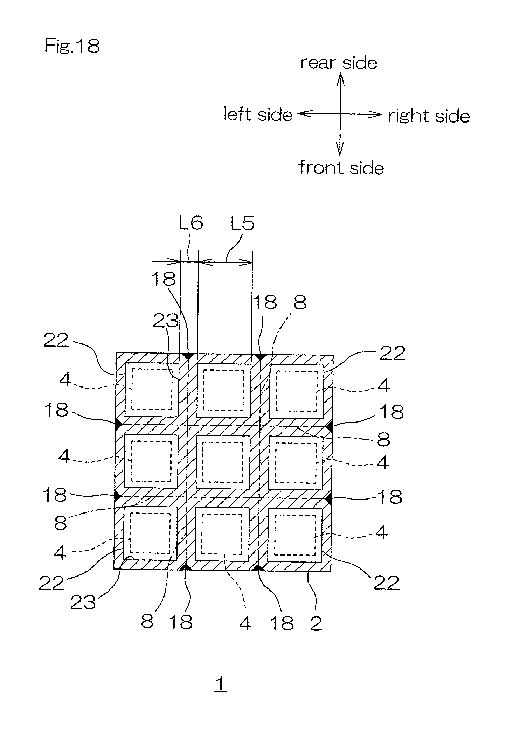

FIG. 18 shows a plan view of the support sheet shown in FIG. 17 (a).

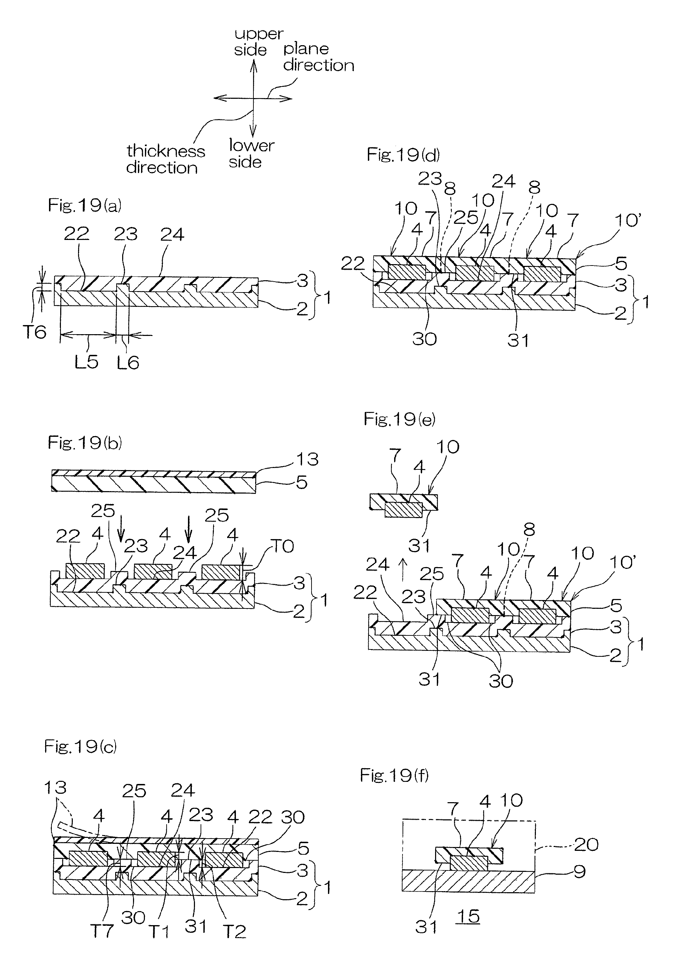

FIG. 19 shows process drawings for illustrating a modified example of the eleventh embodiment of a method for producing an encapsulating sheet-covered semiconductor element and a method for producing a semiconductor device of the present invention:
   FIG. 19 (a) illustrating a step of preparing a support sheet including a support substrate in which support concave portions are provided (a support sheet preparing step),
   FIG. 19 (b) illustrating a step of disposing LEDs on the upper surface of the support sheet and forming pressure-sensitive adhesive protruding portions (an LED disposing step),
   FIG. 19 (c) illustrating a step of disposing a phosphor sheet so as to cover the LEDs and to form a space over the LEDs that are adjacent to each other (a phosphor sheet disposing step),
   FIG. 19 (d) illustrating a step of encapsulating the upper portions of the LEDs by the phosphor sheet (an LED encapsulating step) and a step of cutting the phosphor sheet (a cutting step),
   FIG. 19 (e) illustrating a step of peeling phosphor layer-covered LEDs from the support sheet (an LED peeling step), and
FIG. 19 (f) illustrating a step of mounting the phosphor layer-covered LED on a substrate (a mounting step).

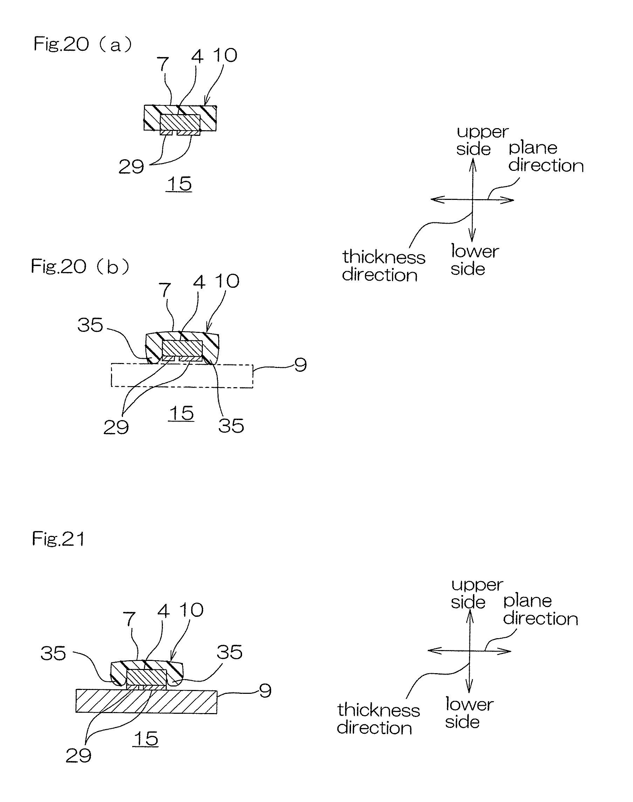

FIG. 20 shows side views of a phosphor layer-covered LED serving as Comparative Example of the present invention:
   FIG. 20 (a) illustrating a step of fabricating the phosphor layer-covered LED in which the lower portions of the side surfaces of an LED are covered with a phosphor layer and
   FIG. 20 (b) illustrating a step of flip-chip mounting the phosphor layer-covered LED by heating.
FIG. 21 shows a side view of a phosphor layer-covered LED in which the lower portions of the side surfaces of an LED are exposed.

### DETAILED DESCRIPTION OF THE INVENTION

A method for producing an encapsulating sheet-covered semiconductor element of the present invention includes a semiconductor element disposing step of disposing a plurality of semiconductor elements at spaced intervals to each other and a phosphor sheet disposing step of disposing an encapsulating sheet so as to cover a plurality of the semiconductor elements and to form a space over the semiconductor elements that are adjacent to each other.

In the following, by the first to eleventh embodiments, a method for producing an encapsulating sheet-covered semiconductor element of the present invention is described with reference to FIGS. 1 to 21.

### <First Embodiment>

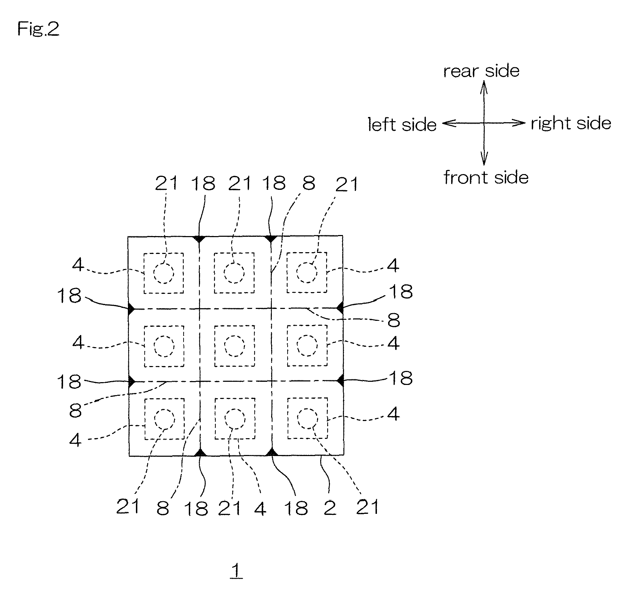

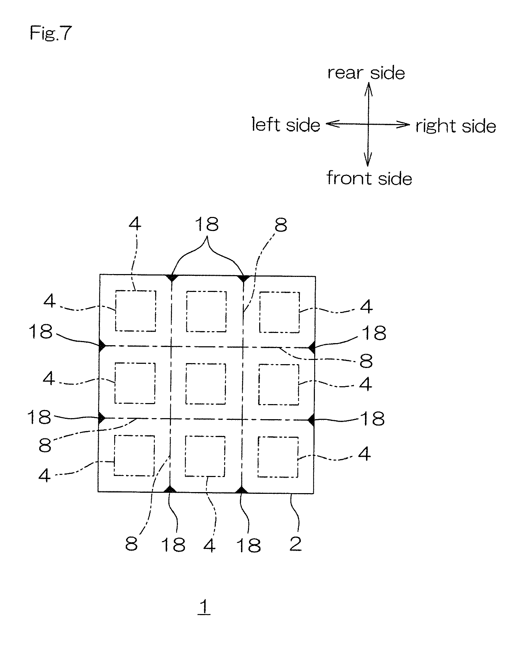

In FIG. 1, the up-down direction of the paper surface may be referred to as a first direction; the depth direction of the paper surface may be referred to as a second direction (a front-rear direction); and the right-left direction of the paper surface may be referred to as a third direction. Directions in FIG. 2 and the subsequent figures are in conformity with the directions in FIG. 1. In FIGS. 2 and 7, a pressure-sensitive adhesive layer 3 to be described later is omitted so as to clearly show the relative arrangement of a support substrate 2 and a reference mark 18 to be described later.

As shown in FIGS. 1 (a) to 1 (e), a method for producing a phosphor layer-covered LED 10 as an encapsulating sheet-covered semiconductor element includes a support sheet preparing step (ref: FIG. 1 (a)); an LED disposing step of disposing LEDs 4 as optical semiconductor elements that are semiconductor elements (one example of a semiconductor element disposing step, ref: FIG. 1 (b)); an LED covering step (ref: FIGS. 1 (c) and 1 (d)); a cutting step of producing the phosphor layer-covered LEDs 10 (ref: dashed lines in FIG. 1 (d)); and an LED peeling step (ref: FIGS. 1 (e) and 1 (e')).

The LED covering step includes a phosphor sheet disposing step of, after the LED disposing step, disposing a phosphor sheet 5 as an encapsulating sheet so as to cover the LEDs 4 and to form a space 30 over the LEDs 4 that are adjacent to each other (one example of an encapsulating sheet disposing step, ref: FIG. 1 (c)) and an LED encapsulating step of curing the phosphor sheet 5 and encapsulating the upper portions of the LEDs 4 by the phosphor sheet 5 (ref: FIG. 1 (d)).

A method for producing an LED device 15 as a semiconductor device includes a mounting step (ref: FIG. 1 (f)).

In the following, the steps of the first embodiment are described in detail.

### [Support Sheet Preparing Step]

The support sheet preparing step is a step of preparing a support sheet 1. As shown in FIGS. 1 (a) and 2, the support sheet 1 is formed into a sheet shape extending in the plane direction (a direction perpendicular to the thickness direction). The support sheet 1 is formed into, for example, a generally rectangular shape in plane view (a shape when projected in the thickness direction).

The support sheet 1 is prepared so that the reference marks 18, which serve as a reference of cutting in the cutting step (ref: the dashed lines in FIG. 1 (d)) to be described later, are provided in advance.

As shown in FIG. 2, a plurality of the reference marks 18 are provided at spaced intervals to each other at the circumference end portion in the plane direction of the support sheet 1. The reference marks 18 are, for example, provided at two sides that are opposed to each other in the support sheet 1. The reference marks 18 are formed to make a pair opposing to each other in an opposing direction of the two sides of the support sheet 1. One pair of the reference marks 18 is provided corresponding to the LEDs 4 (the dashed lines) that are subsequently disposed and is disposed so as to be capable of singulating the LEDs 4 when the phosphor sheet 5 is cut with the reference marks 18 as a reference.

Each of the reference marks 18 is formed into a shape that is easily recognized in plane view and is, for example, formed into a generally triangular shape in plane view.

In a size of the support sheet 1, the maximum length thereof is, for example, 10 mm or more and 300 mm or less and the length of one side thereof is, for example, 10 mm or more and 300 mm or less.

The support sheet 1 is configured to be capable of supporting the LEDs 4 (ref: FIG. 1 (b)) to be described next and as shown in FIGS. 1 (a) and 2, includes, for example, the support substrate 2 and the pressure-sensitive adhesive layer 3 that is laminated on the upper surface of the support substrate 2.

The support substrate 2 is formed into a plate shape extending in the plane direction. The support substrate 2 is provided in the lower portion of the support sheet 1 and is formed to have the generally same shape as that of the support sheet 1 in plane view.

In the support substrate 2, the reference marks 18 are formed. The reference marks 18 are, in sectional view, though not shown, formed as concave portions that dent from the upper surface toward the middle in the up-down direction of the support substrate 2 or as holes that pass through in the up-down direction thereof.

The support substrate 2 is incapable of stretching at least in the plane direction and is formed of a hard material. To be specific, examples of the material include an oxide such as a silicon oxide (glass, silica, or the like) and alumina and a metal such as stainless steel and silicon.

The support substrate 2 has a Young's modulus at 23°C of, for example, 1 × 10⁶ Pa or more, preferably 1 × 10⁷ Pa or more, or more preferably 1 × 10⁸ Pa or more, and of, for example, 1 × 10¹² Pa or less. When the Young's modulus of the support substrate 2 is not less than the above-described lower limit, hardness of the support substrate 2 is secured and the LEDs 4 (ref: FIG. 1 (b)) to be described later can be further surely supported. The Young's modulus of the support substrate 2 is obtained by, for example, the compressive elastic modulus in JIS H 7902:2008.

The thickness of the support substrate 2 is, for example, 0.1 mm or more, or preferably 0.3 mm or more, and is, for example, 5 mm or less, or preferably 2 mm or less.

In the support substrate 2, through holes 21 for allowing a pressing member 14 to insert thereinto in the LED peeling step (ref: FIGS. 1 (e) and 1 (e')) to be described later are formed.

As shown in FIG. 2, a plurality of the through holes 21 are provided at spaced intervals to each other in the support substrate 2 corresponding to the LEDs 4 that are subsequently disposed. The through holes 21 are, for example, disposed so as to allow each of the phosphor layer-covered LEDs 10 to be pressed when the phosphor layer-covered LEDs 10 are singulated with the reference marks 18 as a reference.

To be more specific, a plurality of the through holes 21 are disposed in alignment in the support sheet 1 so as to be spaced apart from each other at equal intervals in the front-rear and the right-left directions in plane view.

The shape of each of the through holes 21 is, for example, formed into a circular shape in plane view. In a size thereof, the hole diameter is, for example, 0.1 mm or more, or preferably 0.2 mm or more, and is, for example, 1 mm or less, or preferably 0.7 mm or less.

The size (the plane area) of each of the through holes 21 with respect to the size (the plane area) of each of the LEDs 4 is, for example, 10 % or more, or preferably 20 % or more, and is, for example, 90 % or less, or preferably 80 % or less.

The pressure-sensitive adhesive layer 3 is formed on the entire upper surface of the support substrate 2.

That is, the pressure-sensitive adhesive layer 3 is laminated on the upper surface of the support substrate 2 so as to cover the through holes 21.

An example of a pressure-sensitive adhesive material for forming the pressure-sensitive adhesive layer 3 includes a pressure-sensitive adhesive such as an acrylic pressure-sensitive adhesive and a silicone pressure-sensitive adhesive.

The pressure-sensitive adhesive material can be widely selected from materials that can be usually used as a pressure-sensitive adhesive, in addition to materials in which the pressure-sensitive adhesive force is capable of being reduced by application of ultraviolet ray, a chemical solution, or heating.

The thickness of the pressure-sensitive adhesive layer 3 is, for example, 0.01 mm or more, or preferably 0.02 mm or more, and is, for example, 1 mm or less, or preferably 0.5 mm or less.

In order to prepare the support sheet 1, for example, the support substrate 2 is attached to the pressure-sensitive adhesive layer 3.

The thickness of the support sheet 1 is, for example, 0.2 mm or more, or preferably 0.5 mm or more, and is, for example, 6 mm or less, or preferably 2.5 mm or less.

### [LED Disposing Step]

The LED disposing step is a step of preparing a plurality of the LEDs 4 and disposing a plurality of the LEDs 4 on the pressure-sensitive adhesive layer 3. In the LED disposing step, as shown in FIG. 1 (b) and by phantom lines in FIG. 2, a plurality of the LEDs 4 are prepared to be disposed on the upper surface of the support sheet 1 at spaced intervals to each other.

Each of the LEDs 4 is a semiconductor element (to be specific, an optical semiconductor element) that converts electrical energy to light energy. Each of the LEDs 4 is, for example, formed into a generally rectangular shape in sectional view and a generally rectangular shape in plane view with the thickness shorter than the length in the plane direction (the maximum length). A luminous layer (not shown) is provided on the upper surface or in the inside of each of the LEDs 4. The lower surface of each of the LEDs 4 is provided with a bump (ref: a numeral 29 in FIG. 20) that is not shown. An example of the LEDs 4 includes blue LEDs (light emitting diode elements) that emit blue light.

The maximum length in the plane direction of each of the LEDs 4 is, for example, 0.1 mm or more and 3 mm or less. The length of one side thereof is, for example, 0.1 mm or more and 3 mm or less. A thickness T0 thereof is, for example, 0.05 mm or more and 1 mm or less.

In the LED disposing step, for example, a plurality of the LEDs 4 are disposed in alignment on the upper surface of the support sheet 1. To be specific, a plurality of the LEDs 4 are disposed in such a manner that a plurality of the LEDs 4 are spaced apart from each other at equal intervals in the front-rear and the right-left directions in plane view.

The LEDs 4 are disposed on the upper surface of the pressure-sensitive adhesive layer 3 so as to be opposed to the through holes 21 in the thickness direction and the LEDs 4 are attached to the pressure-sensitive adhesive layer 3 so that the bumps thereof that are not shown are opposed to the support sheet 1. In this way, the LEDs 4 are supported at (pressure-sensitively adhere to) the upper surface of the support substrate 2 via the pressure-sensitive adhesive layer 3 so that the alignment state thereof is retained.

Each of the LEDs 4 is disposed so that each of the corresponding through holes 21 is positioned at the center thereof.

A gap L1 between the LEDs 4 is, for example, 0.05 mm or more and 2 mm or less.

### [LED Covering Step]

The LED covering step is a step of covering the surfaces of the LEDs 4 with the phosphor sheet 5 to produce the phosphor layer-covered LEDs 10, each of which includes the LED 4 and the phosphor sheet 5. The LED covering step includes the phosphor sheet disposing step (ref: FIG. 1 (c)) and the LED encapsulating step (ref: FIG. 1 (d)).

### (Phosphor Sheet Disposing Step)

The phosphor sheet disposing step is a step of, after the LED disposing step, disposing the phosphor sheet 5 so as to partially cover the LEDs 4 and to form the space 30 over the LEDs 4 that are adjacent to each other. In the upper side view in FIG. 1 (b), and in FIG. 1 (c), the phosphor sheet 5 is formed from a phosphor resin composition containing a curable resin and a phosphor.

Examples of the curable resin include a thermosetting resin that is cured by heating and an active energy ray curable resin that is cured by application of an active energy ray (for example, an ultraviolet ray and an electron beam). Preferably, a thermosetting resin is used.

To be specific, an example of the curable resin includes a thermosetting resin such as a silicone resin, an epoxy resin, a polyimide resin, a phenol resin, a urea resin, a melamine resin, and an unsaturated polyester resin. Preferably, a silicone resin is used.

An example of the silicone resin includes a silicone resin such as a two-step curable type silicone resin and a one-step curable type silicone resin. Preferably, a two-step curable type silicone resin is used.

The two-step curable type silicone resin is a thermosetting silicone resin that has a two-step reaction mechanism and in which a silicone resin is brought into a B-stage state (a semi-cured state) in the first-step reaction and is brought into a C-stage state (a completely cured state) in the second-step reaction. On the other hand, the one-step curable type silicone resin is a thermosetting silicone resin that has a one-step reaction mechanism and in which a silicone resin is completely cured in the first-step reaction.

The B-stage state is a state between an A-stage state in which a curable silicone resin is soluble in a solvent and a C-stage state in which the curable silicone resin is completely cured. Also, the B-stage state is a state in which the curing and the gelation of the curable silicone resin are slightly progressed, and in which the curable silicone resin swells in a solvent but is not completely dissolved therein and is softened but is not melted by heating.

An example of the two-step curable type silicone resin includes a condensation reaction and addition reaction curable type silicone resin that has two reaction systems of a condensation reaction and an addition reaction.

The mixing ratio of the curable resin with respect to the phosphor resin composition is, for example, 30 mass % or more, or preferably 50 mass % or more, and is, for example, 99 mass % or less, or preferably 95 mass % or less.

The phosphor has a wavelength conversion function and examples thereof include a yellow phosphor that is capable of converting blue light into yellow light and a red phosphor that is capable of converting blue light into red light.

Examples of the yellow phosphor include a garnet type phosphor having a garnet type crystal structure such as Y₃Al₅O₁₂:Ce (YAG (yttrium aluminum gamet):Ce) and Tb₃Al₃O₁₂:Ce (TAG (terbium aluminum garnet):Ce) and an oxynitride phosphor such as Ca-α-SiAlON.

An example of the red phosphor includes a nitride phosphor such as CaAlSiN₃:Eu and CaSiN₂:Eu.

Preferably, a yellow phosphor is used.

Examples of a shape of the phosphor include a sphere shape, a plate shape, and a needle shape. Preferably, in view of fluidity, a sphere shape is used.

The average value of the maximum length (in the case of a sphere shape, the average particle size) of the phosphor is, for example, 0.1 µm or more, or preferably 1 µm or more, and is, for example, 200 µm or less, or preferably 100 µm or less.

The mixing ratio of the phosphor with respect to 100 parts by mass of the curable resin is, for example, 0.1 parts by mass or more, or preferably 0.5 parts by mass or more, and is, for example, 80 parts by mass or less, or preferably 50 parts by mass or less.

Furthermore, the phosphor resin composition is also capable of containing a filler.

Examples of the filler include organic microparticles such as silicone particles and inorganic microparticles such as silica, talc, alumina, aluminum nitride, and silicon nitride. The mixing ratio of the filler with respect to 100 parts by mass of the curable resin is, for example, 0.1 parts by mass or more, or preferably 0.5 parts by mass or more, and is, for example, 70 parts by mass or less, or preferably 50 parts by mass or less.

As shown in FIG. 1 (c), in order to dispose the phosphor sheet 5 so as to cover a plurality of the LEDs 4 and to form the space 30 over the LEDs 4 that are adjacent to each other, first, as shown by the upper side view in FIG. 1 (b), the phosphor sheet 5 is prepared. In order to prepare the phosphor sheet 5, a curable resin and a phosphor, and a filler, which is blended as required, are blended to prepare a phosphor resin composition. Next, the phosphor resin composition is applied to the surface of a release sheet 6 to be then heated.

When the curable resin contains a two-step curable type silicone resin, the curable resin is brought into a B-stage state (a semi-cured state) by the above-described heating. That is, the phosphor sheet 5 in a B-stage state is formed.

The phosphor sheet 5 has a compressive elastic modulus at 23°C of, for example, 0.01 MPa or more, or preferably 0.04 MPa or more, and of, for example, 1.0 MPa or less, or preferably 0.5 MPa or less.

When the compressive elastic modulus of the phosphor sheet 5 is not less than the above-described lower limit, sufficient flexibility can be secured. On the other hand, when the compressive elastic modulus of the phosphor sheet 5 is not more than the above-described upper limit, excessive stress applied to the LED 4 is prevented and the LED 4 can be embedded.

A thickness T3 of the phosphor sheet 5 before the compressive bonding (described later) is, for example, 50 µm or more, or preferably 100 µm or more, and is, for example, 2000 µm or less, or preferably 1000 µm or less.

Next, as shown in FIG. 1 (c), the phosphor sheet 5 is disposed so as to partially cover a plurality of the LEDs 4 and to form the space 30 over the LEDs 4 that are adjacent to each other.

In order to dispose the phosphor sheet 5 so as to form the space 30, the lower portion of the phosphor sheet 5 is embedded in the upper portions of the gaps between a plurality of the LEDs 4.

The compressive bonding of the phosphor sheet 5 with respect to the upper portions of a plurality of the LEDs 4 is performed by controlling a pressure or a pushed-in amount of the phosphor sheet 5.

The pressure is appropriately set in accordance with the compressive elastic modulus at 23°C of the phosphor sheet 5.

The pushed-in amount is controlled by adjusting the amount of displacement of a pressing substrate in a pressing device in the up-down (the thickness) direction.

The compressive bonding is performed under a reduced pressure atmosphere or under a normal pressure atmosphere. Preferably, in view of suppressing generation of a void, the compressive bonding is performed under a reduced pressure atmosphere.

The phosphor sheet 5 is placed on the upper surfaces of a plurality of the LEDs 4 and thereafter, the phosphor sheet 5 is allowed to stand for a predetermined hour. Then, the phosphor sheet 5 slightly hangs downwardly based on the self-weight thereof and the flexibility (the low compressive elastic modulus) thereof, so that the phosphor sheet 5 is also capable of being embedded in the upper portions of the gaps between a plurality of the LEDs 4.

Of the phosphor sheet 5, portions, which are embedded in (sunk into) the upper portions of the gaps between a plurality of the LEDs 4, are defined as entering portions 31. Each of the entering portions 31 is extruded downwardly from the upper portion of the phosphor sheet 5 into a generally rectangular shape in sectional view. The side surfaces of each of the entering portions 31 cover the side surfaces of the upper portion of each of the LEDs 4. On the other hand, the phosphor sheet 5 fails to cover and exposes the lower portions (a part) of the side surfaces (the opposing surfaces in which a plurality of the LEDs 4 are opposed to each other) of each of the LEDs 4.

A thickness (the length in the thickness direction) T1 of the entering portion 31 is the length T1 in the thickness direction between the upper surface of the LED 4 and the lowermost surface (that is, the lower surface of the entering portion 31) of the phosphor sheet 5 after being pushed in. The thickness T1 of the entering portion 31 with respect to the thickness T0 of the LED 4 is set to be, for example, 5 % or more, preferably 10 % or more, or more preferably 20 % or more, and to be, for example, 95 % or less, preferably 90 % or less, or more preferably 80 % or less. The thickness T1 of the entering portion 31 with respect to the thickness T3 of the phosphor sheet 5 before the compressive bonding is set to be, for example, 5 % or more, or preferably 10 % or more, and to be, for example, 95 % or less, or preferably 90 % or less. To be specific, the thickness T1 of the entering portion 31 is, for example, 0.01 mm or more, preferably 0.05 mm or more, or more preferably 0.1 mm or more, and is, for example, 1 mm or less, preferably 0.8 mm or less, or more preferably 0.5 mm or less.

A maximum thickness T4 of the phosphor sheet 5 after being disposed on the upper portion of the LED 4 is, for example, 50 µm or more, or preferably 100 µm or more, and is, for example, 2000 µm or less, or preferably 1000 µm or less. The maximum thickness T4 of the phosphor sheet 5 is the sum total of the thickness of the upper portion and the entering length T1 of the entering portion 31.

In this way, the space 30, which is obtained by exposing the lower portions of the gaps between a plurality of the LEDs 4 from the phosphor sheet 5, is formed, while the upper portion of each of the LEDs 4 is covered with the phosphor sheet 5.

The space 30 is a space over a plurality of the LEDs 4. The space 30 is a space defined by the side surfaces of the lower portions of a plurality of the LEDs 4, the upper surface of the pressure-sensitive adhesive layer 3, and the lower surface of the phosphor sheet 5 (that is, the lower surface of the entering portion 31). A plurality of pieces of the space 30 seem to be formed over a plurality of the LEDs 4 in sectional view. However, the space 30 is, in plane view, formed to be communicated with each other. To be specific, as referred in FIG. 2, the space 30 is, in plane view, formed into a generally grid shape (a generally checker-substrate shape) that is obtained by removing the shape of the LED 4 from the outer shape of the pressure-sensitive adhesive layer 3. In the space 30, a portion of the upper surface of the pressure-sensitive adhesive layer 3 that is exposed from the LEDs 4 is not in contact with the lower surface of the phosphor sheet 5 and to be specific, is disposed at spaced intervals to the lower surfaces of the entering portions 31 in the thickness direction.

A with respect to the thickness T0 of the LED 4 is set to be, for example, 5 % or more, preferably 10 % or more, or more preferably 20 % or more, and to be, for example, 95 % or less, preferably 90 % or less, or more preferably 80 % or less. The thickness T2 of the space 30 with respect to the thickness T3 of the phosphor sheet 5 before the compressive bonding is set to be, for example, 5 % or more, or preferably 10 % or more, and to be, for example, 95 % or less, or preferably 90 % or less. To be specific, the thickness T2 of the space 30 is, for example, 0.01 mm or more, preferably 0.05 mm or more, or more preferably 0.1 mm or more, and is, for example, 1 mm or less, preferably 0.8 mm or less, or more preferably 0.5 mm or less.

When the thickness T2 of the space 30 is not less than the above-described lower limit, the side surfaces of the lower portions of a plurality of the LEDs 4 can be surely covered. On the other hand, when the thickness T2 of the space 30 is not more than the above-described upper limit, the space 30, which prevents the contact of the upper surface of the pressure-sensitive adhesive layer 3 with the lower surface of the phosphor sheet 5, can be surely formed.

Thereafter, as shown by the phantom lines in FIG. 1 (c), the release sheet 6 is peeled from the upper surface of the phosphor sheet 5.

### (LED Encapsulating Step)

The LED encapsulating step is a step of curing the phosphor sheet 5 to encapsulate the upper portions of the LEDs 4 by the phosphor sheet 5 that is flexible. The LED encapsulating step is performed after the phosphor sheet disposing step (ref: FIG. 1 (c)).

In the LED encapsulating step, as shown in FIG. 1 (d), the phosphor sheet 5 is cured. To be specific, the phosphor sheet 5 is heated at, for example, 80°C or more, or preferably 100°C or more, and at, for example, 200°C or less, or preferably 180°C or less.

When the curable resin contains a two-step curable type silicone resin and when the phosphor sheet 5 that embeds the LEDs 4 is in a B-stage state, the phosphor sheet 5 is completely cured to be brought into a C-stage state by the above-described heating.

When the curable resin contains a one-step curable type silicone resin, the phosphor sheet 5 that is made from the curable resin is completely cured to be brought into a C-stage state by the above-described heating.

When the curable resin is an active energy ray curable resin, an active energy ray is applied to the phosphor sheet 5 from the upper side.

The cured (completely cured) phosphor sheet 5 has flexibility. To be specific, the cured (completely cured) phosphor sheet 5 has a compressive elastic modulus at 23°C of, for example, 0.5 MPa or more, or preferably 1 MPa or more, and of, for example, 100 MPa or less, or preferably 10 MPa or less.

When the compressive elastic modulus of the phosphor sheet 5 is not more than the above-described upper limit, the flexibility can be surely secured and in the cutting step (ref: FIG. 1 (d)) to be described next, for example, the phosphor sheet 5 can be cut using a cutting device (described later). When the compressive elastic modulus of the phosphor sheet 5 is not less than the above-described lower limit, the shape thereof after being cut can be retained.

In this way, the side surfaces of the upper portions of the LEDs 4 and the upper surfaces thereof are covered with the phosphor sheet 5 in tight contact with each other. That is, the upper portions of the LEDs 4 are encapsulated by the phosphor sheet 5 in a C-stage state.

### [Cutting Step]

The cutting step is a step of, after the LED encapsulating step, cutting the phosphor sheet 5 corresponding to each of a plurality of the LEDs 4 to produce the phosphor layer-covered LED 10 that includes one LED 4 from phosphor sheet-covered LEDs 10' that include a plurality of the LEDs 4. As shown by the dashed lines in FIG. 1 (d), in the cutting step, the flexible phosphor sheet 5 around a plurality of the LEDs 4 is cut along the thickness direction. As shown by dash-dot lines in FIG. 2, for example, the phosphor sheet 5 is cut into a generally rectangular shape in plane view that surrounds each of the LEDs 4.

In order to cut the phosphor sheet 5, for example, a cutting device is used. Examples thereof include a dicing device using a disc-shaped dicing saw (dicing blade), a cutting device using a cutter, and a laser irradiation device.

The cutting of the phosphor sheet 5 is performed with the reference marks 18 as a reference. To be specific, the phosphor sheet 5 is cut so as to form cuts 8 along the straight lines (shown by the dash-dot lines in FIG. 2) that connect the reference marks 18 making one pair.

In the cutting of the phosphor sheet 5, for example, the phosphor sheet 5 is cut from the upper side toward the lower side so that the cuts 8 fail to pass through the support sheet 1, to be specific, fail to pass through the pressure-sensitive adhesive layer 3.

By the cutting step, the phosphor layer-covered LEDs 10, each of which includes one LED 4 and a phosphor layer 7 that is formed of the phosphor sheet 5 covering the upper portion of the LED 4, are obtained in a state where the LEDs 4 are in tight contact with the support sheet 1.

### [LED Peeling Step]

As shown in FIG. 1 (e), the LED peeling step is a step of peeling each of the phosphor layer-covered LEDs 10 from the pressure-sensitive adhesive layer 3. As shown in FIG. 1 (e'), in the LED peeling step, using a pick-up device 17 that is provided with the pressing member 14 such as a needle and an absorbing member 16 such as a collet, the pressure-sensitive adhesive layer 3 is pressed by the pressing member 14 via the through hole 21, so that each of the phosphor layer-covered LEDs 10 is peeled from the support substrate 2 and the pressure-sensitive adhesive layer 3.

To be specific, first, the support sheet 1 is placed in the pick-up device 17. Then, the pressing member 14 is disposed from the lower side in opposed relation to the through hole 21 corresponding to the phosphor layer-covered LED 10 that is intended to be peeled off.

Then, the pressing member 14 is inserted into the through hole 21 from the lower side.

Then, the pressure-sensitive adhesive layer 3 corresponding to the through hole 21 is pressed relatively toward the upper side with respect to the support substrate 2 and the pressure-sensitive adhesive layer 3 is pushed up along with the phosphor layer-covered LED 10.

The pushed-up phosphor layer-covered LED 10 is absorbed by the absorbing member 16.

The phosphor layer-covered LED 10 is absorbed by the absorbing member 16 and is further moved relatively toward the upper side with respect to the support substrate 2. Thereafter, the phosphor layer-covered LED 10 is peeled from the pressure-sensitive adhesive layer 3.

Before the LED peeling step, the pressure-sensitive adhesive force of the pressure-sensitive adhesive layer 3 is reduced by application of ultraviolet ray, a chemical solution, or heating as required and then, each of the phosphor layer-covered LEDs 10 is also capable of being easily peeled off.

In the LED peeling step, the phosphor layer 7 is not in contact with the pressure-sensitive adhesive layer 3 and the LED 4 only is in contact with the pressure-sensitive adhesive layer 3, so that each of the phosphor layer-covered LEDs 10 is capable of being easily peeled from the pressure-sensitive adhesive layer 3.

In this way, as shown in FIG. 1 (e), each of the phosphor layer-covered LEDs 10 that is peeled from the support sheet 1 is obtained.

### [Mounting Step]

The mounting step is a step of, after the LED peeling step, mounting the phosphor layer-covered LED 10 on a substrate 9. In the mounting step, after the phosphor layer-covered LED 10 is selected in accordance with emission wavelength and luminous efficiency, as shown in FIG. 1 (f), the selected phosphor layer-covered LED 10 is mounted on the substrate 9. In this way, the LED device 15 as a semiconductor device is obtained.

To be specific, the phosphor layer-covered LED 10 is disposed in opposed relation to the substrate 9 so that a bump (not shown) that is provided on the lower surface of the LED 4 is opposed to a terminal (not shown) that is provided on the upper surface of the substrate 9. That is, the LED 4 in the phosphor layer-covered LED 10 is flip-chip mounted on the substrate 9 (by heating as required).

In this way, the LED device 15 including the substrate 9 and the phosphor layer-covered LED 10 that is mounted on the substrate 9 is obtained. In the LED device 15, the entering portion 31 and the substrate 9 are disposed at spaced intervals to each other in the up-down (the thickness) direction.

Thereafter, as shown by the phantom line in FIG. 1 (f), an encapsulating protective layer 20 (an encapsulating layer that is different from the phosphor layer 7) that encapsulates the phosphor layer-covered LED 10 is capable of being provided in the LED device 15 as required. In this way, the reliability of the LED device 15 is capable of being improved.

In the above-described phosphor layer-covered LEDs 10, the phosphor sheet 5 is disposed so as to partially cover a plurality of the LEDs 4 and to form the space 30 over the LEDs 4 that are adjacent to each other. Thus, when the phosphor sheet 5 is brought into contact with (compressively bonded to) a plurality of the LEDs 4, the stress applied from the phosphor sheet 5 to a plurality of the LEDs 4 is capable of being released to the space 30. Therefore, the stress in the plane direction applied from the phosphor sheet 5 to a plurality of the LEDs 4 is capable of being reduced. As a result, the phosphor layer-covered LED 10 in which a shift of position of the LED 4, that is, the LED 4 is shifted in the plane direction is suppressed is capable of being produced.

By exposing the lower portions of the side surfaces of the LEDs 4 that are opposed to each other, the above-described space 30 is capable of being surely formed.

On the other hand, as shown in FIG. 20 (a), in a case where the lower portions of the side surfaces of the LED 4 are covered with the phosphor layer 7, as shown in FIG. 20 (b), the lower end portion of the phosphor layer 7 hangs toward the lower side with respect to the lower end portion of the LED 4 when thermal sagging of the phosphor layer 7 occurs by heating at the time of the flip-chip mounting of the phosphor layer-covered LED 10. When a hanging portion 35 in the phosphor layer 7 is, when projected in the plane direction, positioned at the lower side with respect to a bump 29 in the LED 4, the bump 29 in the LED 4 floats with respect to the substrate 9 by the hanging portion 35, so that the bump 29 in the LED 4 is prevented from being in contact with a terminal (not shown) in the substrate 9.

In contrast, in the embodiment, as shown in FIG. 21, by exposing the lower portions of the side surfaces of the LED 4, even when thermal sagging of the phosphor layer 7 occurs by heating at the time of the flip-chip mounting of the phosphor layer-covered LED 10, the hanging portion 35 in the phosphor layer 7 is, when projected in the plane direction, capable of being positioned at the upper side with respect to the bump 29 in the LED 4 or capable of being positioned at the same height as the bump 29. Thus, a contact failure between the bump 29 in the LED 4 and the terminal (not shown) in the substrate 9 caused by the floating of the bump 29 in the LED 4 with respect to the substrate 9 is capable of being prevented. As a result, the connection reliability of the LED device 15 is capable of being improved.

Also, the phosphor sheet 5 containing a phosphor is brought into contact with the upper portions of the LEDs 4, so that a wavelength of light emitted from the LED 4 is converted by the phosphor layer 7 and thus, light having high energy is capable of being emitted.

In the phosphor layer-covered LED 10, a shift of position of the LED 4 is suppressed, so that unevenness in size is suppressed. Thus, stable optical properties, to be specific, stable brightness, stable chromaticity, stable orientation properties, and the like are capable of being ensured.

The method for producing the LED device 15 includes a step of preparing the phosphor layer-covered LED 10 in which stable optical properties are ensured, so that the LED device 15 5 having stable optical properties is capable of being produced.

In the LED device 15, a shift of position of the LED 4 is suppressed, so that unevenness in size is suppressed. Thus, the LED device 15 is capable of ensuring stable brightness, stable chromaticity, stable orientation properties, and the like.

According to the above-described method for producing the phosphor layer-covered LED 10, in the support sheet preparing step, the hard support substrate 2 in which the through holes 21 are formed in advance is prepared and in the LED peeling step, using the above-described pick-up device 17, the pressing member 14 is inserted into the through hole 21 in the support substrate 2 to press the pressure-sensitive adhesive layer 3, so that each of the phosphor layer-covered LEDs 10 is peeled from the pressure-sensitive adhesive layer 3.

Thus, each of the LEDs 4 is capable of being peeled from the pressure-sensitive adhesive layer 3 without requiring a step in which the pressure-sensitive adhesive force of the pressure-sensitive adhesive layer 3 is reduced before the LED peeling step.

As a result, the number of steps required for the production of the phosphor layer-covered LED 10 is capable of being reduced.

Also, a material for forming the pressure-sensitive adhesive layer 3 can be widely selected in addition to materials in which the pressure-sensitive adhesive force is capable of being reduced by application of ultraviolet ray, a chemical solution, or heating.

As a result, the freedom in process planning is capable of being improved.

On the other hand, the method for producing the phosphor layer-covered LED 10 includes the cutting step and after the cutting step, each of the phosphor layer-covered LEDs 10 is peeled from the support sheet 1. That is, in the cutting step, the phosphor sheet 5 is capable of being cut, while the LEDs 4 and the phosphor sheet 5 are supported by the support sheet 1 including the hard support substrate 2. Thus, the phosphor layer-covered LED 10 having excellent size stability is capable of being obtained.

The LED device 15 includes the phosphor layer-covered LED 10 having excellent size stability, so that it has excellent reliability and thus, its luminous efficiency is improved.

After the LED encapsulating step in which the phosphor sheet 5 is cured, the cutting step in which the phosphor sheet 5 is cut is performed, so that a dimensional deviation caused by shrinkage of the phosphor sheet 5 that may occur in the curing can be cancelled in the cutting step. Thus, the phosphor layer-covered LED 10 having further excellent size stability is capable of being obtained.

In addition, the phosphor sheet 5 that encapsulates the upper portions of the LEDs 4 is flexible, so that in the cutting step, the phosphor sheet 5 is capable of being smoothly cut not only using an expensive dicing device, but also using various cutting devices including a relatively cheap cutting device.

In addition, in the phosphor sheet disposing step in this method, the upper portions of the LEDs 4 are embedded by the phosphor sheet 5 in a B-stage state; in the LED encapsulating step, the phosphor sheet 5 is cured to be brought into a C-stage state; and the phosphor sheet 5 in a C-stage state encapsulates the upper portions of the LEDs 4. Thus, the upper portions of the LEDs 4 are easily and surely covered with the phosphor sheet 5 in a B-stage state and the phosphor sheet 5 in a C-stage state is capable of surely encapsulating the upper portions of the LEDs 4.

Consequently, the phosphor layer-covered LED 10 has excellent size stability.

In the phosphor layer-covered LED 10, the number of steps required for the production thereof is reduced, so that its cost is capable of being reduced.

The LED device 15 includes the above-described phosphor layer-covered LED 10, so that its cost is capable of being reduced.

In the support sheet preparing step in this method, the support sheet 1 is prepared so that the reference marks 18, which serve as a reference of cutting in the cutting step, are provided in advance.

On the other hand, in the method described in Japanese Unexamined Patent Publication No. 2001-308116 in which dummy wafers are peeled from a silica glass substrate or a pressure-sensitive adhesive sheet to be then subjected to dicing, the dummy wafers are not on the silica glass substrate when subjected to dicing and thus, the dicing is not capable of being performed with the above-described reference marks 18 as a reference.

In contrast, in the above-described method, the LEDs 4 are supported by the support sheet 1 in the cutting step, so that in this way, the LEDs 4 are capable of being singulated with excellent accuracy with the reference marks 18 as a reference.

### [Modified Example]

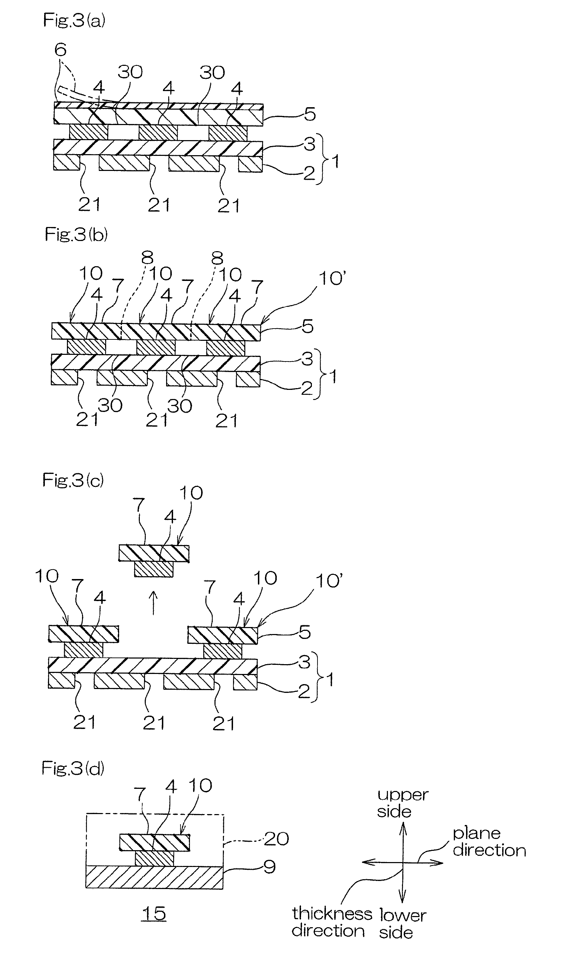

In the embodiment in FIG. 1, as shown in FIG. 1 (c), in the LED covering step, the upper surfaces of the LEDs 4 and the upper portions of the side surfaces of the LEDs 4 are covered with the phosphor sheet 5. Alternatively, for example, as shown in FIG. 3 (a), the upper surfaces only of the LEDs 4 are covered with the phosphor sheet 5 and all of the side surfaces (the entire side surfaces) of the LEDs 4 can be exposed from the phosphor sheet 5.

In such a case, as shown in FIG. 3 (a), the phosphor sheet 5 is disposed on the upper surfaces of a plurality of the LEDs 4 so that the lower surface of the phosphor sheet 5 and the upper surfaces of a plurality of the LEDs 4 are positioned on the same plane surface, that is, the lower surface of the phosphor sheet 5 and the upper surface of each of the LEDs 4 form the same plane surface that is parallel to the pressure-sensitive adhesive layer 3. By disposing the phosphor sheet 5, the entering portion 31 that is shown in FIG. 1 (c) is not formed. Furthermore, the compressive elastic modulus is set so that the phosphor sheet 5 is not compressively bonded and in the phosphor sheet 5, the entering portion 31 is not formed based on the self-weight thereof. In such a case, the phosphor sheet 5 has a compressive elastic modulus at 23°C of, for example, 0.02 MPa or more, or preferably, 0.05 MPa or more, and of, for example, 1.0 MPa or less, or preferably 0.5 MPa or less.

Subsequently, as shown in FIG. 3 (b), the phosphor sheet 5 is cured. In this way, the upper surfaces of the LEDs 4 are covered with the phosphor sheet 5 in tight contact with each other. That is, the upper surfaces of the LEDs 4 are encapsulated by the phosphor sheet 5 in a C-stage state.

Thereafter, the cutting step (ref: the dashed lines in FIG. 3 (b)), the LED peeling step (ref: FIG. 3 (c)), and the mounting step (ref: FIG. 3 (d)) are sequentially performed.

In the embodiment in FIG. 3, the same function and effect as that of the embodiment in FIG. 1 can be achieved. Furthermore, compared to the embodiment in FIG. 1, a step of forming the entering portion 31 is capable of being omitted and thus, the steps are capable of being simplified.

In the embodiment in FIG. 3, preferably, the LED 4 having a luminous layer (not shown) on the upper surface thereof only is used.

On the other hand, in the embodiment in FIG. 1, the upper portions of the side surfaces of the LEDs 4 are encapsulated by the entering portions 31, so that the LED 4 having the luminous layers (not shown) on the upper surface and in the inside thereof is capable of being used.

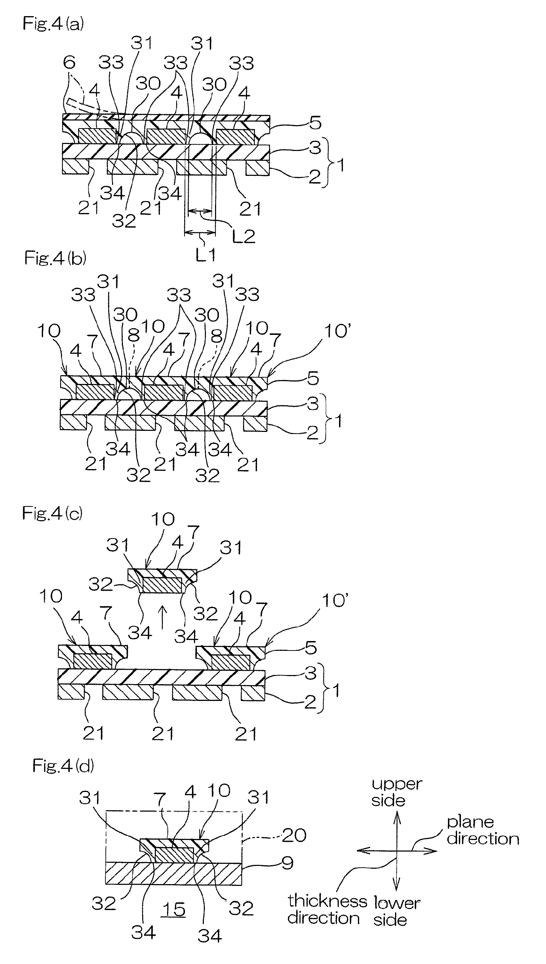

In the embodiment in FIG. 1, as shown in FIG. 1 (c), the lower portions of the side surfaces of the LEDs 4 are exposed from the phosphor sheet 5, while the upper portions of the side surfaces of the LEDs 4 are covered with the phosphor sheet 5. Alternatively, for example, as shown in FIG. 4 (a), all of the side surfaces (the entire side surfaces) of the LEDs 4 can be also covered with the phosphor sheet 5 as long as the space 30 is formed over the LEDs 4 that are adjacent to each other.

In such a case, in the phosphor sheet disposing step shown in FIG. 4 (a), the phosphor sheet 5 is disposed so that the phosphor sheet 5 covers the surfaces (the upper surfaces and the side surfaces, excluding the lower surfaces) of the LEDs 4 and that the phosphor sheet 5 is in contact with circumference end surfaces 33 only, each of which, on the upper surface of the pressure-sensitive adhesive layer 3, surrounds the LED 4 and is positioned near the outer side of the LED 4.

In the phosphor sheet 5, the lower surface of the entering portion 31 filled between a plurality of the LEDs 4 has a curved surface 32 that is formed into a curved shape at spaced intervals with respect to the upper surface of the pressure-sensitive adhesive layer 3 at the upper side thereof and a contact surface 34 that is continuous to the curved surface 32 and is in contact with the circumference end surface 33 of the pressure-sensitive adhesive layer 3.

The space 30 is defined by the upper surface of the pressure-sensitive adhesive layer 3 and the curved surface 32 of the entering portion 31. The space 30 is communicated with each other and is, in plane view, formed into a generally grid shape (a generally checker-substrate shape) that is obtained by removing the outer shape of the LED 4 and the shape of the circumference end surface 33 of the pressure-sensitive adhesive layer 3 from the outer shape of the pressure-sensitive adhesive layer 3. The space 30 is over the LEDs 4 that are adjacent to each other and "over" is defined as a state where a length L2 of the space 30 is formed to be a sufficient length with respect to the gap L1 between the LEDs 4. To be specific, in this state, the length L2 of the space 30 with respect to the gap L1 between the LEDs 4 is formed to be, for example, 80 % or more, furthermore, 90 % or more, or moreover, 95 % or more. Most preferably, the space 30 is formed in a state (ref: FIGS. 1 (c) and 1 (d) in the first embodiment) of being communicated with each other between the LEDs 4 so that the side surfaces, which are opposed to each other, of the LEDs 4 that are adjacent to each other are exposed. The space 30 is formed as a space other than a minute void (a length of 1 to 10 µm).

In this method, after the phosphor sheet disposing step (ref: FIG. 4 (a)), the LED encapsulating step (ref: FIG. 4 (b)), the cutting step (ref: the dashed lines in FIG. 4 (b)), the LED peeling step (ref: FIG. 4 (c)), and the mounting step (ref: FIG. 4 (d)) are sequentially performed.

In the LED encapsulating step, as shown in FIG. 4 (b), the side surfaces and the upper surfaces of the LEDs 4 are covered with the phosphor sheet 5 in tight contact with each other. That is, the LEDs 4 are encapsulated by the phosphor sheet 5 in a C-stage state.

In the embodiment in FIG. 4, the same function and effect as that of the embodiment in FIG. 1 can be achieved. Furthermore, compared to the embodiment in FIG. 1, the entire side surfaces of the LEDs 4 are encapsulated by the phosphor sheet 5, so that the durability of the LED 4 and the luminous efficiency of the LED device 15 are capable of being improved. In addition, the LED 4 having the luminous layers (not shown) on the upper surface and in the inside thereof is capable of being preferably used.

In FIG. 2, each of the through holes 21 is formed into a circular shape in plane view. However, the shape thereof is not particularly limited and can be formed into an appropriate shape such as a generally rectangular shape in plane view or a generally polygonal shape in plane view including a generally triangular shape in plane view.

In FIG. 2, each of the reference marks 18 is formed into a generally triangular shape in plane view. However, the shape thereof is not particularly limited and can be formed into an appropriate shape such as a generally circular shape in plane view, a generally rectangular shape in plane view, a generally X-shape in plane view, and a generally T-shape in plane view.

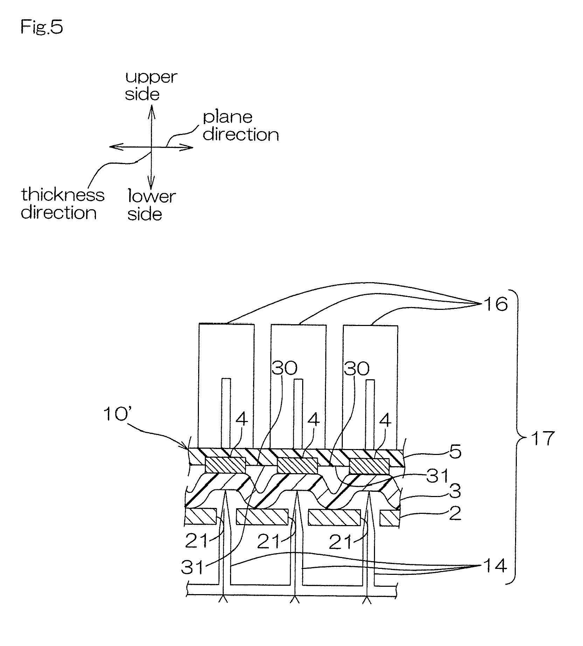

In the first embodiment, first, in the cutting step, as shown by the dashed lines in FIG. 1 (d), a plurality of the LEDs 4 and the phosphor sheet 5 that covers the upper portions of a plurality of the LEDs 4 are singulated into each of a plurality of the phosphor layer-covered LEDs 10. Next, in the LED peeling step, as shown in FIG. 1 (e), each of a plurality of the phosphor layer-covered LEDs 10 is peeled from the pressure-sensitive adhesive layer 3. Alternatively, as shown in FIG. 5, in the cutting step, a plurality of the LEDs 4 and the phosphor sheet 5 corresponding thereto are not sigulated and in the LED peeling step, a plurality of the LEDs 4, along with the phosphor sheet 5, can be peeled from the pressure-sensitive adhesive layer 3.

In such a case, as shown in FIG. 5, the pick-up device 17 is provided with a plurality of the pressing members 14 and a plurality of the absorbing members 16 corresponding to a plurality of the LEDs 4. A plurality of the pressing members 14 move relative to one another in the up-down direction at the same time.

In order to peel each of a plurality of the LEDs 4, first, a plurality of the LEDs 4 are placed in the pick-up device 17 and each of a plurality of the pressing members 14 is disposed from the lower side in opposed relation to each of a plurality of the through holes 21.

A plurality of the pressing members 14 are simultaneously inserted into a plurality of the through holes 21 from the lower side.

Then, the entire pressure-sensitive adhesive layer 3 is pressed relatively toward the upper side with respect to the support substrate 2 and the entire pressure-sensitive adhesive layer 3 is pushed up along with a plurality of the LEDs 4 and the phosphor sheet 5.

The pushed-up plurality of the LEDs 4 and phosphor sheet 5 are absorbed by a plurality of the absorbing members 16.

A plurality of the LEDs 4 and the phosphor sheet 5 are absorbed by a plurality of the absorbing members 16 and are further moved relatively toward the upper side with respect to the support substrate 2. Thereafter, a plurality of the LEDs 4 and the phosphor sheet 5 are peeled from the pressure-sensitive adhesive layer 3.

In the first embodiment, the LED 4, the phosphor layer-covered LED 10, and the LED device 15 are described as one example of the semiconductor element, the encapsulating sheet-covered semiconductor element, and the semiconductor device of the present invention, respectively. Alternatively, for example, the semiconductor element, the encapsulating sheet-covered semiconductor element, and the semiconductor device of the present invention can also include an optical semiconductor element, a phosphor sheet-covered optical semiconductor element, and an optical semiconductor device, respectively. To be specific, the optical semiconductor element, the phosphor sheet-covered optical semiconductor element, and the optical semiconductor device can include an LD (laser diode) 4, a phosphor layer-covered LD 10, and a laser diode device 7, respectively.

Furthermore, the LED 4, the phosphor sheet 5 (the phosphor layer 7), the phosphor layer-covered LED 10, and the LED device 15 are described as one example of the semiconductor element, the encapsulating sheet, the encapsulating sheet-covered semiconductor element, and the semiconductor device of the present invention, respectively. Alternatively, for example, though not shown, the semiconductor element, the encapsulating sheet, the encapsulating sheet-covered semiconductor element, and the semiconductor device of the present invention can also include an electronic element, an encapsulating sheet (an encapsulating layer), an encapsulating layer-covered electronic element, and an electronic device, respectively.

The electronic element is a semiconductor element that converts electrical energy to energy other than light, to be specific, to signal energy or the like. To be specific, examples thereof include a transistor and a diode. The size of the electronic element is appropriately selected in accordance with its use and purpose.

The encapsulating sheet is formed from an encapsulating resin composition that contains a curable resin as an essential component and a filler as an optional component. An example of the filler further includes a black pigment such as carbon black. The mixing ratio of the filler with respect to 100 parts by mass of the curable resin is, for example, 5 parts by mass or more, or preferably 10 parts by mass or more, and is, for example, 99 parts by mass or less, or preferably 95 parts by mass or less.

The properties other than light transmission properties (to be specific, compressive elastic modulus and the like) of the encapsulating sheet are the same as those of the phosphor sheet 5 in the first embodiment.

As referred in FIG. 1 (d), the encapsulating sheet is cut and the encapsulating layer is formed as a protective layer that covers the upper surface of each of the electronic elements and the upper portions of the side surfaces thereof.

### <Second Embodiment>

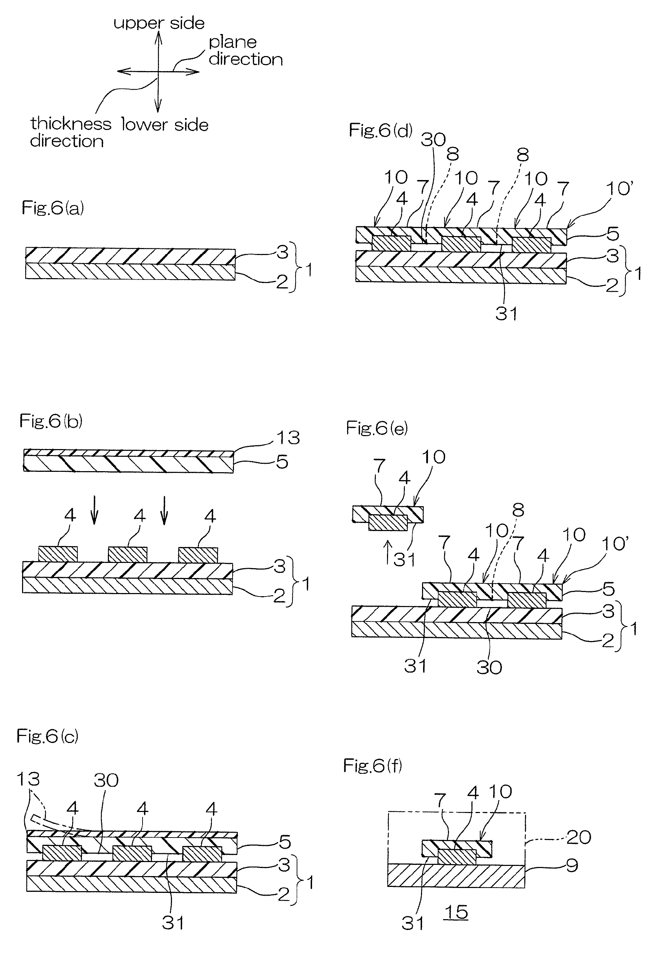

In FIGS. 6 and 7, the same reference numerals are provided for members and steps corresponding to each of those in the first embodiment, and their detailed description is omitted.

In the first embodiment, the through holes 21 are provided in the support substrate 2. Alternatively, for example, as shown in FIGS. 6 (a) and 7, the support substrate 2 can be formed into a flat plate shape having no through hole 21.

As shown in FIGS. 6 (a) to 6 (e), the method for producing the phosphor layer-covered LED 10 in the second embodiment includes a support sheet preparing step of preparing the support sheet 1 (ref: FIG. 6 (a)); an LED disposing step of disposing the LEDs 4 on the support sheet 1 (ref: FIG. 6 (b)); a phosphor sheet disposing step of, after the LED disposing step, disposing the phosphor sheet 5 on the upper portions of the LEDs 4 so as to partially cover the LEDs 4 and to form the space 30 over the LEDs 4 that are adjacent to each other (ref: FIG. 6 (c)); an LED encapsulating step of curing the phosphor sheet 5 to encapsulate the upper portions of the LEDs 4 by the phosphor sheet 5 (ref: FIG. 6 (d)); a cutting step of, after the LED encapsulating step, cutting the phosphor sheet 5 corresponding to each of the LEDs 4 to produce the phosphor layer-covered LEDs 10 (ref: the dashed lines in FIG. 6 (d)); and an LED peeling step of, after the cutting step, peeling the phosphor layer-covered LEDs 10 from the support sheet 1 (ref: an arrow in FIG. 6 (e)).

The method for producing the LED device 15 includes a mounting step (ref: FIG. 6 (f)).

In the following, the steps of the second embodiment are described in detail.

### [Support Sheet Preparing Step]

As shown in FIGS. 6 (a) and 7, the support sheet 1 is formed into a flat plate sheet shape extending in the plane direction. The support sheet 1 is formed into, for example, a rectangular shape in plane view.

As shown in FIG. 7, the support sheet 1 is prepared so that the reference marks 18, which serve as a reference of cutting in the cutting step to be described later, are provided in advance. On the other hand, unlike the first embodiment, the through hole 21 is not provided in the support sheet 1 at the center thereof in the plane direction.

The support sheet 1 is configured to be capable of supporting the LEDs 4 (ref: FIG. 6 (b)) to be described next and as shown in FIGS. 6 (a) and 7, includes, for example, the support substrate 2 and the pressure-sensitive adhesive layer 3 that is laminated on the upper surface of the support substrate 2.

The support substrate 2 is formed into a plate shape extending in the plane direction. The support substrate 2 is provided in the lower portion of the support sheet 1 and is formed to have the generally same shape as that of the support sheet 1 in plane view. Unlike the first embodiment, the through hole 21 is not provided in the support substrate 2 at the center thereof in the plane direction.

The pressure-sensitive adhesive layer 3 is formed on the entire upper surface of the support substrate 2.

An example of a pressure-sensitive adhesive material for forming the pressure-sensitive adhesive layer 3 includes the same pressure-sensitive adhesive as that in the first embodiment. The pressure-sensitive adhesive layer 3 can be also formed of, for example, an active energy ray irradiation release sheet in which the pressure-sensitive adhesive force is capable of being reduced by application of an active energy ray (to be specific, an active energy ray irradiation release sheet described in Japanese Unexamined Patent Publication No. 2005-286003 or the like) or a thermal release sheet in which the pressure-sensitive adhesive force is capable of being reduced by heating (to be specific, a thermal release sheet such as REVALPHA (a registered trademark, manufactured by NITTO DENKO CORPORATION)). To be specific, when a phosphor resin composition in the phosphor sheet 5 (ref: the upper side view in FIG. 6 (b)) to be described later contains a thermosetting resin, preferably, the pressure-sensitive adhesive layer 3 is formed of an active energy ray irradiation release sheet. On the other hand, when the phosphor resin composition in the phosphor sheet 5 to be described later contains an active energy ray curable resin, preferably, the pressure-sensitive adhesive layer 3 is formed of a thermal release sheet.

### [LED Disposing Step]

In the LED disposing step, as shown in FIG. 6 (b) and by the phantom lines in FIG. 7, a plurality of the LEDs 4 are prepared to be disposed on the support sheet 1.

### [Phosphor Sheet Disposing Step]

As shown in FIG. 6 (c), the phosphor sheet 5 is disposed so as to cover the upper portions of a plurality of the LEDs 4 and to form the space 30 over the LEDs 4 that are adjacent to each other.

To be specific, as shown by arrows in FIG. 6 (b), the phosphor sheet 5 that is laminated on a release sheet 13 is, for example, compressively bonded toward the pressure-sensitive adhesive layer 3. The compressive bonding is performed under a reduced pressure atmosphere or under a normal pressure atmosphere. Preferably, the compressive bonding is performed under a reduced pressure atmosphere.

Thereafter, as shown by the phantom lines in FIG. 6 (c), the release sheet 13 is peeled from the upper surface of the phosphor sheet 5.

### [LED Encapsulating Step]

The LED encapsulating step is performed after the phosphor sheet disposing step (ref: FIG. 6 (c)).

As shown in FIG. 6 (d), in the LED encapsulating step, the phosphor sheet 5 is cured.

In this way, the side surfaces of the upper portions of the LEDs 4 and the upper surfaces thereof are covered with the phosphor sheet 5 in tight contact with each other. That is, the upper portions of the LEDs 4 are encapsulated by the phosphor sheet 5 in a C-stage state.

### [Cutting Step]

As shown by the dashed lines in FIG. 6 (d), in the cutting step, the flexible phosphor sheet 5 around the LEDs 4 is cut along the thickness direction. As shown by the dash-dot lines in FIG. 7, for example, the phosphor sheet 5 is cut into a generally rectangular shape in plane view that surrounds each of the LEDs 4.

By the cutting step, the phosphor layer-covered LEDs 10, each of which includes the LED 4 and the phosphor layer 7 that is formed of the phosphor sheet 5 covering the LED 4, are obtained in a state where the LEDs 4 are in tight contact with the support sheet 1.

### [LED Peeling Step]

In FIG. 6 (e), in the LED peeling step, each of the phosphor layer-covered LEDs 10 is peeled from the upper surface of the pressure-sensitive adhesive layer 3. That is, each of the phosphor layer-covered LEDs 10 is peeled from the support substrate 2 and the pressure-sensitive adhesive layer 3. To be specific, an active energy ray is applied to the pressure-sensitive adhesive layer 3 or the pressure-sensitive adhesive layer 3 is heated so as to reduce the pressure-sensitive adhesive force of the pressure-sensitive adhesive layer 3. In the LED peeling step, unlike the first embodiment, each of the phosphor layer-covered LEDs 10 is peeled from the pressure-sensitive adhesive layer 3 without using the pressing member 14 (ref: FIG. 1 (e')).

In the LED peeling step, the phosphor layer 7 is not in contact with the pressure-sensitive adhesive layer 3 and the LED 4 only is in contact with the pressure-sensitive adhesive layer 3, so that each of the phosphor layer-covered LEDs 10 is capable of being easily peeled from the pressure-sensitive adhesive layer 3.

In this way, each of the phosphor layer-covered LEDs 10 that is peeled from the support sheet 1 is obtained.

### [Mounting Step]

Thereafter, after the phosphor layer-covered LED 10 is selected in accordance with emission wavelength and luminous efficiency, as shown in FIG. 6 (f), the selected phosphor layer-covered LED 10 is mounted on the substrate 9. In this way, the LED device 15 is obtained.

In this way, the LED device 15 including the substrate 9 and the phosphor layer-covered LED 10 that is mounted on the substrate 9 is obtained.

Thereafter, as shown by the phantom line in FIG. 6 (f), the encapsulating protective layer 20 (an encapsulating layer that is different from the phosphor layer 7) that encapsulates the phosphor layer-covered LED 10 is provided in the LED device 15 as required. In this way, the reliability of the LED device 15 is capable of being improved.

In the method for producing the phosphor layer-covered LED 10 in the second embodiment, the same function and effect as that of the first embodiment can be achieved.

In the support sheet preparing step (ref: FIG. 6 (a)) in the second embodiment, the support sheet 1 is prepared so as to include the support substrate 2 and the pressure-sensitive adhesive layer 3. Alternatively, for example, though not shown, the support sheet 1 can be also prepared so as to include the support substrate 2 only without including the pressure-sensitive adhesive layer 3.

Preferably, as shown in FIG. 6 (a), the support sheet 1 is prepared so as to include the support substrate 2 and the pressure-sensitive adhesive layer 3.

In this way, in the LED disposing step shown in FIG. 6 (b), when the LEDs 4 are disposed, the LEDs 4 can adhere to the support substrate 2 via the pressure-sensitive adhesive layer 3. Thus, the support sheet 1 can surely support the LEDs 4.

### <Third Embodiment>

In the views in the third embodiment, the same reference numerals are provided for members and steps corresponding to each of those in the first and second embodiments, and their detailed description is omitted.

In the LED peeling step (ref: FIG. 6 (e)) in the second embodiment, each of the phosphor layer-covered LEDs 10 is peeled from the support substrate 2 and the pressure-sensitive adhesive layer 3. Alternatively, for example, as shown in FIG. 8 (e), first, the support substrate 2 is peeled from the pressure-sensitive adhesive layer 3 and thereafter, as shown in FIG. 8 (f), each of the phosphor layer-covered LEDs 10 can be peeled from the pressure-sensitive adhesive layer 3 only.

That is, the method for producing the phosphor layer-covered LED 10 includes the same steps of support sheet preparing step (ref: FIG. 8 (a)), LED disposing step (ref: FIG. 8 (b)), phosphor sheet disposing step (ref: FIG. 8 (c)), LED encapsulating step (ref: FIG. 8 (d)), cutting step (ref: the dashed lines in FIG. 8 (d)), and LED peeling step (ref: FIG. 8 (f)) as those in the second embodiment. In addition, as shown in FIG. 8 (e), the method for producing the phosphor layer-covered LED 10 further includes a support substrate peeling step in which the support substrate 2 is peeled from the pressure-sensitive adhesive layer 3 after the cutting step (ref: FIG. 8 (d)) and before the LED peeling step (ref: FIG. 8 (f)).

### [Support Substrate Peeling Step]

As shown in FIG. 8 (e), in the support substrate peeling step, the support substrate 2 is peeled from the lower surface of the pressure-sensitive adhesive layer 3.

In order to peel the support substrate 2 from the pressure-sensitive adhesive layer 3, for example, the pressure-sensitive adhesive layer 3 is formed from a pressure-sensitive adhesive in which the pressure-sensitive adhesive force is capable of being reduced by application of an active energy ray such as an ultraviolet ray and the active energy ray is applied to the pressure-sensitive adhesive layer 3, so that the pressure-sensitive adhesive force of the pressure-sensitive adhesive layer 3 is reduced. Thereafter, the support substrate 2 is peeled from the pressure-sensitive adhesive layer 3.

Alternatively, the pressure-sensitive adhesive layer 3 is formed from a pressure-sensitive adhesive in which the pressure-sensitive adhesive force is capable of being reduced by heating and the pressure-sensitive adhesive layer 3 is heated, so that the pressure-sensitive adhesive force of the pressure-sensitive adhesive layer 3 is reduced. Thereafter, the support substrate 2 is peeled from the pressure-sensitive adhesive layer 3.

### [LED Peeling Step]

Next, in the LED peeling step shown by the arrow in FIG. 8 (f), each of the phosphor layer-covered LEDs 10 is peeled from the pressure-sensitive adhesive layer 3.

To be specific, as shown in FIG. 8 (f'), for example, each of the phosphor layer-covered LEDs 10 is peeled from the pressure-sensitive adhesive layer 3 with the pick-up device 17. In the pick-up device 17, the pressing member 14 presses (pushes up) the pressure-sensitive adhesive layer 3 corresponding to the phosphor layer-covered LED 10 that is intended to be peeled off from the lower side thereof. In this way, the phosphor layer-covered LED 10 that is intended to be peeled off is pushed up upwardly, and the pushed-up phosphor layer-covered LED 10 is peeled from the pressure-sensitive adhesive layer 3, while being absorbed by the absorbing member 16 such as a collet.

In this way, as shown in FIG. 8 (f), each of the phosphor layer-covered LEDs 10 that is peeled from the support sheet 1 is obtained.

### [Mounting Step]

Thereafter, after the phosphor layer-covered LED 10 is selected in accordance with emission wavelength and luminous efficiency, as shown in FIG. 8 (g), the selected phosphor layer-covered LED 10 is mounted on the substrate 9. In this way, the LED device 15 is obtained.

According to the method in the third embodiment, in the LED peeling step, each of the phosphor layer-covered LEDs 10 is peeled from the pressure-sensitive adhesive layer 3, so that the phosphor layer-covered LED 10 is capable of being easily and surely peeled from the pressure-sensitive adhesive layer 3 using the above-described pick-up device 17.

### <Fourth Embodiment>

In the views in the fourth embodiment, the same reference numerals are provided for members and steps corresponding to each of those in the first to third embodiments, and their detailed description is omitted.

In the LED peeling steps (ref: FIGS. 1 (e), 6 (e), and 8 (f)) in the first to third embodiments, each of the phosphor layer-covered LEDs 10 is peeled from the support sheet 1 and in the mounting step (ref: FIGS. 1 (f), 6 (f), and 8 (g)), the peeled phosphor layer-covered LED 10 is then mounted on the substrate 9. Alternatively, for example, as shown in FIGS. 9 (e) and 9 (f), the phosphor layer-covered LEDs 10 are sequentially transferred onto a transfer sheet 11 and a stretchable support sheet 12, and thereafter, as shown in FIG. 9 (g), each of the phosphor layer-covered LEDs 10 can be peeled from the stretchable support sheet 12.

That is, the method for producing the phosphor layer-covered LED 10 includes the same steps of support sheet preparing step (ref: FIG. 9 (a)), LED disposing step (ref: FIG. 9 (b)), phosphor sheet disposing step (ref: FIG. 9 (c)), LED encapsulating step (ref: FIG. 9 (d)), and cutting step (ref: the dashed lines in FIG. 9 (d)) as those in the second embodiment and furthermore, includes the above-described LED peeling step (ref: FIGS. 9 (e) to 9 (g)). The method for producing the LED device 15 includes a mounting step (ref: FIG. 9 (h)).

### [LED Peeling Step]

The LED peeling step includes a transfer step of transferring the phosphor layer-covered LEDs 10 onto the stretchable support sheet 12 (ref: FIG. 9 (f)) and a re-releasing step of peeling the phosphor layer-covered LEDs 10 from the stretchable support sheet 12, while stretching the stretchable support sheet 12 in the plane direction (ref: FIGS. 9 (g) and 9 (g')).

### [Transfer Step]

In order to transfer the phosphor layer-covered LEDs 10 onto the stretchable support sheet 12, as shown by the arrows in FIG. 9 (d), and in FIG. 9 (e), the phosphor layer-covered LEDs 10 after the cutting step (ref: the dashed lines in FIG. 9 (d)) are transferred onto the transfer sheet 11 in advance (a first transfer step).

The transfer sheet 11 is formed of the same material and with the same thickness as those in the stretchable support sheet 12 to be described next.

By the transfer of the phosphor layer-covered LEDs 10 onto the transfer sheet 11, the surface (the lower surface) of the phosphor layer 7 is in contact (in tight contact) with the upper surface of the transfer sheet 11, while the surfaces (the upper surfaces and the upper portions of the side surfaces) of the LEDs 4 in which bumps that are not shown are formed are exposed from the phosphor layer 7 around the LEDs 4.

Thereafter, as shown in FIG. 9 (f), the phosphor layer-covered LEDs 10 are transferred onto the stretchable support sheet 12 (a second transfer step).

The stretchable support sheet 12 is a stretchable pressure-sensitive adhesive sheet that is capable of stretching in the plane direction. Examples thereof include an active energy ray irradiation release sheet in which the pressure-sensitive adhesive force is capable of being reduced by application of an active energy ray (to be specific, an active energy ray irradiation release sheet described in Japanese Unexamined Patent Publication No. 2005-286003 or the like) and a thermal release sheet in which the pressure-sensitive adhesive force is capable of being reduced by heating (to be specific, a thermal release sheet such as REVALPHA (a registered trademark, manufactured by NITTO DENKO CORPORATION)). Preferably, an active energy ray irradiation release sheet is used.

The stretchable support sheet 12 has a tensile elasticity at 23°C of, for example, 0.01 MPa or more, or preferably 0.1 MPa or more, and of, for example, 10 MPa or less, or preferably 1 MPa or less.

The thickness of the stretchable support sheet 12 is, for example, 0.1 mm or more and 1 mm or less.

A commercially available product can be used as the stretchable support sheet 12. To be specific, the UE series (manufactured by NITTO DENKO CORPORATION) or the like is used.

By the transfer of the phosphor layer-covered LEDs 10 onto the stretchable support sheet 12, the surface (the upper surface) of the phosphor layer 7 is exposed, while the surfaces (the lower surfaces) of the LEDs 4 in which bumps that are not shown are formed are in contact (in tight contact) with the upper surface of the stretchable support sheet 12.

### [Re-Releasing Step]

After the transfer step, as shown in FIG. 9 (g), the stretchable support sheet 12 is stretched in the plane direction and each of the phosphor layer-covered LEDs 10 is peeled from the stretchable support sheet 12.

To be specific, first, as shown by the arrows in FIG. 9 (f), the stretchable support sheet 12 is stretched outwardly in the plane direction. In this way, as shown in FIG. 9 (g), in a state where the phosphor layer-covered LEDs 10 are in tight contact with the stretchable support sheet 12, the tensile stress is concentrated in the cuts 8; thus, the cuts 8 expand; and the LEDs 4 are separated from each other, so that gaps 19 are formed. Each of the gaps 19 is formed into a generally grid shape (a generally checker-substrate shape) in plane view so as to separate the LEDs 4.

Subsequently, as shown in FIG. 9 (g'), the stretchable support sheet 12 corresponding to the phosphor layer-covered LED 10 that is intended to be peeled off is pushed up from the lower side thereof by the pressing member 14. In this way, the phosphor layer-covered LED 10 is pushed up upwardly, and the pushed-up phosphor layer-covered LED 10 is peeled from the stretchable support sheet 12, while being absorbed by the absorbing member 16.

When the stretchable support sheet 12 is an active energy ray irradiation release sheet, in a case where each of the phosphor layer-covered LEDs 10 is peeled from the stretchable support sheet 12, an active energy ray is applied to the stretchable support sheet 12. When the stretchable support sheet 12 is a thermal release sheet, the stretchable support sheet 12 is heated. The pressure-sensitive adhesive force of the stretchable support sheet 12 is reduced by those treatments, so that each of the phosphor layer-covered LEDs 10 is capable of being easily and surely peeled from the stretchable support sheet 12.

In this way, each of the phosphor layer-covered LEDs 10 that is peeled from the support sheet 1 is obtained.

### [Mounting Step]

Thereafter, after the phosphor layer-covered LED 10 is selected in accordance with emission wavelength and luminous efficiency, as shown in FIG. 9 (h), the selected phosphor layer-covered LED 10 is mounted on the substrate 9. In this way, the LED device 15 is obtained.

In the method in the fourth embodiment, the stretchable support sheet 12 is stretched in the plane direction and each of the phosphor layer-covered LEDs 10 is peeled from the stretchable support sheet 12.

Thus, the gaps 19 are formed around each of the phosphor layer-covered LEDs 10, so that each of the phosphor layer-covered LEDs 10 can be further easily and surely peeled from the stretchable support sheet 12 using the pick-up device 17.

Additionally, the gap 19 is formed between the phosphor layer-covered LED 10 that is intended to be peeled off and the phosphor layer-covered LED 10 that is adjacent thereto. Thus, it can be prevented that when the absorbing member 16 is brought into contact with the phosphor layer-covered LED 10 that is intended to be peeled off, the absorbing member 16 comes in contact with the phosphor layer-covered LED 10 that is adjacent thereto to cause a damage to the phosphor layer-covered LED 10.

### <Fifth Embodiment>

In the views in the fifth embodiment, the same reference numerals are provided for members and steps corresponding to each of those in the first to fourth embodiments, and their detailed description is omitted.

In the fourth embodiment, as shown in FIG. 9 (e), each of the phosphor layer-covered LEDs 10 after the cutting step (ref: the dashed lines in FIG. 9 (d)) is transferred onto the transfer sheet 11. Alternatively, as referred in FIG. 10, as shown by the arrows in FIG. 10 (d), and in FIG. 10 (e), first, the phosphor layer-covered LEDs 10 are transferred onto the transfer sheet 11 and thereafter, as shown by the dashed lines in FIG. 10 (f), the cutting step can be performed.

That is, the method for producing the phosphor layer-covered LED 10 in the fifth embodiment includes the same steps of support sheet preparing step (ref: FIG. 10 (a)), LED disposing step (ref: FIG. 10 (b)), phosphor sheet disposing step (ref: FIG. 10 (c)), LED encapsulating step (ref: FIG. 10 (d)), transfer step (ref: FIGS. 10 (e) and 10 (f)), cutting step (ref: the dashed lines in FIG. 10 (f)), and re-releasing step (ref: FIG. 10 (g)) as those in the fourth embodiment. The method for producing the LED device 15 in the fifth embodiment includes a mounting step (ref: FIG. 10 (i)).

The cutting step shown by the dashed lines in FIG. 10 (f) is performed after the first transfer step (ref: FIG. 10 (e)) and before the second transfer step (ref: FIG. 10 (f)).

Then, after the obtained phosphor layer-covered LED 10 is selected in accordance with emission wavelength and luminous efficiency, as shown in FIG. 10 (i), the selected phosphor layer-covered LED 10 is mounted on the substrate 9. In this way, the LED device 15 is obtained.

### <Sixth Embodiment>

In the views in the sixth embodiment, the same reference numerals are provided for members and steps corresponding to each of those in the first to fifth embodiments, and their detailed description is omitted.

In the fifth embodiment, as shown in FIG. 10 (e), in the first transfer step, the phosphor layer-covered LEDs 10 made of the phosphor sheet 5 and a plurality of the LEDs 4 are transferred onto the transfer sheet 11 and at this time, the support sheet 1 made of the support substrate 2 and the pressure-sensitive adhesive layer 3 is peeled from the phosphor layer-covered LEDs 10. Alternatively, as shown in FIG. 11 (d), first, the support substrate 2 in the support sheet 1 is peeled from the pressure-sensitive adhesive layer 3 in advance; next, as shown by the arrows in FIG. 11 (e), and in FIG. 11 (f), the phosphor layer-covered LEDs 10, along with the pressure-sensitive adhesive layer 3, are transferred onto the transfer sheet 11; and subsequently, as shown in FIG. 11 (f), on the stretchable support sheet 12, the pressure-sensitive adhesive layer 3 can be peeled from the phosphor layer-covered LEDs 10.

That is, the method for producing the phosphor layer-covered LED 10 in the sixth embodiment includes the same steps of support sheet preparing step (ref: FIG. 11 (a)), LED disposing step (ref: FIG. 11 (b)), phosphor sheet disposing step (ref: FIG. 11 (c)), LED encapsulating step (ref: FIG. 11 (d)), transfer step (ref: FIGS. 11 (f) and 11 (h)), support substrate peeling step (ref: FIG. 11 (e)), pressure-sensitive adhesive layer peeling step (ref: the arrows in FIG. 11 (f), and in FIG. 11 (g)), cutting step (ref: the dashed lines in FIG. 11 (g)), and re-releasing step (ref: FIG. 11 (i)) as those in the fifth embodiment. The method for producing the LED device 15 in the sixth embodiment includes a mounting step (ref: FIG. 11 (j)).

The support substrate peeling step shown by the arrows in FIG. 11 (d), and in FIG. 11 (e) is performed after the LED encapsulating step (ref: FIG. 11 (d)). Thereafter, as shown in FIG. 11 (f), in the first transfer step in the transfer step, the pressure-sensitive adhesive layer 3 and the phosphor layer-covered LEDs 10 are transferred onto the transfer sheet 11. Then, as shown by the arrows in FIG. 11 (f), and in FIG. 11 (g), in the pressure-sensitive adhesive layer peeling step, the pressure-sensitive adhesive layer 3 is peeled from the phosphor layer-covered LEDs 10. Thereafter, as shown in FIG. 11 (g), in the second transfer step in the transfer step, the phosphor layer-covered LEDs 10 are transferred onto the stretchable support sheet 12.

Then, after the obtained phosphor layer-covered LED 10 is selected in accordance with emission wavelength and luminous efficiency, as shown in FIG. 11 (j), the selected phosphor layer-covered LED 10 is mounted on the substrate 9. In this way, the LED device 15 is obtained.

### <Seventh Embodiment>

In the views in the seventh embodiment, the same reference numerals are provided for members and steps corresponding to each of those in the first to sixth embodiments, and their detailed description is omitted.

As shown in FIGS. 12 (a) to 12 (e), the method for producing the phosphor layer-covered LED 10 in the seventh embodiment includes an LED disposing step of disposing the LEDs 4 on the upper surface of a support sheet 32 (ref: FIG. 12 (a)); a phosphor sheet disposing step of disposing the phosphor sheet 5 so as to partially cover the LEDs 4 and to form the space 30 over the LEDs 4 that are adjacent to each other (ref: FIG. 12 (b)); an LED encapsulating step of applying an active energy ray to the phosphor sheet 5 and encapsulating the upper portions of the LEDs 4 by the phosphor sheet 5 (ref: FIG. 12 (c)); a cutting step of cutting the phosphor sheet 5 corresponding to each of the LEDs 4 (ref: FIG. 12 (d)); and an LED peeling step of peeling the phosphor layer-covered LEDs 10 from the support sheet 32 (ref: FIG. 12 (e)). The method for producing the LED device 15 in the seventh embodiment includes a mounting step (ref: FIG. 12 (f)).

In the following, the steps of the seventh embodiment are described in detail.

### <LED Disposing Step>

As shown in FIG. 12 (a), in the LED disposing step, the support sheet 32 is formed into a sheet shape extending in the plane direction (a direction perpendicular to the thickness direction). The support sheet 32 is formed into a generally rectangular shape in plane view that is the same as or larger than the phosphor sheet 5 to be described next. To be specific, the support sheet 32 is formed into a generally rectangular sheet shape in plane view.

The support sheet 32 is not required to have heat resistance with respect to the heating and curing of the phosphor sheet 5 to be described later, so that it can be also selected from a sheet having low heat resistance. The support sheet 32 is capable of supporting the LEDs 4 and is also capable of stretching in the plane direction. Examples thereof may include a thermal release sheet in which the pressure-sensitive adhesive force is capable of being reduced by heating (to be specific, a thermal release sheet such as REVALPHA (a registered trademark, manufactured by NITTO DENKO CORPORATION)) or an active energy ray irradiation release sheet in which the pressure-sensitive adhesive force is capable of being reduced by application of an active energy ray (for example, an ultraviolet ray and an electron beam) (to be specific, an active energy ray irradiation release sheet described in Japanese Unexamined Patent Publication No. 2005-286003 or the like). When the support sheet 32 is an active energy ray irradiation release sheet, the active energy ray curable resin and the irradiation conditions are selected so as not to reduce the pressure-sensitive adhesive force of the support sheet 32 by application of the active energy ray to the phosphor sheet 5.

In a size of the support sheet 32, the maximum length thereof is, for example, 10 mm or more and 300 mm or less and the length of one side thereof is, for example, 10 mm or more and 300 mm or less.

The support sheet 32 has a tensile elasticity at 23 °C of, for example, 1 × 10⁴ Pa or more, or preferably 1 × 10⁵ Pa or more, and of, for example, 1 ×10⁹ Pa or less. When the tensile elasticity of the support sheet 32 is not less than the above-described lower limit, the stretchability of the support sheet 32 in the plane direction is secured and the stretching (ref: FIG. 12 (e)) of the support sheet 32 in the plane direction to be described later is capable of being smoothly performed.

The thickness of the support sheet 32 is, for example, 0.1 mm or more, or preferably 0.2 mm or more, and is, for example, 1 mm or less, or preferably 0.5 mm or less.

In the LED disposing step, for example, a plurality of the LEDs 4 are disposed in alignment on the upper surface of the support sheet 32. To be specific, a plurality of the LEDs 4 are disposed on the upper surface of the support sheet 32 in such a manner that a plurality of the LEDs 4 are spaced apart from each other at equal intervals in the front-rear and the right-left directions in plane view. The LEDs 4 are attached to the upper surface of the support sheet 32 so that the bumps thereof that are not shown are opposed to the upper surface of the support sheet 32. In this way, the LEDs 4 are supported at (pressure-sensitively adhere to) the upper surface of the support sheet 32 so that the alignment state thereof is retained.

The gap L1 between the LEDs 4 is, for example, 0.05 mm or more and 2 mm or less.

### <Phosphor Sheet Disposing Step>

The phosphor sheet disposing step is performed after the LED disposing step.

In the phosphor sheet disposing step shown in FIG. 12 (b), the phosphor sheet 5 shown by the upper side view in FIG. 12 (a) is formed from a phosphor resin composition containing an active energy ray curable resin and a phosphor.

The active energy ray curable resin is a curable resin that is capable of being cured by application of an active energy ray. To be specific, an example thereof includes a silicone semi-cured material. The silicone semi-cured material is obtained as a sheet by heating a first silicone resin composition or a second silicone resin composition.

In the following, the first silicone resin composition and the second silicone resin composition are described in detail.

### [First Silicone Resin Composition]

The first silicone resin composition contains, for example, a first polysiloxane containing at least one pair of condensable substituted groups that is capable of condensation by heating and at least one addable substituted group that is capable of addition by an active energy ray and a second polysiloxane containing at least one addable substituted group that is capable of addition by an active energy ray and makes one pair with the addable substituted group in the first polysiloxane.

An example of the one pair of condensable substituted groups includes combination (a first combination group) of at least one substituted group selected from the group consisting of a hydroxyl group (-OH), an alkoxy group, an acyloxy group, an amino group (-NH₂), an alkylamino group, an alkenyloxy group, and a halogen atom and a hydroxyl group.

The alkoxy group is represented by -OR¹. R¹ represents an alkyl group or a cycloalkyl group. An example of the alkyl group includes a straight chain or branched chain alkyl group having 1 or more and 20 or less carbon atoms such as a methyl group, an ethyl group, a propyl group, an isopropyl group, a butyl group, an isobutyl group, a pentyl group, and a hexyl group. Preferably, an alkyl group having 1 or more carbon atoms is used, more preferably, an alkyl group having 10 or less carbon atoms is used, or further more preferably, an alkyl group having 6 or less carbon atoms is used. An example of the cycloalkyl group includes a cycloalkyl group having 3 or more and 6 or less carbon atoms such as a cyclopentyl group and a cyclohexyl group.

An example of the alkoxy group includes an alkoxy group containing a straight chain or branched chain alkyl group having 1 or more and 20 or less carbon atoms such as a methoxy group, an ethoxy group, a propoxy group, an isopropoxy group, a butoxy group, an isobutoxy group, a pentyloxy group, and a hexyloxy group.

An example of the alkoxy group also includes an alkoxy group containing a cycloalkyl group having 3 or more and 6 or less carbon atoms such as a cyclopentyloxy group and a cyclohexyloxy group.

As the alkoxy group, preferably, in view of easy preparation and thermal stability, an alkoxy group containing an alkyl group having 1 or more carbon atoms is used, more preferably, an alkoxy group containing an alkyl group having 10 or less carbon atoms is used, further more preferably, an alkoxy group containing an alkyl group having 6 or less carbon atoms is used, or even more preferably, a methoxy group is used.

The acyloxy group is represented by -OCOR¹. R¹ represents the above-described alkyl group or cycloalkyl group. Preferably, as R¹, an alkyl group is used.

Examples of the acyloxy group include an acetoxy group (-OCOCH₃), -OCOC₂H₅, and -OCOC₃H₇. Preferably, an acetoxy group is used.

Examples of the alkylamino group include a monoalkylamino group and a dialkylamino group.

The monoalkylamino group is represented by -NR²H. R² represents an alkyl group or a cycloalkyl group. Preferably, as R², an alkyl group is used. An example of the monoalkylamino group includes a monoalkylamino group having 1 or more and 10 or less carbon atoms of an N-substituted alkyl group such as a methylamino group, an ethylamino group, an n-propylamino group, and an isopropylamino group.

The dialkylamino group is represented by -NR²₂. R² represents alkyl groups or cycloalkyl groups that may be the same or different from each other. R² is the same as that described above. An example of the dialkylamino group includes a dialkylamino group having 1 or more and 10 or less carbon atoms of an N,N-substituted alkyl such as a dimethylamino group, a diethylamino group, a di-n-propylamino group, a diisopropylamino group, an ethylmethylamino group, a methyl-n-propylamino group, and a methylisopropylamino group.

As the alkylamino group, preferably, a dialkylamino group is used, more preferably, a dialkylamino group having the same number of carbon atoms of N,N-substituted alkyl is used, or further more preferably, a dimethylamino group is used.

The alkenyloxy group is represented by -OCOR³. R³ represents an alkenyl group or a cycloalkenyl group. An example of the alkenyl group includes an alkenyl group having 3 or more and 10 or less carbon atoms such as a vinyl group, an allyl group, a propenyl group, an isopropenyl group, a butenyl group, a pentenyl group, a hexenyl group, a heptenyl group, and an octenyl group. An example of the cycloalkenyl group includes a cycloalkenyl group having 3 or more and 10 or less carbon atoms such as a cyclohexenyl group, a cyclooctenyl group, and a norbornenyl group.

As the alkenyloxy group, preferably, an alkenyloxy group containing an alkenyl group having 2 or more and 10 or less carbon atoms is used, or more preferably, an isopropenyloxy group is used.

Examples of the halogen atom include a fluorine atom, a chlorine atom, a bromine atom, and an iodine atom. Preferably, a chlorine atom is used.

To be specific, an example of the first combination group includes one pair of combinations such as combination of hydroxyl groups with themselves, combination of an alkoxy group and a hydroxyl group, combination of an acyloxy group and a hydroxyl group, combination of an amino group and a hydroxyl group, combination of an alkylamino group and a hydroxyl group, combination of an alkenyloxy group and a hydroxyl group, and combination of a halogen atom and a hydroxyl group.

Furthermore, an example of the first combination group also includes two pairs (to be specific, the total of two pairs of one pair of an alkoxy group and a hydroxyl group and the other pair of an acyloxy group and a hydroxyl group) or more of combinations such as combination of an alkoxy group, an acyloxy group, and a hydroxyl group.

As the first combination group, preferably, combination of hydroxyl groups with themselves and combination of an alkoxy group and a hydroxyl group are used, more preferably, combination of an alkoxy group and a hydroxyl group is used, further more preferably, combination of an alkoxy group containing an alkyl group having 1 or more and 10 or less carbon atoms and a hydroxyl group is used, or particularly preferably, combination of a methoxy group and a hydroxyl group is used.

In the one pair of condensable substituted groups made of the first combination group, two silicon atoms are bonded to each other via an oxide atom by condensation represented by the following formula (1), that is, silanol condensation. 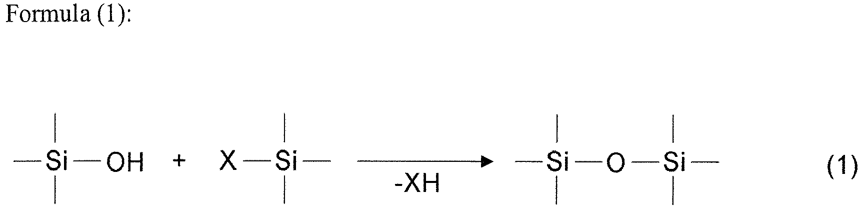 X= -OH, -OR¹,-OCOR¹,-NH₂,-NR²H,-NR²₂,-OCOR³,halogen atom

(where, in formula, R¹ to R³ are the same as those described above.)

An example of the one pair of condensable substituted groups includes combination (a second combination group) of at least one substituted group selected from a hydroxyl group and an alkoxy group and a hydrogen atom.

An example of the alkoxy group includes the alkoxy group illustrated in the first combination group.

To be specific, an example of the second combination group includes one pair of combinations such as combination of a hydroxyl group and a hydrogen atom and combination of an alkoxy group and a hydrogen atom.

Furthermore, an example of the second combination group also includes two pairs (to be specific, the total of two pairs of one pair of a hydroxyl group and a hydrogen atom and the other pair of an alkoxy group and a hydrogen atom) or more of combinations such as combination of a hydroxyl group, an alkoxy group, and a hydrogen atom.

In one pair of condensable substituted groups made of the second combination group, two silicon atoms are bonded to each other via an oxide atom by condensation represented by the following formula (2), that is, hydrosilane condensation. 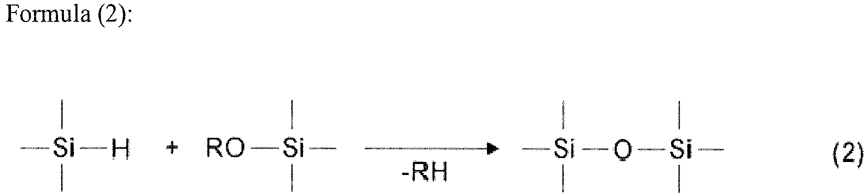 OR= OH, -OR¹

(where, in formula, R¹ is the same as that described above.)

The above-described first combination groups and second combination groups can be contained in the first polysiloxane alone or in combination of a plurality of groups.

Each of the condensable substituted groups is bonded to a silicon atom that is at the end of the main chain, which constitutes a molecule in the first polysiloxane; in the middle of the main chain; and/or in a side chain that branches off from the main chain. Preferably, one condensable substituted group (preferably, a hydroxyl group) is bonded to the silicon atoms at both ends of the main chain and the other condensable substituted group (preferably, an alkoxy group) is bonded to the silicon atom in the middle of the main chain (ref: formula (16) to be described later).

In one pair of addable substituted groups, at least one piece of one addable substituted group is contained in the first polysiloxane and at least one piece of the other addable substituted group is contained in the second polysiloxane.

Examples of the one pair of addable substituted groups include combination of a hydrosilyl group and an ethylenically unsaturated group-containing group, combination of (meth)acryloyl group-containing groups with themselves, combination of epoxy group-containing groups with themselves, and combination of a thiol group-containing group and an ethylenically unsaturated group-containing group.

The hydrosilyl group is represented by -SiH and is a group in which a hydrogen atom is directly bonded to a silicon atom.

The ethylenically unsaturated group-containing group contains, in a molecule, an ethylenically unsaturated group. Examples of the ethylenically unsaturated group-containing group include the above-described alkenyl group and cycloalkenyl group. Preferably, an alkenyl group is used, or more preferably, a vinyl group is used.

The (meth)acryloyl group-containing group contains, in a molecule, a methacryloyl group (CH₂=C(CH₃)COO-) and/or an acryloyl group (CH₂=CHCOO-) and to be specific, is represented by the following formula (3).

Formula (3):

CH₂ = CYCOO - R⁴ - (3)

(where, in formula, Y represents a hydrogen atom or a methyl group and R⁴ represents a divalent hydrocarbon group selected from a saturated hydrocarbon group and an aromatic hydrocarbon group.)

Examples of the divalent saturated hydrocarbon group include an alkylene group having 1 or more and 6 or less carbon atoms such as a methylene group, an ethylene group, a propylene group, and a butylene group and a cycloalkylene group having 3 or more and 8 or less carbon atoms such as a cyclopentylene group and a cyclohexylene group.

An example of the divalent aromatic hydrocarbon group includes an arylene group having 6 or more and 10 or less carbon atoms such as a phenylene group and a naphthylene group.

As the divalent hydrocarbon group, preferably, a divalent saturated hydrocarbon group is used, more preferably, an alkylene group is used, or further more preferably, a propylene group is used.

To be specific, an example of the (meth)acryloyl group-containing group includes a 3-(meth)acryloxypropyl group.

The epoxy group-containing group contains, in a molecule, an epoxy group. Examples of the epoxy group-containing group include an epoxy group, a glycidyl ether group, and an epoxy cycloalkyl group. Preferably, a glycidyl ether group and an epoxy cycloalkyl group are used.

The glycidyl ether group is a glycidoxy alkyl group, for example, represented by formula (4).

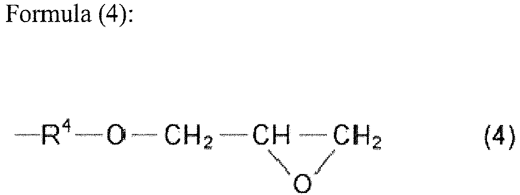

(where, in formula (4), R⁴ represents a divalent hydrocarbon group selected from a saturated hydrocarbon group and an aromatic hydrocarbon group.)

The divalent hydrocarbon group represented by R⁴ is the same as the divalent hydrocarbon group in the above-described formula (3).

An example of the glycidyl ether group includes a 3-glycidoxypropyl group.

An example of the epoxy cycloalkyl group includes an epoxy cyclohexyl group represented by the following formula (5).

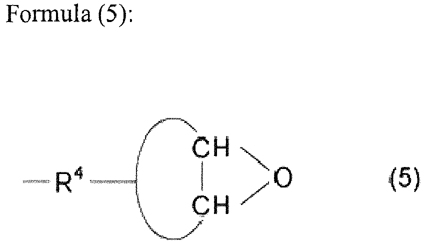

(where, in formula, R⁴ represents a divalent hydrocarbon group selected from a saturated hydrocarbon group and an aromatic hydrocarbon group.)

An example of the divalent saturated hydrocarbon group includes the divalent hydrocarbon group in the above-described formula (3). Preferably, the above-described alkylene group having 1 or more and 6 or less carbon atoms is used, or more preferably, an ethylene group is used.

To be specific, an example of the epoxy cycloalkyl group includes a 2-(3,4-epoxy cyclohexyl)ethyl group.

The thiol group-containing group contains, in a molecule, a thiol group (-SH). Examples thereof include a thiol group and a mercaptoalkyl group such as mercaptomethyl, mercaptoethyl, and mercaptopropyl.

One addable substituted group is replaced with the end and the middle of the main chain and/or a side chain in the first polysiloxane. The other addable substituted group is replaced with or positioned at the end and the middle of the main chain and/or a side chain in the second polysiloxane.

An example of the addable substituted group includes one pair or two or more pairs of combinations described above.

As one pair of addable substituted groups, in view of heat resistance and transparency, preferably, combination of a hydrosilyl group and an alkenyl group is used.

As shown in the following formulas (6) to (9), one pair of addable substituted groups is subjected to addition.

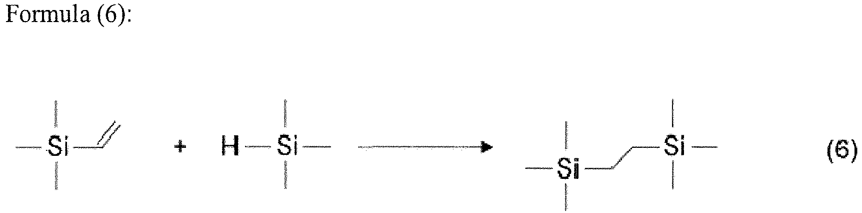

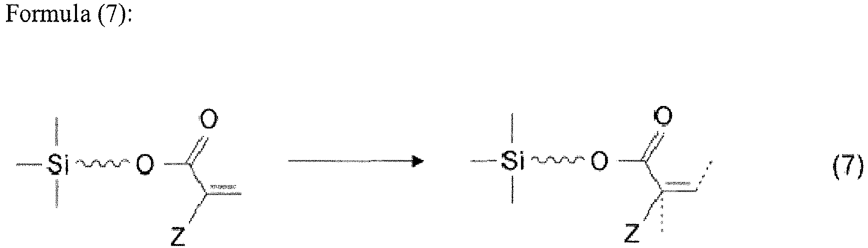

(where, in formula, Z represents a hydrogen atom or a methyl group.)

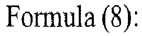

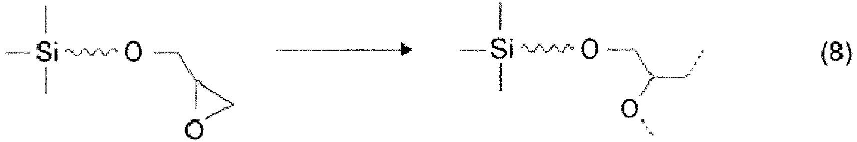

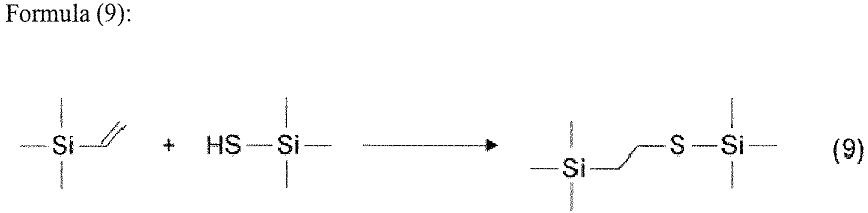

To be specific, when one pair of addable substituted groups is combination of a hydrosilyl group and an alkenyl group (to be specific, a vinyl group), as shown by the above-described formula (6), hydrosilylation (hydrosilylation addition) is performed.

When one pair of addable substituted groups is combination of (meth)acryloyl groups with themselves, as shown by the above-described formula (7), polymerization (addition polymerization) is performed.

When one pair of addable substituted groups is combination of glycidyl ether groups with themselves, as shown by the above-described formula (8), ring-opening addition is performed based on ring opening of an epoxy group.

When one pair of addable substituted groups is combination of a thiol group and an alkenyl group (to be specific, a vinyl group), as shown by the above-described formula (9), a thiol-ene reaction (addition) is performed.

To be specific, the first polysiloxane is represented by the following formula (10).

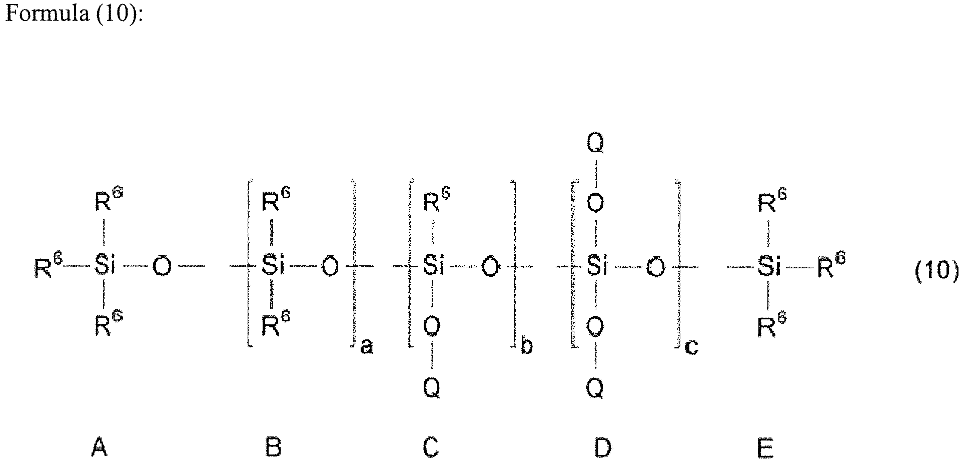

(where, in formula, R⁶ represents a monovalent hydrocarbon group selected from a saturated hydrocarbon group and an aromatic hydrocarbon group; a condensable substituted group; and/or an addable substituted group. SiR⁶ may represent an addable substituted group. A to E represent a constituent unit, A and E represent an end unit, and B to D represent a repeating unit. Q represents a constituent unit of B to E. "a" + "b" + "c" is an integer of 1 or more. Of a plurality of R⁶s, at least one pair of R⁶s represents a condensable substituted group, and at least one R⁶ or at least one SiR⁶ represents an addable substituted group.)

In formula (10), of the monovalent hydrocarbon groups represented by R⁶, examples of the monovalent saturated hydrocarbon group include an alkyl group and a cycloalkyl group. Examples of the alkyl group and the cycloalkyl group include the same alkyl group and cycloalkyl group as those illustrated in the above-described R¹, respectively.

In formula (10), of the monovalent hydrocarbon groups represented by R⁶, an example of the monovalent aromatic hydrocarbon group includes an aryl group having 6 or more and 10 or less carbon atoms such as a phenyl group and a naphthyl group.

As the monovalent hydrocarbon group, preferably, methyl and phenyl are used.

"a" is, for example, an integer of 0 or more, preferably an integer of 1 or more, or more preferably an integer of 2 or more. "a" is also, for example, an integer of 100000 or less, or preferably an integer of 10000 or less.

"b" is, for example, an integer of 0 or more and 100000 or less, or preferably an integer of 0 or more and 10000 or less.

"c" is, for example, an integer of 0 or more and 100000 or less, or preferably an integer of 0 or more and 10000 or less.

"a" + "b" + "c" is preferably an integer of 1 or more and 100000 or less, or more preferably an integer of 1 or more and 10000 or less. That is, of "a" to "c", at least one is an integer of 1 or more.

Examples of the condensable substituted group represented by R⁶ and the addable substituted group represented by R⁶ or SiR⁶ include the above-described condensable substituted group and addable substituted group, respectively.

The first polysiloxane is, for example, prepared by allowing a first silicon compound containing both at least one condensable substituted group and at least one addable substituted group, and a second silicon compound containing at least one condensable substituted group to be partially subjected to condensation (ref: formula (16) to be described later).

The first silicon compound is, for example, represented by the following formula (11).

Formula (11):

R⁷SiBₙX¹₃₋ₙ (11)

(where, in formula, R⁷ or SiR⁷ represents an addable substituted group; B represents a monovalent hydrocarbon group selected from a saturated hydrocarbon group and an aromatic hydrocarbon group; and X¹ represents a condensable substituted group. "n" represents 0 or 1.)

As the addable substituted group represented by R⁷ or SiR⁷, for example, the above-described addable substituted group is used; preferably, one of the substituted groups constituting one pair of addable substituted groups is used; more preferably, an ethylenicaly unsaturated group-containing group, a (meth)acryloyl group-containing group, and an epoxy group-containing group are used; further more preferably, an ethylenically unsaturated group-containing group is used; particularly preferably, an alkenyl group is used; or most preferably, a vinyl group is used.

As the condensable substituted group represented by X¹, for example, the above-described condensable substituted group is used; preferably, one of the substituted groups constituting one pair of condensable substituted groups is used; more preferably, a hydroxyl group, an alkoxy group, an acyloxy group, an amino group, an alkylamino group, an alkenyloxy group, and a halogen atom are used; or further more preferably, an alkoxy group is used.

As the alkoxy group represented by X¹, for example, in view of reactivity, preferably, an alkoxy group containing an alkyl group having 1 or more and 10 or less carbon atoms is used, or more preferably, an alkoxy group containing an alkyl group having 1 or more and 6 or less carbon atoms is used. To be specific, a methoxy group is used.

The monovalent hydrocarbon group represented by B is the same monovalent hydrocarbon group as that illustrated by R⁶ in formula (10).

When "n" is 0, the first silicon compound is represented by the following formula (12) and is defined as a trifunctional silicon compound containing three condensable substituted groups.

Formula (12):

R⁷SiX¹₃ (12)

(where, in formula, R⁷ or SiR⁷ represents an addable substituted group and X¹ represents a condensable substituted group.)

Examples of the trifunctional silicon compound include a vinyltrimethoxysilane, a vinyltriethoxysilane, an allyltrimethoxysilane, a propenyltrimethoxysilane, a norbornenyltrimethoxysilane, an octenyltrimethoxysilane, a 3-acryloxypropyltrimethoxysilane, a 3-methacryloxypropyltriethoxysilane, a 3-methacryloxypropyltrimethoxysilane, a 3-glycidoxypropyltriethoxysilane, a 3-glycidoxypropyltrimethoxysilane, and a 2-(3,4-epoxycyclohexyl)ethyltrimethoxysilane.

These trifunctional silicon compounds can be used alone or in combination of two or more.

As the trifunctional silicon compound, preferably, a vinyltrimethoxysilane in which R⁷ is a vinyl group and all of the X¹s are methoxy groups in the above-described formula (12) is used.

On the other hand, in the above-described formula (11), when "n" is 1, the first silicon compound is represented by the following formula (13) and is defined as a bifunctional silicon compound containing two condensable substituted groups.

Formula (13):

R⁷SiBX¹₂ (13)

(where, in formula, R⁷ or SiR⁷ represents an addable substituted group; B represents a monovalent hydrocarbon group selected from a saturated hydrocarbon group and an aromatic hydrocarbon group; and X¹ represents a condensable substituted group.)

R⁷, SiR⁷, B, and X¹ are the same as those described above.

Examples of the bifunctional silicon compound include a vinyldimethoxymethylsilane, a vinyldiethoxymethylsilane, an allyldimethoxymethylsilane, a propenyldimethoxymethylsilane, a norbornenyldimethoxymethylsilane, an octenyldimethoxymethylsilane, an octenyldiethoxymethylsilane, a 3-acryloxypropyldimethoxymethylsilane, a 3-methacryloxypropyldimethoxymethylsilane, a 3-methacryloxypropyldimethoxymethylsilane, a 3-glycidoxypropyldiethoxymethylsilane, a 3-glycidoxypropyldimethoxymethylsilane, and a 2-(3,4-epoxycyclohexyl)ethyldimethoxymethylsilane.

These bifunctional silicon compounds can be used alone or in combination of two or more.

As the bifunctional silicon compound, preferably, a vinyldimethoxymethylsilane in which R⁷ is a vinyl group, B is a methyl group, and all of the X¹s are methoxy groups in the above-described formula (13) is used.

A commercially available product can be used as the first silicon compound and a first silicon compound synthesized in accordance with a known method can be also used.

These first silicon compounds can be used alone or in combination of two or more.

To be specific, a trifunctional silicon compound is used alone, a bifunctional silicon compound is used alone, or a trifunctional silicon compound and a bifunctional silicon compound are used in combination. Preferably, a trifunctional silicon compound is used alone, and a trifunctional silicon compound and a bifunctional silicon compound are used in combination.

An example of the second silicon compound includes a polysiloxane containing at least two condensable substituted groups, to be specific, containing a condensable substituted group bonded to a silicon atom at the end of the main chain and/or a condensable substituted group bonded to a silicon atom in a side chain that branches off from the main chain.

Preferably, the second silicon compound contains a condensable substituted group bonded to the silicon atoms at both ends of the main chain (a bifunctional silicon compound).

The second silicon compound is a dual-end type polysiloxane (a bifunctional polysiloxane) represented by the following formula (14).

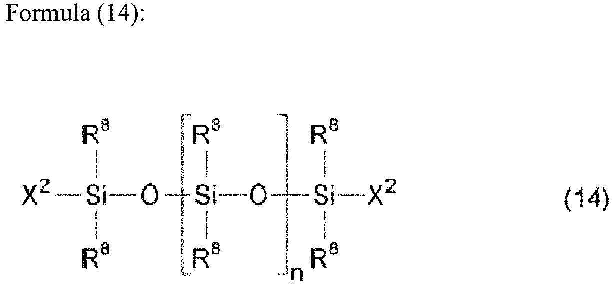

(where, in formula, R⁸ represents a monovalent hydrocarbon group selected from a saturated hydrocarbon group and an aromatic hydrocarbon group; X² represents a condensable substituted group; and "n" represents an integer of 1 or more.)

In formula (14), an example of the monovalent hydrocarbon group represented by R⁸ includes the monovalent hydrocarbon group illustrated by R⁶ in the above-described formula (10). Preferably, methyl and phenyl are used.

In formula (14), an example of the condensable substituted group represented by X² includes the condensable substituted group illustrated by R⁶ in the above-described formula (10). Preferably, a hydroxyl group and a hydrogen atom are used, or more preferably, a hydroxyl group is used.

When the condensable substituted group is a hydroxyl group, the dual-end type polysiloxane is defined as a polysiloxane containing silanol groups at both ends (a silicone oil containing silanol groups at both ends) represented by the following formula (15).

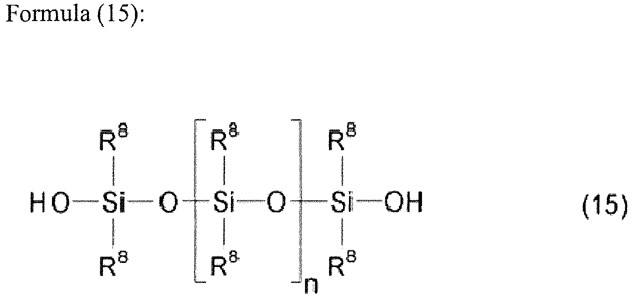

(where, in formula, R⁸ represents a monovalent hydrocarbon group selected from a saturated hydrocarbon group and an aromatic hydrocarbon group. "n" represents an integer of 1 or more.)

R⁸ is the same as that described above.

In the above-described formulas (14) and (15), "n" is, in view of stability and/or handling ability, preferably an integer of 1 or more and 10000 or less, or more preferably an integer of 1 or more and 1000 or less.

To be specific, examples of the dual-end type polysiloxane include a polydimethylsiloxane containing silanol groups at both ends, a polymethylphenylsiloxane containing silanol groups at both ends, and a polydiphenylsiloxane containing silanol groups at both ends.

A commercially available product can be used as the second silicon compound and a second silicon compound synthesized in accordance with a known method can be also used.

The number average molecular weight of the second silicon compound is, in view of stability and/or handling ability, for example, 100 or more, or preferably 200 or more, and is, for example, 1000000 or less, or preferably 100000 or less. The number average molecular weight is calculated by conversion based on standard polystyrene with a gel permeation chromatography. The number average molecular weight of materials, other than the second silicon compound, is also calculated in the same manner as described above.

In order to allow the first silicon compound and the second silicon compound to be partially subjected to condensation, a condensation material made of those is blended with a condensation catalyst.

The mixing ratio of the second silicon compound with respect to 100 parts by mass of the total amount of the first silicon compound and the second silicon compound (that is, the total amount of the condensation material) is, for example, 1 part by mass or more, preferably 50 parts by mass or more, or more preferably 80 parts by mass or more, and is, for example, 99.99 parts by mass or less, preferably 99.9 parts by mass or less, or more preferably 99.5 parts by mass or less.

The molar ratio (X²/X¹) of the condensable substituted group (X² in the above-described formula (14), to be specific, a hydroxyl group) in the second silicon compound to the condensable substituted group (X¹ in the above-described formula (11), to be specific, an alkoxy group) in the first silicon compound is, for example, 20/1 or less, or preferably 10/1 or less, and is, for example, 1/5 or more, preferably 1/2 or more, or most preferably substantially 1/1.

When the molar ratio is above the above-described upper limit, in a case where the first polysiloxane is obtained by allowing the first and the second silicon compounds to be partially subjected to condensation and thereafter, the first and the second polysiloxanes are completely subjected to condensation, a silicone semi-cured material having an appropriate toughness may not be obtained. On the other hand, when the molar ratio is below the above-described lower limit, the mixing proportion of the first silicon compound is excessively large, so that the heat resistance of a silicone cured material to be obtained may be reduced.

When the molar ratio is within the above-described range (preferably, substantially 1/1), the condensable substituted group (to be specific, an alkoxy group) in the first silicon compound and the condensable substituted group (to be specific, a hydroxyl group) in the second silicon compound can be completely subjected to condensation neither too much nor too little.

When the trifunctional silicon compound and the bifunctional silicon compound are used in combination, the ratio (the number of parts by mass of the bifunctional silicon compound/the number of parts by mass of the trifunctional silicon compound) of the bifunctional silicon compound to the trifunctional silicon compound, based on mass, is, for example, 70/30 or less, or preferably 50/50 or less, and is, for example, 1/99 or more, or preferably 5/95 or more. When the trifunctional silicon compound and the bifunctional silicon compound are used in combination, the molar ratio (X²/X¹) of the condensable substituted group (X² in the above-described formula (14), to be specific, a hydroxyl group) in the second silicon compound to the condensable substituted group (X¹ in the above-described formula (12), to be specific, an alkoxy group) in the trifunctional silicon compound is, for example, 20/1 or less, preferably 10/1 or less, and is, for example, 1/5 or more, preferably 1/2 or more, or most preferably substantially 1/1. On the other hand, when the trifunctional silicon compound and the bifunctional silicon compound are used in combination, the molar ratio (X²/X¹) of the condensable substituted group (X² in the above-described formula (14), to be specific, a hydroxyl group) in the second silicon compound to the condensable substituted group (X¹ in the above-described formula (13), to be specific, an alkoxy group) in the bifunctional silicon compound is, for example, 20/1 or less, or preferably 10/1 or less, and is, for example, 1/5 or more, preferably 1/2 or more, or most preferably substantially 1/1.

The condensation catalyst is not particularly limited as long as it is a catalyst that promotes condensation of the first silicon compound with the second silicon compound. Examples of the condensation catalyst include an acid, a base, and a metal catalyst.

An example of the acid includes an inorganic acid (a Broensted acid) such as a hydrochloric acid, an acetic acid, a formic acid, and a sulfuric acid. The acid includes a Lewis acid and an example of the Lewis acid includes an organic Lewis acid such as pentafluorophenyl boron, scandium triflate, bismuth triflate, scandium trifurylimide, oxovanadium triflate, scandium trifurylmethide, and trimethylsilyl trifurylimide.

Examples of the base include an inorganic base such as potassium hydroxide, sodium hydroxide, and potassium carbonate and tetramethylammonium hydroxide. Preferably, an organic base such as tetramethylammonium hydroxide is used.

Examples of the metal catalyst include an aluminum-based catalyst, a titanium-based catalyst, a zinc-based catalyst, and a tin-based catalyst. Preferably, a tin-based catalyst is used.

Examples of the tin-based catalyst include a carboxylic acid tin salt such as di (or bis)(carboxylic acid)tin (II) containing a straight chain or branched chain carboxylic acid having 1 or more and 20 or less carbon atoms including di(2-ethylhexanoate)tin (II), dioctanoate tin (II) (dicaprylic acid tin (II)), bis(2-ethylhexanoate)tin, bis(neodecanoate)tin, and tin oleate and an organic tin compound such as dibutylbis(2,4-pentanedionate)tin, dimethyltindiversatate, dibutyltindiversatate, dibutyltindiacetate (dibutyldiacetoxytin), dibutyltindioctoate, dibutylbis(2-ethylhexylmaleate)tin, dioctyldilauryltin, dimethyldineodecanoatetin, dibutyltindioleate, dibutyltindilaulate, dioctyltindilaulate, dioctyltindiversatate, dioctyltinbis (mercaptoacetic acid isooctyl ester)salt, tetramethyl-1,3-diacetoxydistannoxane, bis(triethyltin)oxide, tetramethyl-1,3-diphenoxydistannoxane, bis(tripropyltin)oxide, bis(tributyltin)oxide, bis(triphenyltin)oxide, poly(dibutyltin maleate), diphenyltindiacetate, dibutyltin oxide, dibutyltindimethoxide, and dibutylbis(triethoxy)tin.

As the tin-based catalyst, preferably, a carboxylic acid tin salt is used, more preferably, di(carboxylic acid)tin (II) containing a straight chain or branched chain carboxylic acid having 1 or more and 20 or less carbon atoms is used, further more preferably, di(carboxylic acid)tin (II) containing a straight chain or branched chain carboxylic acid having 4 or more and 14 or less carbon atoms is used, or particularly preferably, di(carboxylic acid)tin (II) containing a branched chain carboxylic acid having 6 or more and 10 or less carbon atoms is used.

These condensation catalysts can be used alone or in combination.

A commercially available product can be used as the condensation catalyst. A condensation catalyst synthesized in accordance with a known method can be also used.

The condensation catalyst can be, for example, solved in a solvent to be prepared as a condensation catalyst solution. The concentration of the condensation catalyst in the condensation catalyst solution is adjusted to be, for example, 1 mass % or more and 99 mass % or less.

The mixing ratio of the condensation catalyst with respect to 100 mol of the second silicon compound is, for example, 0.001 mol or more, or preferably 0.01 mol or more, and is, for example, 50 mol or less, or preferably 5 mol or less.

Next, in this method, after the blending of the first silicon compound, the second silicon compound, and the condensation catalyst, the mixture is stirred and mixed at a temperature of, for example, 0°C or more, or preferably 10°C or more, and of, for example, 80°C or less, or preferably 75°C or less for, for example, 1 minute or more, or preferably 2 hours or more, and of, for example, 24 hours or less, or preferably 10 hours or less.

By the above-described mixing, the first and the second silicon compounds are partially subjected to condensation in the presence of the condensation catalyst.

To be specific, the condensable substituted group (X¹ in the above-described formula (11)) in the first silicon compound and the condensable substituted group (X² in the above-described formula (14)) in the second silicon compound are partially subjected to condensation.

To be more specific, when the condensable substituted group in the first silicon compound is an alkoxy group and the condensable substituted group in the second silicon compound is a hydroxyl group, as shown by the following formula (16), they are partially subjected to condensation.

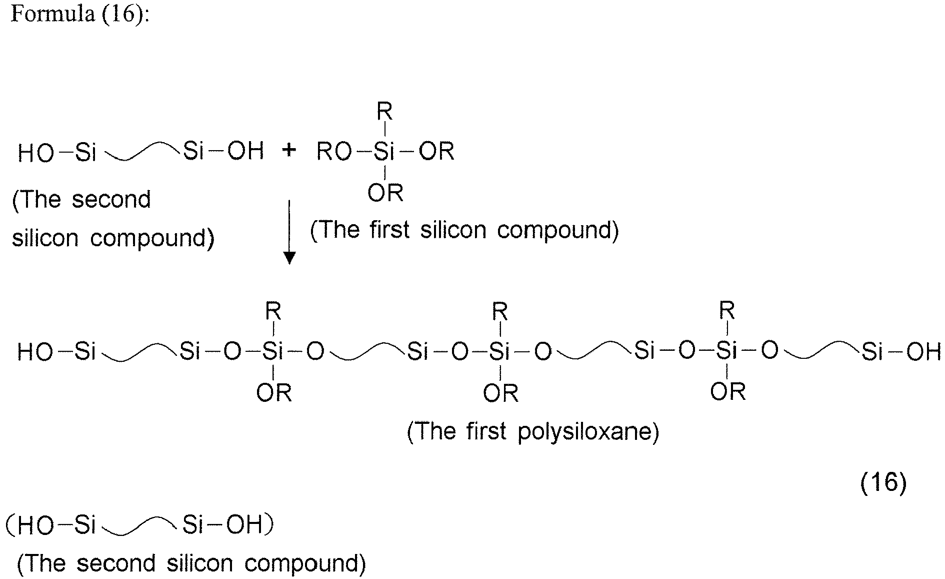

A portion in the second silicon compound is not subjected to condensation and remains to be subjected to condensation with the condensable substituted group in the first polysiloxane by next further condensation (a complete curing step).

The first polysiloxane obtained in this way is in a liquid state (in an oil state) and in an A-stage state.

An example of the second polysiloxane includes a side-chain type polysiloxane that is represented by the following formula (17) and contains at least one condensable substituted group in a side chain.

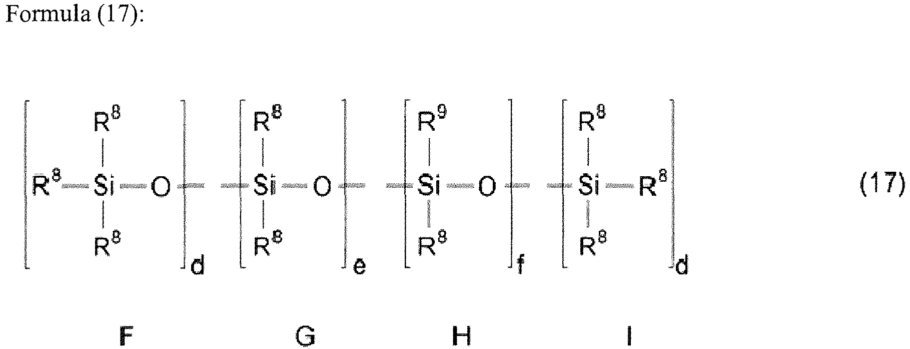

(where, in formula, F to I represent a constituent unit; F and I represent an end unit; and G and H represent a repeating unit. R⁸ represents a monovalent hydrocarbon group selected from a saturated hydrocarbon group and an aromatic hydrocarbon group, and R⁹ or SiR⁹ represents an addable substituted group. "d" is 0 or 1, "e" is an integer of 0 or more, and "f" is an integer of 1 or more. All of the R⁸s or the R⁹s may be the same or different from each other.)

In formula (17), an example of the monovalent hydrocarbon group represented by R⁸ includes the monovalent hydrocarbon group illustrated by R⁶ in the above-described formula (10). Preferably, methyl and phenyl are used.

In formula (17), as the addable substituted group represented by R⁹ or SiR⁹, for example, the above-described addable substituted group is used; preferably, the other of the substituted groups constituting one pair of addable substituted groups is used; more preferably, a hydrosilyl group and an ethylenically unsaturated group-containing group (to be specific, a vinyl group) are used; or further more preferably, a hydrosilyl group is used.

When "d" is 1, the side-chain type polysiloxane is a straight chain polysiloxane and when "d" is 0, the side-chain type polysiloxane is a cyclic polysiloxane.

Preferably, "d" is 1.

"e" represents the number of repeating unit in the constituent unit G and is, in view of reactivity, preferably an integer of 0 or more, or more preferably an integer of 1 or more, and is preferably an integer of 100000 or less, or more preferably an integer of 10000 or less.

"f" represents the number of repeating unit in the constituent unit H and is, in view of reactivity, preferably an integer of 1 or more, or more preferably an integer of 2 or more, and is, preferably an integer of 100000 or less, or more preferably an integer of 10000 or less.

The number average molecular weight of the side-chain type polysiloxane is, for example, in view of stability and handling ability, 100 or more and 1000000 or less, or preferably 100 or more and 100000 or less.

To be specific, examples of the side-chain type polysiloxane include a methylhydrogenpolysiloxane, a methylvinylpolysiloxane, a dimethylpolysiloxane-co-methylhydrogenpolysiloxane, a dimethylpolysiloxane-co-vinylmethylpolysiloxane, an ethylhydrogenpolysiloxane, a methylhydrogenpolysiloxane-co-methylphenylpolysiloxane, a methylvinylpolysiloxane-co-methylphenylpolysiloxane, a 2,4,6,8-tetramethyl-2,4,6,8-tetravinylcyclotetrasiloxane, and a 1,3,5,7-tetramethylcyclotetrasiloxane.

These side-chain type polysiloxanes can be used alone or in combination of two or more.

Preferably, a straight chain side-chain type polysiloxane in which R⁸ is a methyl group; R⁹ is a hydrogen atom (that is, SiR⁹ is a hydrosilyl group) or a vinyl group; "d" is 1; "e" is an integer of 1 or more; and "h" is an integer of 2 or more is used.

An example of the second polysiloxane includes a dual-end type polysiloxane (a polysiloxane containing addable substituted groups at both ends) that is represented by the following formula (18) and contains the addable substituted groups at both ends of a molecule.

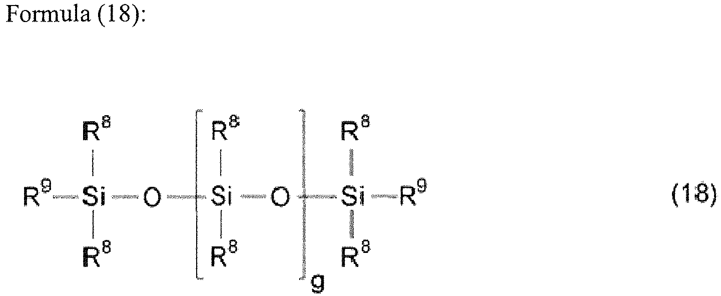

(where, in formula, R⁸ represents a monovalent hydrocarbon group selected from a saturated hydrocarbon group and an aromatic hydrocarbon group; R⁹ or SiR⁹ represents an addable substituted group; and "g" represents an integer of 1 or more. All of the R⁸s or the R⁹s may be the same or different from each other.)

An example of the monovalent hydrocarbon group represented by R⁸ includes the monovalent hydrocarbon group illustrated by R⁶ in the above-described formula (10). Preferably, methyl and phenyl are used.

As the addable substituted group represented by R⁹ or SiR⁹, for example, the above-described addable substituted group is used; preferably, the other of the substituted groups constituting one pair of addable substituted groups is used; more preferably, a hydrosilyl group and an ethylenically unsaturated group-containing group (to be specific, a vinyl group) are used; or further more preferably, a hydrosilyl group is used.

"g" is, in view of reactivity, preferably an integer of 1 or more, or more preferably an integer of 2 or more, and is preferably an integer of 100000 or less, or more preferably an integer of 10000 or less.

The number average molecular weight of the dual-end type polysiloxane is, for example, in view of stability and handling ability, 100 or more and 1000000 or less, or preferably 100 or more and 100000 or less.

Examples of the dual-end type polysiloxane include a polydimethylsiloxane containing hydrosilyl groups at both ends, a polydimethylsiloxane containing vinyl groups at both ends, a polymethylphenylsiloxane containing hydrosilyl groups at both ends, a polymethylphenylsiloxane containing vinyl groups at both ends, a polydiphenylsiloxane containing hydrosilyl groups at both ends, a polydimethylsiloxane containing vinyl groups at both ends, and a polydiphenylsiloxane containing vinyl groups at both ends.

These dual-end type polysiloxanes can be used alone or in combination of two or more.

Preferably, a polydimethylsiloxane containing hydrosilyl groups at both ends (an organohydrogenpolysiloxane) or a polydimethylsiloxane containing vinyl groups at both ends in which all of the R⁸s are methyl groups; R⁹ is a hydrogen atom (that is, SiR⁹ is a hydrosilyl group) or a vinyl group; and "g" is an integer of 2 or more and 10000 or less is used.

Of the above-described side-chain type polysiloxane and dual-end type polysiloxane, as the second polysiloxane, preferably, a dual-end type polysiloxane is used.

A commercially available product can be used as the second polysiloxane. A second polysiloxane synthesized in accordance with a known method can be also used.

In order to prepare the first silicone resin composition, the first polysiloxane and the second polysiloxane are blended. Preferably, the first polysiloxane and the second polysiloxane are blended with an addition catalyst.

The molar ratio (R⁷/Sik⁹) of the addable substituted group (one side, preferably a vinyl group (R⁷ in formula (11)) in the first polysiloxane to the addable substituted group (the other side, preferably a hydrosilyl group (SiR⁹ in formula (18)) in the second polysiloxane is, for example, 20/1 or less, preferably 10/1 or less, or more preferably 5/1 or less and is, for example, 1/20 or more, preferably 1/10 or more, or more preferably 1/5 or more.

The mixing ratio of the second polysiloxane with respect to 100 parts by mass of the total amount of the first polysiloxane and the second polysiloxane is, for example, 1 part by mass or more, preferably 50 parts by mass or more, or more preferably, 80 parts by mass or more, and is, for example, 99.99 parts by mass or less, preferably 99.9 parts by mass or less, or more preferably 99.5 parts by mass or less.

The addition catalyst is not particularly limited as long as it is a catalyst that promotes addition of the addable substituted group in the first polysiloxane with the addable substituted group in the first polysiloxane, to be specific, addition in the above-described formulas (6) to (9). Preferably, in view of promoting condensation by an active energy ray, a photocatalyst having active properties with respect to the active energy ray is used.

An example of the photocatalyst includes a hydrosilylation catalyst.

The hydrosilylation catalyst promotes a hydrosilylation addition reaction of a hydrosilyl group with an alkenyl group. An example of the hydrosilylation catalyst includes a transition element catalyst. To be specific, examples thereof include a platinum-based catalyst; a chromium-based catalyst (hexacarbonyl chromium (Cr(CO)₆ and the like); an iron-based catalyst (carbonyltriphenylphosphine iron (Fe(CO)PPh₃ and the like), tricarbonylbisphenylphosphine iron (trans-Fe(CO)₃(PPh₃)₂), polymer-substrate-(aryl-diphenylphosphine)5-n[carbonyl iron] (polymer substrate-(Ar-PPh₂)₅-n[Fe(CO)ₙ]), pentacarbonyl iron (Fe(CO)₅), and the like); a cobalt-based catalyst (tricarbonyltriethylsilylcobalt (Et₃SiCo(CO)₃), tetracarbonyltriphenylsilylcobalt (Ph₃SiCo(CO)₄), octacarbonylcobalt (Co₂(CO)₈), and the like); a molybdenum-based catalyst (hexacarbonylmolybdenum (Mo(CO)₆ and the like); a palladium-based catalyst; and a rhodium-based catalyst.

As the hydrosilylation catalyst, preferably, a platinum-based catalyst is used. Examples thereof include inorganic platinum such as platinum black, platinum chloride, and chloroplatinic acid and a platinum complex such as a platinum olefin complex, a platinum carbonyl complex, a platinum cyclopentadienyl complex, and a platinum acetylacetonate complex.

Preferably, in view of reactivity, a platinum complex is used, or more preferably, a platinum cyclopentadienyl complex and a platinum acetylacetonate complex are used.

Examples of the platinum cyclopentadienyl complex include trimethyl (methylcyclopentadienyl) platinum (IV) and a trimethyl (cyclopentadienyl) platinum (IV) complex.

An example of the platinum acetylacetonate complex includes 2,4-pentanedionato platinum (II) (platinum (II) acetylacetonate).

An example of the transition element catalyst can also include one described in the following document.

Document: ISSN 1070-3632, Russian Journal of General Chemistry, 2011, Vol.81, No.7, pp. 1480 to 1492, "Hydrosilylation on Photoactivated Catalysts", D.A. de Vekki

These addition catalysts can be used alone or in combination.

A commercially available product can be used as the addition catalyst. An addition catalyst synthesized in accordance with a known method can be also used.

The addition catalyst can be, for example, solved in a solvent to be prepared as an addition catalyst solution. The concentration of the addition catalyst in the addition catalyst solution is, for example, 1 mass % or more and 99 mass % or less. When the addition catalyst is a transition element catalyst, the concentration of the transition element is adjusted to be, for example, 0.1 mass % or more and 50 mass % or less.

The mixing ratio of the addition catalyst with respect to 100 parts by mass of the total of the first silicone resin composition is, for example, 1.0 × 10⁻¹¹ parts by mass or more, or preferably, 1.0 × 10⁻⁹ parts by mass or more, and is, for example, 0.5 parts by mass or less, or preferably 0.1 parts by mass or less.

The addition catalyst can be also used in combination with a photoassistance agent such as a photoactive agent, a photoacid generator, and a photobase generator with an appropriate amount as required.

Each of the components containing the first polysiloxane and the second polysiloxane is blended at the above-described mixing proportion to be stirred and mixed, so that the first silicone resin composition can be obtained.

The first silicone resin composition contains a part of the second silicon compound that remains in the preparation of the first polysiloxane.

The first silicone resin composition obtained as described above is, for example, in a liquid state, or preferably, in an oil state (in a viscous liquid state). The viscosity thereof under the conditions of 25°C and one pressure is, for example, 100 mPa·s or more, or preferably 1000 mPa·s or more, and is, for example, 100000 mPa·s or less, or preferably 50000 mPa·s or less. The viscosity thereof is measured under the conditions of one pressure using a rheometer. The viscosity is measured by adjusting a temperature of the first silicone resin composition to 25°C and using an E-type cone at a number of revolutions of 99 s⁻¹.

To be specific, in order to obtain the first silicone resin composition, first, the polydimethylsiloxane containing silanol groups at both ends, the vinyltrimethoxysilane, and the di(2-ethylhexanoate)tin (II) (the condensation catalyst) are blended to prepare the first polysiloxane in an oil state. Thereafter, the polydimethylsiloxane containing hydrosilyl groups at both ends (the second polysiloxane) and a solution of the trimethyl (methylcyclopentadienyl) platinum (IV) or the platinum (II) acetylacetonate (the addition catalyst) are blended thereto.

Alternatively, first, the polydimethylsiloxane containing silanol groups at both ends, the vinyltrimethoxysilane, and the di(2-ethylhexanoate)tin (II) (the condensation catalyst) are blended to prepare the first polysiloxane in an oil state. Thereafter, the polydimethylsiloxane containing hydrosilyl groups at both ends (the second polysiloxane) and a solution of the trimethyl (methylcyclopentadienyl) platinum (IV) complex or the platinum (II) acetylacetonate (the addition catalyst) are blended thereto.

### [Second Silicone Resin Composition]

The second silicone resin composition contains a third polysiloxane containing at least one pair of condensable substituted groups that is capable of condensation by heating and at least one pair of addable substituted groups that is capable of addition by an active energy ray.

An example of the one pair of condensable substituted groups includes the same one pair of condensable substituted groups as that in the first polysiloxane in the first silicone resin composition. The one pair of condensable substituted groups is replaced with the end and the middle of the main chain and/or a side chain in the third polysiloxane.

An example of the one pair of addable substituted groups includes the same one pair of addable substituted groups as that in the first and the second polysiloxanes in the first silicone resin composition. The one pair of addable substituted groups is replaced with the end and the middle of the main chain and/or a side chain in the third polysiloxane.

The third polysiloxane is represented by, for example, the following formula (19).

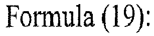

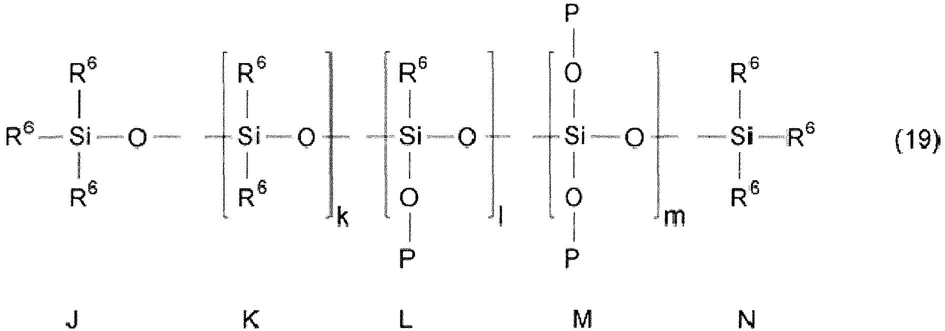

(where, in formula, R⁶ represents a monovalent hydrocarbon group selected from a saturated hydrocarbon group and an aromatic hydrocarbon group; a condensable substituted group; and/or an addable substituted group. J to N represent a constituent unit, J and N represent an end unit, and K to M represent a repeating unit. P represents a constituent unit of K to M. "k" + "l" + "m" is an integer of 1 or more. R⁶ contains at least one pair of condensable substituted groups and at least one pair of addable substituted groups.)

Examples of the monovalent hydrocarbon group, the condensable substituted group, and the addable substituted group represented by R⁶ include the monovalent hydrocarbon group, the condensable substituted group, and the addable substituted group illustrated in the above-described formula (10), respectively.

"k" + "l" + "m" is, in view of stability and handling ability, preferably an integer of 1 or more and 100000 or less, or more preferably an integer of 1 or more and 10000 or less.

"k" is, for example, an integer of 0 or more, or preferably an integer of 1 or more, and is, for example, an integer of 100000 or less, or preferably an integer of 10000 or less.

"l" is, for example, an integer of 0 or more and 100000 or less, or preferably an integer of 0 or more and 10000 or less.

"m" is, for example, an integer of 0 or more and 100000 or less, or preferably an integer of 0 or more and 10000 or less.

The number average molecular weight of the third polysiloxane is, for example, 100 or more, or preferably 200 or more, and is, for example, 1000000 or less, or preferably 100000 or less.

A commercially available product can be used as the third polysiloxane. A third polysiloxane synthesized in accordance with a known method can be also used.

The content ratio of the third polysiloxane with respect to the second silicone resin composition is, for example, 60 mass % or more, or preferably 90 mass % or more, and is, for example, 100 mass % or less.

In order to obtain a silicone semi-cured material from the second silicone resin composition, under the same conditions as those of the first silicone resin composition, the third polysiloxane is heated with the condensation catalyst and thereafter, the addition catalyst is added thereto.

### [Phosphor]

An example of the phosphor includes the same phosphor as that illustrated in the first embodiment. The mixing ratio of the phosphor with respect to 100 parts by mass of the active energy ray curable resin is, for example, 0.1 parts by mass or more, or preferably 0.5 parts by mass or more, and is, for example, 80 parts by mass or less, or preferably 50 parts by mass or less.

### [Filler]

Furthermore, the phosphor resin composition is capable of containing the filler. An example of the filler includes the same filler as that illustrated in the first embodiment. The mixing ratio of the filler with respect to 100 parts by mass of the active energy ray curable resin is, for example, 0.1 parts by mass or more, or preferably 0.5 parts by mass or more, and is, for example, 70 parts by mass or less, or preferably 50 parts by mass or less.

### [Fabrication of Phosphor Sheet 5]

In order to fabricate the phosphor sheet 5, a first silicone resin composition or a second silicone resin composition in an A-stage state and a phosphor, and a filler, which is blended as required, are blended. The obtained mixture is applied to the surface of the release sheet 13 to be thereafter heated, so that the phosphor resin composition is prepared into a sheet shape. In the preparation of the first silicone resin composition or the second silicone resin composition in an A-stage state, the phosphor and the filler, which is blended as required, can be added at any timing of blending of the components or before, during, or after the reaction.

Examples of the release sheet 13 include a polymer film such as a polyethylene film and a polyester film (PET or the like), a ceramic sheet, and a metal foil. Preferably, a polymer film is used. The surface of the release sheet 13 can be also subjected to release treatment such as fluorine treatment.

In the application of the mixture, an application method such as a casting, a spin coating, or a roll coating is used.

The heating conditions are as follows: a heating temperature of, for example, 40°C or more, or preferably 60°C or more, and of, for example, 180°C or less, or preferably 150°C or less and a heating duration of, for example, 0.1 minutes or more, and of, for example, 180 minutes or less, or preferably 60 minutes or less.

When the heating conditions are within the above-described range, a low molecular weight component (for example, a solvent including water or the like) is surely removed to terminate condensation, so that the first silicone resin composition or the second silicone resin composition can be brought into a semi-cured state (a B-stage state).

When the mixture is prepared from the first silicone resin composition, at least one pair of condensable substituted groups contained in the first polysiloxane is subjected to condensation by the above-described heating. In this way, when the condensable substituted group in the first silicon compound is an alkoxy group and the condensable substituted group in the second silicon compound is a hydroxyl group, as shown in the following formula (20), the molecular weight of the first polysiloxane is increased, so that the first silicone resin composition is gelated. That is, the first silicone resin composition is brought into a semi-cured state (a B-stage state), so that a silicone semi-cured material is obtained.

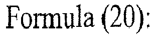

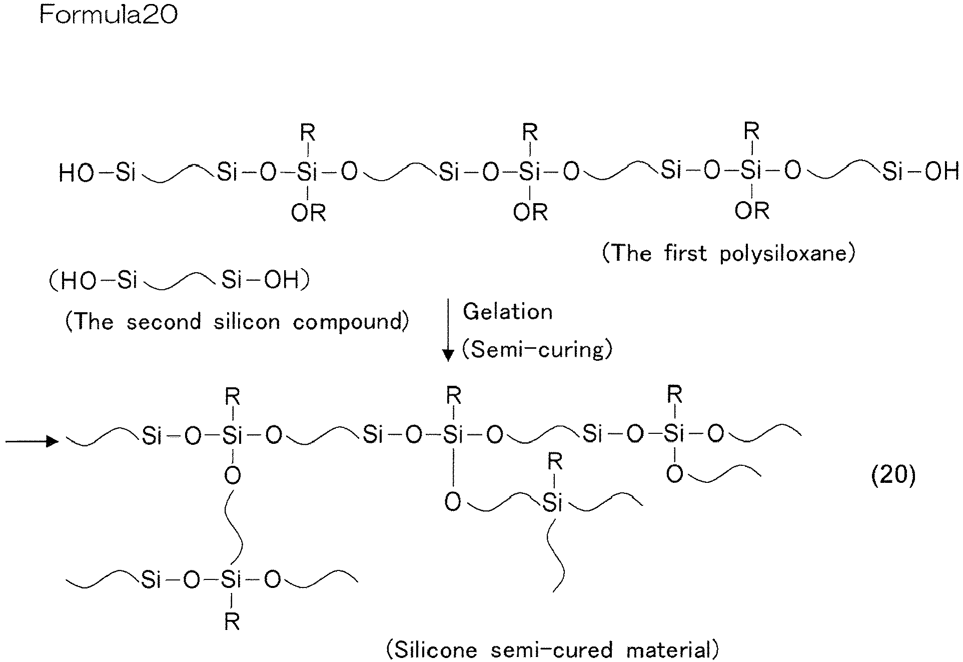

When the mixture is prepared from the second silicone resin composition, at least one pair of condensable substituted groups contained in the third polysiloxane is subjected to condensation by the above-described heating. In this way, the molecular weight of the third polysiloxane is increased, so that the second silicone resin composition is gelated. That is, the second silicone resin composition is brought into a semi-cured state (a B-stage state), so that a silicone semi-cured material is obtained.

In this way, the phosphor sheet 5 formed from the phosphor resin composition containing the silicone semi-cured material and the phosphor (and the filler blended as required) is obtained.

The phosphor sheet 5 has a compressive elastic modulus at 23°C of, for example, 0.01 MPa or more, or preferably 0.04 MPa or more, and of, for example, 1.0 MPa or less.

When the compressive elastic modulus of the phosphor sheet 5 is not more than the above-described upper limit, sufficient flexibility can be secured. On the other hand, when the compressive elastic modulus of the phosphor sheet 5 is not less than the above-described lower limit, the excessive stress applied to the LEDs 4 is prevented and the LEDs 4 can be embedded.

The phosphor sheet 5 has a light transmittance at the wavelength of 400 nm or less of, for example, 50 % or more, or preferably 60 % or more.

When the light transmittance of the phosphor sheet 5 is not less than the above-described lower limit, the light transmission properties can be surely secured and the LED device 15 (described later) having excellent brightness can be obtained.

The thickness T3 of the phosphor sheet 5 is, for example, 10 µm or more, or preferably 100 µm or more, and is, for example, 5000 µm or less, or preferably 2000 µm or less.

In this way, as shown by the upper side view in FIG. 12 (a), the phosphor sheet 5 that is laminated on the release sheet 13 is fabricated (prepared).

Thereafter, the fabricated phosphor sheet 5 is disposed so as to cover the upper portions of a plurality of the LEDs 4 and to form the space 30 over the LEDs 4 that are adjacent to each other.

Thereafter, as shown by the phantom lines in FIG. 12 (b), the release sheet 13 is peeled from the phosphor sheet 5 as required.

### <LED Encapsulating Step>

After the phosphor sheet disposing step, as shown by the arrow in FIG. 12 (c), an active energy ray is applied to the phosphor sheet 5 in the LED encapsulating step.

Examples of the active energy ray include an ultraviolet ray and an electron beam. An example of the active energy ray also includes an active energy ray having a spectral distribution in a wavelength region of, for example, 180 nm or more, or preferably 200 nm or more, and of, for example, 460 nm or less, or preferably 400 nm or less.

In the application of the active energy ray, an application device is used. Examples thereof include a chemical lamp, an excimer laser, a black light, a mercury arc, a carbon arc, a low pressure mercury lamp, a medium pressure mercury lamp, a high pressure mercury lamp, an extra-high pressure mercury lamp, and a metal halide lamp. Also, an example thereof can include an application device capable of generating an active energy ray that is in the longer wavelength side or in the shorter wavelength side than in the above-described wavelength region.

The amount of irradiation is, for example, 0.001 J/cm² or more, and is, for example, 100 J/cm² or less, or preferably 10 J/cm² or less.

The irradiation duration is, for example, 10 minutes or less, or preferably 1 minute or less, and is, for example, 5 seconds or more.

The active energy ray is, for example, applied from the upper side and/or the lower side toward the phosphor sheet 5. Preferably, as shown by the arrow in FIG. 12 (c), the active energy ray is applied from the upper side toward the phosphor sheet 5.

In the application of the active energy ray toward the phosphor sheet 5, when the support sheet 32 is an active energy ray irradiation release sheet, the active energy ray irradiation release sheet and the irradiation conditions are selected so as not to reduce the pressure-sensitive adhesive force of the support sheet 32 by application of the active energy ray to the phosphor sheet 5.

Along with the above-described application of the active energy ray, heating is also capable of being performed.

The timing of the heating may be at the same time with the application of the active energy ray, or before or after the application of the active energy ray. Preferably, the heating is performed after the application of the active energy ray.

The heating conditions are as follows: a temperature of, for example, 50°C or more, or preferably 100°C or more, and of, for example, 250°C or less, or preferably 200°C or less, and a heating duration of, for example, 0.1 minutes or more, and of, for example, 1440 minutes or less, or preferably 180 minutes or less.

The phosphor sheet 5 is completely cured by the above-described application of the active energy ray (and heating performed as required) to be brought into a C-stage state.

To be specific, when the silicone semi-cured material is prepared from the first silicone resin composition, as shown by the following formula (21), in a case where the addable substituted group in the first polysiloxane is a vinyl group and the addable substituted group in the second polysiloxane is a hydrosilyl group, they are subjected to addition (hydrosilylation addition) by application of the active energy ray (and heating performed as required).

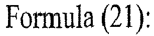

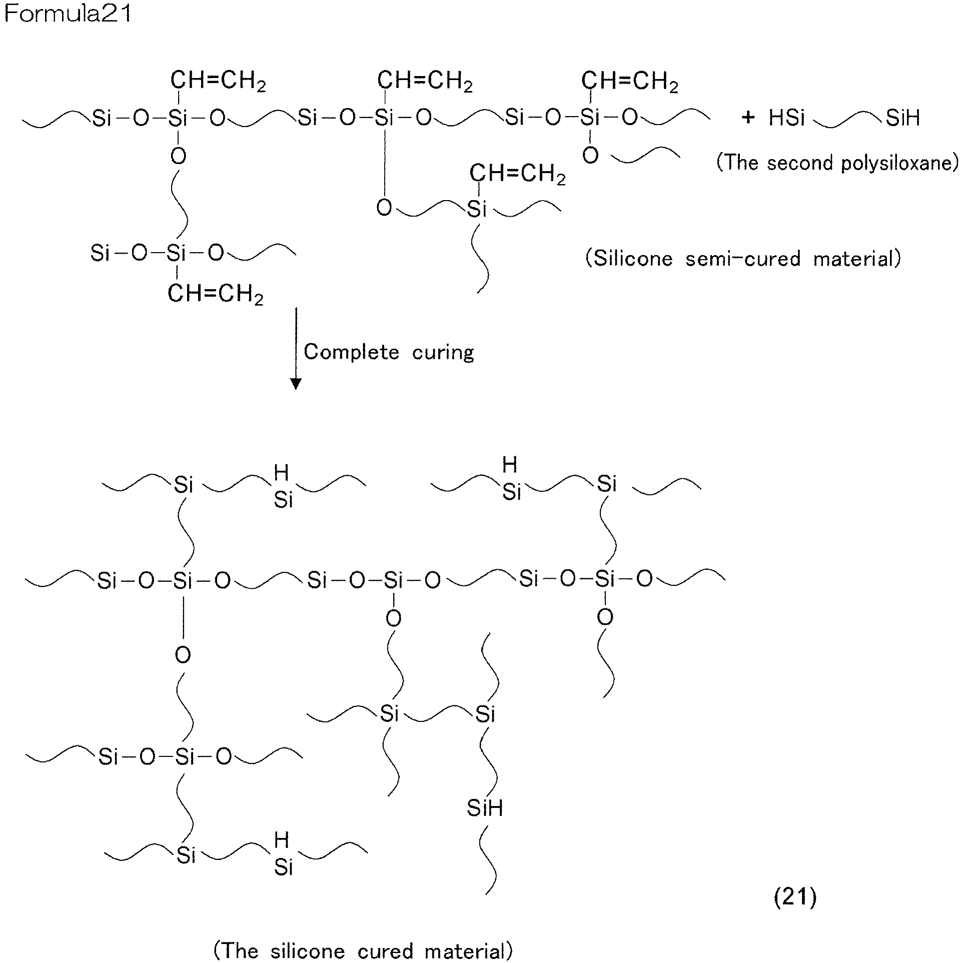

Alternatively, when the silicone semi-cured material is prepared from the second silicone resin composition, in a case where the addable substituted group in the third polysiloxane is a vinyl group and a hydrosilyl group, they are subjected to addition (hydrosilylation addition) by application of the active energy ray (and heating performed as required).

In this way, the silicone semi-cured material is completely cured. That is, the phosphor sheet 5 is completely cured (brought into a C-stage state).

The degree of progress of the addition in the complete curing can be checked with the peak strength derived from the addable substituted group with, for example, a solid NMR measurement.

The phosphor sheet 5 that is brought into a C-stage state (completely cured) has flexibility. To be specific, the phosphor sheet 5 that is brought into a C-stage state (completely cured) has a compressive elastic modulus at 23°C of, for example, 0.5 MPa or more, or preferably 1.0 MPa or more, and of, for example, 100 MPa or less, or preferably 10 MPa or less.

When the compressive elastic modulus of the phosphor sheet 5 is not more than the above-described upper limit, the flexibility can be surely secured and in the cutting step (ref: the dashed lines in FIG. 12 (d)) to be described next, for example, the phosphor sheet 5 can be cut using a relatively cheap cutting device. When the compressive elastic modulus of the phosphor sheet 5 is not less than the above-described lower limit, the shape thereof after being cut can be retained.

In this way, the side surfaces of the upper portions of the LEDs 4 and the upper surfaces thereof are covered with the phosphor sheet 5 in tight contact with each other. That is, the upper portions of the LEDs 4 are encapsulated by the phosphor sheet 5 in a C-stage state.

### <Cutting Step>

After the LED encapsulating step, as shown by the dashed lines in FIG. 12 (d), in the cutting step, the flexible phosphor sheet 5 around the LEDs 4 is cut along the thickness direction. The phosphor sheet 5 is, for example, cut into a generally rectangular shape in plane view that surrounds each of the LEDs 4.

In this way, the phosphor layer-covered LEDs 10, each of which includes the LED 4 and the phosphor layer 7 formed of the phosphor sheet 5 that covers the surfaces (the upper surface and the side surfaces) of the upper portion of the LED 4, are obtained in a state where the LEDs 4 are in tight contact with the support sheet 32.

### <LED Peeling Step>

After the cutting step, as shown in FIG. 12 (e), the support sheet 32 is stretched in the plane direction and each of the phosphor layer-covered LEDs 10 is peeled from the support sheet 32.

To be specific, first, as shown by the arrows in FIG. 12 (d), the support sheet 32 is stretched outwardly in the plane direction. In this way, as shown in FIG. 12 (e), in a state where the phosphor layer-covered LEDs 10 are in tight contact with the support sheet 32, the tensile stress is concentrated in the cuts 8; thus, the cuts 8 expand; and the LEDs 4 are separated from each other, so that the gaps 19 are formed. Each of the gaps 19 is formed into a generally grid shape in plane view so as to separate the LEDs 4.

Thereafter, each of the phosphor layer-covered LEDs 10 is peeled from the upper surface of the support sheet 32.

To be specific, as shown in FIG. 12 (e'), for example, each of the phosphor layer-covered LEDs 10 is peeled from the support sheet 32 with the pick-up device 17 that is provided with the pressing member 14 such as a needle and the absorbing member 16 such as a collet. In the pick-up device 17, the pressing member 14 presses (pushes up) the support sheet 32 corresponding to the phosphor layer-covered LED 10 that is intended to be peeled off from the lower side thereof. In this way, the phosphor layer-covered LED 10 that is intended to be peeled off is pushed up upwardly, and the pushed-up phosphor layer-covered LED 10 is peeled from the support sheet 32, while being absorbed by the absorbing member 16 such as a collet.

When the support sheet 32 is stretched in the plane direction, the gap 19 is formed between the phosphor layer-covered LED 10 that is intended to be peeled off and the phosphor layer-covered LED 10 that is adjacent thereto. Thus, it can be prevented that when the absorbing member 16 is brought into contact with the phosphor layer-covered LED 10 that is intended to be peeled off, the absorbing member 16 comes in contact with the phosphor layer-covered LED 10 that is adjacent thereto to cause a damage to the phosphor layer-covered LED 10.

When the above-described support sheet 32 is a thermal release sheet, instead of the stretching of the support sheet 32 described above or in addition to the stretching of the support sheet 32, the support sheet 32 can be also heated at, for example, 50°C or more, or preferably 70°C or more, and at, for example, 200°C or less, or preferably 150°C or less.

When the above-described support sheet 32 is an active energy ray irradiation release sheet, instead of the stretching of the support sheet 32 described above or in addition to the stretching of the support sheet 32, an active energy ray can be also applied to the support sheet 32.

The pressure-sensitive adhesive force of the support sheet 32 is reduced by those treatments, so that each of the phosphor layer-covered LEDs 10 is capable of being further easily peeled from the support sheet 32.

In this way, as shown in FIG. 12 (e), each of the phosphor layer-covered LEDs 10 that is peeled from the support sheet 32 is obtained.

### <Mounting Step>

After the LED peeling step, after the phosphor layer-covered LED 10 is selected in accordance with emission wavelength and luminous efficiency, as shown in FIG. 12 (f), the selected phosphor layer-covered LED 10 is mounted on the substrate 9. In this way, the LED device 15 is obtained.

Thereafter, as shown by the phantom line in FIG. 12 (f), the encapsulating protective layer 20 that encapsulates the phosphor layer-covered LED 10 is provided in the LED device 15 as required. In this way, the reliability of the LED device 15 is capable of being improved.

In the method for producing the phosphor layer-covered LED 10 in the seventh embodiment, the phosphor sheet 5 that is formed from a phosphor resin composition containing an active energy ray curable resin, which is capable of being cured by application of an active energy ray, and a phosphor is disposed so as to cover the upper portions of the LEDs 4 and to form the space 30. Thereafter, the active energy ray is applied to the phosphor sheet 5 and the upper portions of the LEDs 4 are encapsulated by the phosphor sheet 5. Thus, a damage to the support sheet 32 is suppressed and the upper portions of the LEDs 4 are encapsulated, so that the phosphor is capable of being uniformly dispersed around the LEDs 4.

That is, the phosphor sheet 5 is cured by application of the active energy ray thereto without heating the phosphor sheet 5 or by reducing the heating thereof, so that the upper portions of the LEDs 4 are capable of being encapsulated. Thus, the support sheet 32 that supports the phosphor sheet 5 is not required to have heat resistance, that is, the support sheet 32 having low heat resistance is capable of being used.

Additionally, when the phosphor sheet 5 is completely cured, the irradiation duration for applying an active energy ray is capable of being set to be short, compared to a case where the phosphor sheet 5 is completely cured by heating only.

Also, by cutting the phosphor sheet 5 corresponding to each of the LEDs 4, the phosphor layer-covered LEDs 10, each of which includes the LED 4 and the phosphor layer 7 formed of the phosphor sheet 5 that covers the surfaces of the upper portion of the LED 4, are obtained. Thereafter, each of the phosphor layer-covered LEDs 10 is peeled from the support sheet 32. Thus, the phosphor sheet 5 supported by the support sheet 32 in which a damage is suppressed is cut with excellent size stability, so that the phosphor layer-covered LED 10 having excellent size stability is capable of being obtained.

When the phosphor sheet 5 is cut while being supported by the support sheet 32 in the cutting step and thereafter, the support sheet 32 is heated in the LED peeling step, the support sheet 32 that supports the phosphor sheet 5 in the cutting step and completes its role is heated and then, each of the phosphor layer-covered LEDs 10 is peeled off. In this way, the phosphor layer-covered LED 10 having excellent size stability is capable of being efficiently obtained.

Consequently, the phosphor layer-covered LED 10 has excellent size stability.

The LED device 15 includes the phosphor layer-covered LED 10 having excellent size stability, so that it has excellent reliability and thus, its luminous efficiency is improved.

### <Modified Example>

In the above-described seventh embodiment, the support sheet 32 is formed of one layer. Alternatively, for example, though not shown, the support sheet 32 can be also formed of two layers of a hard support substrate that is incapable of stretching in the plane direction and a pressure-sensitive adhesive layer that is laminated on the support substrate.

Examples of a hard material for forming the support substrate include an oxide such as a silicon oxide (silica or the like) and a metal such as stainless steel. The thickness of the support substrate is, for example, 0.1 mm or more, or preferably 0.3 mm or more, and is, for example, 5 mm or less, or preferably 2 mm or less.

The pressure-sensitive adhesive layer is formed on the entire upper surface of the support substrate. An example of a pressure-sensitive adhesive material for forming the pressure-sensitive adhesive layer includes a pressure-sensitive adhesive such as an acrylic pressure-sensitive adhesive. The thickness of the pressure-sensitive adhesive layer is, for example, 0.1 mm or more, or preferably 0.2 mm or more, and is, for example, 1 mm or less, or preferably 0.5 mm or less.

Preferably, as shown by the upper side view in FIG. 12 (a), the support sheet 32 that is capable of stretching in the plane direction is formed of one layer.

According to this, in the LED peeling step shown in FIG. 12 (e), the support sheet 32 is stretched in the plane direction and each of the phosphor layer-covered LEDs 10 is peeled from the support sheet 32. Thus, as shown in FIG. 12 (e'), the phosphor layer-covered LED 10 is capable of being easily and surely peeled from the support sheet 32 using the above-described pick-up device 17.

A hard support substrate is not provided in the support sheet 32, so that as referred in FIG. 12 (e'), the support sheet 32 and the corresponding phosphor layer-covered LED 10 are capable of being pushed up from the lower side by the pressing member 14 in the pick-up device 17.

Additionally, a hard support substrate is not required to be laminated on the pressure-sensitive adhesive layer, so that the production process is capable of being simplified.

### <Eighth Embodiment>

In the views in the eighth embodiment, the same reference numerals are provided for members and steps corresponding to each of those in the first to seventh embodiments, and their detailed description is omitted.

The method for producing the phosphor layer-covered LED 10 in the eighth embodiment includes a support sheet preparing step of preparing the support sheet 1 (ref: FIG. 13 (a)); an LED attaching step of attaching the LEDs 4 to the support substrate 2 via the pressure-sensitive adhesive layer 3 (one example of a semiconductor element disposing step, ref: FIG. 13 (b)); an LED encapsulating step of encapsulating the upper portions of the LEDs 4 by the phosphor sheet 5 (ref: FIGS. 13 (c) and 13 (d)); a cutting step of cutting the phosphor sheet 5 corresponding to each of the LEDs 4 (ref: the dashed lines in FIG. 13 (d)); and an LED peeling step of peeling the phosphor layer-covered LEDs 10 from the pressure-sensitive adhesive layer 3 (ref: FIG. 13 (e)). The method for producing the LED device 15 in the eighth embodiment includes a mounting step (ref: FIG. 13 (f)).

In the following, the steps of the eighth embodiment are described in detail.

### <Support Sheet Preparing Step>

As shown in FIG. 13 (a), the support sheet 1 includes the support substrate 2 and the pressure-sensitive adhesive layer 3 that is laminated on the upper surface of the support substrate 2.

An example of the support substrate 2 includes the same support substrate 2 as that illustrated in the first embodiment.

The pressure-sensitive adhesive layer 3 is formed from a material in which the pressure-sensitive adhesive force is capable of being reduced by application of an active energy ray as an active energy ray irradiation release layer (sheet). To be specific, the pressure-sensitive adhesive layer 3 is formed of a pressure-sensitive adhesive layer such as an acrylic pressure-sensitive adhesive layer. Also, the pressure-sensitive adhesive layer 3 can be formed of, for example, the active energy ray irradiation release layer (sheet) described in Japanese Unexamined Patent Publication No. 2001-308116.

The thickness of the pressure-sensitive adhesive layer 3 is, for example, 0.01 mm or more, or preferably 0.02 mm or more, and is, for example, 1 mm or less, or preferably 0.5 mm or less.

In order to prepare the support sheet 1, for example, the support substrate 2 is attached to the pressure-sensitive adhesive layer 3. The thickness of the support sheet 1 is, for example, 0.2 mm or more, or preferably 0.5 mm or more, and is, for example, 6 mm or less, or preferably 2.5 mm or less.

### <LED attaching step>

The LED attaching step is performed after the support sheet preparing step.

In the LED attaching step, as shown by the lower side view in FIG. 13 (b), for example, a plurality of the LEDs 4 are attached to the upper surface of the pressure-sensitive adhesive layer 3 in alignment. To be specific, a plurality of the LEDs 4 are attached to the upper surface of the pressure-sensitive adhesive layer 3 so that a plurality of the LEDs 4 are spaced apart from each other at equal intervals in the front-rear and the right-left directions in plane view. The LEDs 4 are attached to the upper surface of the pressure-sensitive adhesive layer 3 so that the bumps thereof that are not shown are opposed to the upper surface of the pressure-sensitive adhesive layer 3. In this way, the LEDs 4 are supported at (pressure-sensitively adhere to) the upper surface of the pressure-sensitive adhesive layer 3 so that the alignment state thereof is retained.

### <LED Encapsulating Step>

The LED encapsulating step is performed after the LED attaching step.

In the upper side view in FIG. 13 (b), the phosphor sheet 5 is formed from the same phosphor resin composition as that in the first embodiment into a sheet shape extending in the plane direction.

As shown in FIG. 13 (c), in order to encapsulate the upper portions of the LEDs 4 by the phosphor sheet 5, first, as shown by the upper side view in FIG. 13 (b), the phosphor sheet 5 is prepared.

Next, as shown in FIG. 13 (c), the phosphor sheet 5 is disposed so as to cover the upper portions of the LEDs 4 and to form the space 30 over the LEDs 4 that are adjacent to each other (the phosphor sheet disposing step as one example of an encapsulating sheet disposing step).

Thereafter, as shown by the phantom lines in FIG. 13 (c), the release sheet 13 is peeled from the upper surface of the phosphor sheet 5.

Thereafter, as shown in FIG. 13 (d), the phosphor sheet 5 is cured. When the curable resin is a thermosetting resin, the phosphor sheet 5 is thermally cured. To be specific, the phosphor sheet 5 is heated at, for example, 80°C or more, or preferably 100°C or more, and at, for example, 200°C or less, or preferably 180°C or less.

When the thermosetting resin contains a two-step curable type silicone resin and the phosphor sheet 5 that embeds the LEDs 4 is in a B-stage state, the phosphor sheet 5 is completely cured to be brought into a C-stage state by the above-described heating.

When the thermosetting resin contains a one-step curable type silicone resin, the phosphor sheet 5 is completely cured to be brought into a C-stage state by the above-described heating.

Alternatively, when the curable resin is an active energy ray curable resin, an active energy ray is applied to the phosphor sheet 5 from the upper side. When the active energy ray is applied from the upper side, the curable resin and the irradiation conditions are selected so as not to reduce the pressure-sensitive adhesive force of the pressure-sensitive adhesive layer 3 by application of the active energy ray.

The cured (completely cured) phosphor sheet 5 has flexibility. The phosphor sheet 5 has a light transmittance at the wavelength of 400 nm or less of, for example, 50 % or more, or preferably 60 % or more. When the light transmittance of the phosphor sheet 5 is not less than the above-described lower limit, the transmission properties of the active energy ray in the phosphor layer 7 are secured, so that the active energy ray can transmit through the phosphor layer 7 to reach the pressure-sensitive adhesive layer 3. At the same time, the LED device 15 (described later) having excellent brightness is capable of being obtained.

In this way, the upper portions of the side surfaces of the LEDs 4 and the upper surfaces thereof are covered with the phosphor sheet 5 in tight contact with each other. That is, the upper portions of the LEDs 4 are encapsulated by the phosphor sheet 5 in a C-stage state.

### <Cutting Step>

After the LED encapsulating step, as shown by the dashed lines in FIG. 13 (d), in the cutting step, the phosphor sheet 5 around the LEDs 4 is cut along the thickness direction. As shown by the dash-dot lines in FIG. 2, the phosphor sheet 5 is, for example, cut into a generally rectangular shape in plane view that surrounds each of the LEDs 4.

By the cutting step, the phosphor layer-covered LEDs 10, each of which includes the LED 4 and the phosphor layer 7 formed of the phosphor sheet 5 that covers the surfaces (the upper surface and the side surfaces) of the upper portion of the LED 4, are obtained in a state where the LEDs 4 are in tight contact with the support sheet 1. That is, the phosphor sheets 5 are singulated corresponding to the LEDs 4. The properties (the light transmittance and the like) of the phosphor layer 7 are the same as those of the phosphor sheet 5.

### <LED Peeling Step>

After the cutting step, as shown in FIG. 13 (e), in the LED peeling step, each of the phosphor layer-covered LEDs 10 is peeled from the upper surface of the pressure-sensitive adhesive layer 3.

In order to peel each of the phosphor layer-covered LEDs 10 from the upper surface of the pressure-sensitive adhesive layer 3, first, as shown by a down arrow in FIG. 13 (e), an active energy ray is applied from the upper side to the pressure-sensitive adhesive layer 3 via the phosphor sheet 5.

Examples of the active energy ray include an ultraviolet ray and an electron beam. An example of the active energy ray also includes an active energy ray having a spectral distribution in a wavelength region of, for example, 180 nm or more, or preferably 200 nm or more, and of, for example, 460 nm or less, or preferably 400 nm or less.

In the application of the active energy ray, an application device is used. Examples thereof include a chemical lamp, an excimer laser, a black light, a mercury arc, a carbon arc, a low pressure mercury lamp, a medium pressure mercury lamp, a high pressure mercury lamp, an extra-high pressure mercury lamp, and a metal halide lamp. Also, an example thereof includes an application device capable of generating an active energy ray that is in the longer wavelength side or in the shorter wavelength side than in the above-described wavelength region.

The amount of irradiation is, for example, 0.001 J/cm² or more, or preferably 0.01 J/cm² or more, and is, for example, 100 J/cm² or less, or preferably 10 J/cm² or less. When the amount of irradiation is not less than the above-described lower limit, the pressure-sensitive adhesive force of the pressure-sensitive adhesive layer 3 can be surely and efficiently reduced. On the other hand, when the amount of irradiation is not more than the above-described upper limit, an increase in cost can be suppressed and a damage to a device can be effectively prevented.

The irradiation duration is, for example, 10 minutes or less, or preferably 1 minute or less, and is, for example, 5 seconds or more. When the upper limit of the irradiation duration is not more than the above-described upper limit, the duration required for the LED peeling step can be shortened.

All or a part of the active energy ray transmits through the phosphor layer 7 from the upper side to be applied to the pressure-sensitive adhesive layer 3.

By the application of the active energy ray, the pressure-sensitive adhesive force of the pressure-sensitive adhesive layer 3 is reduced.

In this state, as shown by an up arrow in FIG. 13 (e), each of the phosphor layer-covered LEDs 10 is peeled from the pressure-sensitive adhesive layer 3. In order to peel each of the phosphor layer-covered LEDs 10 from the pressure-sensitive adhesive layer 3, though not shown, a pick-up device that is provided with an absorbing member such as a collet is capable of being used as required. To be specific, each of the phosphor layer-covered LEDs 10 is capable of being peeled from the pressure-sensitive adhesive layer 3, while being absorbed by an absorbing member.

In the peeling of each of the phosphor layer-covered LEDs 10 from the pressure-sensitive adhesive layer 3, the lower surface of each of the LEDs 4 is peeled from the upper surface of the pressure-sensitive adhesive layer 3.

In this way, each of the phosphor layer-covered LEDs 10 that is peeled from the pressure-sensitive adhesive layer 3 is obtained.

### [Mounting Step]

After the LED peeling step, after the phosphor layer-covered LED 10 is selected in accordance with emission wavelength and luminous efficiency, as shown in FIG. 13 (f), the selected phosphor layer-covered LED 10 is mounted on the substrate 9. In this way, the LED device 15 is obtained.

In this way, the LED device 15 including the substrate 9 and the phosphor layer-covered LED 10 that is mounted on the substrate 9 is obtained.

Thereafter, as shown by the phantom line in FIG. 13 (f), the encapsulating protective layer 20 that encapsulates the phosphor layer-covered LED 10 is provided in the LED device 15 as required. In this way, the reliability of the LED device 15 is capable of being improved.

According to the method in the eighth embodiment, in the LED peeling step, an active energy ray is applied from the upper side to the pressure-sensitive adhesive layer 3 via the phosphor sheet 5. Then, the active energy ray transmits through the phosphor sheet 5 to be applied to the pressure-sensitive adhesive layer 3. Thus, it is not required that the support substrate 2 is formed from a substrate material that allows an active energy ray to transmit therethrough and the active energy ray is allowed to transmit through the support substrate 2. As a result, as the support substrate 2, not only a support substrate having active energy ray transmissive properties is used, but also a support substrate having active energy ray blocking properties can be selected.

After the cutting step, the LED peeling step is performed. That is, in the cutting step, the LEDs 4 and the phosphor sheet 5 are supported by the support sheet 1 including the hard support substrate 2 and the phosphor sheet 5 is capable of being cut. Thus, the phosphor layer-covered LED 10 having excellent size stability is capable of being obtained.

Furthermore, in this method, in the LED peeling step, an active energy ray is applied to the pressure-sensitive adhesive layer 3, so that a deformation of the support sheet 1 caused by heating is prevented and the size stability is capable of being further improved, compared to a method in which the pressure-sensitive adhesive force of the pressure-sensitive adhesive layer 3 is reduced by heating of the pressure-sensitive adhesive layer 3.

Consequently, the phosphor layer-covered LED 10 has excellent size stability.

The LED device 15 includes the phosphor layer-covered LED 10 having excellent size stability, so that it has excellent reliability and thus, its luminous efficiency is improved.

### <Modified Example>

In the LED peeling step in the embodiment in FIG. 13 (e), an active energy ray is applied from the upper side only to the pressure-sensitive adhesive layer 3. However, in the eighth embodiment, an active energy ray may be applied at least from the upper side. For example, when the support substrate 2 is formed from an active energy ray transmissive material or an active energy ray semi-transmissive material, an active energy ray can be also applied from both of the upper side and the lower side to the pressure-sensitive adhesive layer 3. In such a case, of the active energy ray applied from the lower side of the support sheet 1, all or a part of the active energy ray transmits through the support substrate 2 to reach the pressure-sensitive adhesive layer 3.

According to the modified example, in the LED peeling step, a duration required for reducing the pressure-sensitive adhesive force of the pressure-sensitive adhesive layer 3, that is, the irradiation duration of an active energy ray is capable of being further shortened and the production efficiency of the phosphor layer-covered LED 10 is capable of being improved.

### <Ninth Embodiment>

In the first to eighth embodiments, first, the phosphor layer-covered LED 10 is fabricated and prepared (ref: FIGS. 1 (e), 6 (e), 8 (f), 9 (g), 10 (h), 11 (i), 12 (e), and 13 (e)) and thereafter, the LED 4 in the phosphor layer-covered LED 10 is mounted on the substrate 9 (ref: FIGS. 1 (f), 6 (f), 8 (g), 9 (h), 10 (i), 11 (j), 12 (f), and 13 (f)).

Alternatively, as referred in FIG. 14, as shown in FIG. 14 (a), a plurality of the LEDs 4 are mounted on the substrate 9 in advance and thereafter, as shown in FIG. 14 (b), the phosphor sheet 5 is capable of being disposed so as to cover the upper portions of a plurality of the LEDs 4 and to form the space 30 over the LEDs 4 that are adjacent to each other.

In the ninth embodiment, as shown in FIG. 14 (a), a plurality of the LEDs 4 are mounted on the substrate 9 in advance so as to be spaced apart from each other at equal intervals in the front-rear and the right-left directions.

Thereafter, the phosphor sheet 5 is disposed on the substrate 9 so as to form the space 30. In order to dispose the phosphor sheet 5 so as to form the space 30, first, the phosphor sheet 5 is prepared. Then, as shown in FIG. 14 (b), the phosphor sheet 5 is compressively bonded to the upper portions of a plurality of the LEDs 4. The compressive bonding is performed under a reduced pressure atmosphere or under a normal pressure atmosphere. Preferably, the compressive bonding is performed under a reduced pressure atmosphere. In this way, the space 30 is formed. Thereafter, when the phosphor sheet 5 contains a curable resin, the phosphor sheet 5 is cured, so that the upper portions of a plurality of the LEDs 4 are encapsulated.

In this way, the phosphor layer-covered LEDs 10 are formed on the substrate 9 and the LED device 15, which includes the substrate 9, a plurality of the LEDs 4, and the phosphor sheet 5, is obtained.

Thereafter, as shown by the phantom line in FIG. 14 (b), after the encapsulating protective layer 20 is provided as required, the LED devices 15 can be also singulated corresponding to each of the LEDs 4. Along with the production of the LED device 15, the phosphor layer-covered LED 10 is fabricated.

In the ninth embodiment, the phosphor layer-covered LED 10 is not required to be selected in accordance with emission wavelength and luminous efficiency and the LEDs 4 are mounted on the substrate 9 in advance, so that the step of selection of the phosphor layer-covered LED 10 described above is capable of being omitted.

### <Tenth Embodiment>

In the above-described first embodiment, as shown in FIG. 1 (c), in the phosphor sheet disposing step in the LED covering step, the pushed-in amount of the phosphor layer 7 is controlled by adjusting the amount of displacement of a pressing substrate in a pressing device that is not shown in the up-down direction. Alternatively, for example, as shown in FIG. 15, the pushed-in amount of the phosphor layer 7 can be also controlled by using a spacer 27.

In FIGS. 15 and 16, the same reference numerals are provided for members and steps corresponding to each of those in the first embodiment, and their detailed description is omitted. In FIG. 16, the spacer 27 (described later) is shown by hatching.

The tenth embodiment includes a support sheet preparing step (ref: FIG. 15 (a)), an LED disposing step (ref: FIG. 15 (b)), an LED covering step (ref: FIGS. 15 (c) and 15 (d)), a cutting step (ref: the dashed lines in FIG. 15 (d)), and an LED peeling step (ref: FIGS. 15 (e) and 15 (e')) and in addition to those steps, further includes a spacer disposing step (ref: FIG. 15 (a)).

### [Spacer Disposing Step]

As shown in FIG. 15 (a), the spacer disposing step is performed after the support sheet preparing step.

In the spacer disposing step, the spacer 27 is provided on the support sheet 1. As shown in FIGS. 15 (a) and 16, the spacer 27 is, on the upper surface of the pressure-sensitive adhesive layer 3, disposed so as to surround placement regions 24 on which a plurality of the LEDs 4 are placed. That is, the spacer 27 is, when projected in the thickness direction, formed into a generally frame shape in plane view so as not to be overlapped with the placement regions 24. Each of opening portions 28 in the spacer 27 is formed so as to include each of the placement regions 24. To be specific, each of the opening portions 28 is formed into a generally rectangular shape in plane view that is larger than each of the placement regions 24.

A length L3 of one side of the opening portions 28 in the spacer 27 is longer than the length of one side of the LED 4. To be specific, the length L3 of one side of the opening portions 28 in the spacer 27 with respect to the length of one side of the LED 4 is, for example, above 100 %, preferably 110 % or more, more preferably 125 % or more, or further more preferably 150 % or more, and is, for example, 300 % or less. To be more specific, the length L3 of one side of the opening portions 28 in the spacer 27 is, for example, 0.3 mm or more, or preferably 1.0 mm or more, and is, for example, 5.0 mm or less, or preferably 3.0 mm or less. A width L4 of the spacer 27 is appropriately set in accordance with the length L3 of one side of the opening portions 28 in the spacer 27. To be specific, the width L4 of the spacer 27 is, for example, 0.3 mm or more, or preferably 0.5 mm or more, and is, for example, 5.0 mm or less, or preferably 3.0 mm or less.

A thickness T5 of the spacer 27 is set to be the desired thickness T2 of the space 30 (ref: FIG. 15 (c)), to be specific, the length obtained by subtracting the thickness T1 (the entering length) of the entering portion 31 (ref: FIG. 15 (c)) from the thickness T0 of the LED 4 (ref: FIG. 15(b)).

Examples of a material for forming the spacer 27 include a resin and a metal. Examples of the resin include polyester such as PET and a polyolefin such as polypropylene and polyethylene. Examples of the metal include iron, copper, and stainless steel. The surface of the spacer 27 can be also subjected to release treatment such as fluorine treatment.

In order to provide the spacer 27 on the support sheet 1, for example, the spacer 27 that is trimmed into the above-described shape in advance is placed on the upper surface of the pressure-sensitive adhesive layer 3. Alternatively, after a sheet that is formed of the above-described material is laminated on the upper surface of the pressure-sensitive adhesive layer 3, the obtained laminate can be formed into the above-described shape by a known pattern forming method.

### [LED Covering Step]

The LED covering step includes a phosphor sheet disposing step (ref: FIG. 15 (c)) and an LED encapsulating step (ref: FIG. 15 (d)).

### (Phosphor Sheet Disposing Step)

As shown in FIG. 15 (c), in the phosphor sheet disposing step, the phosphor sheet 5 is pushed in with respect to the upper portions of a plurality of the LEDs 4 until the lower surface of the phosphor sheet 5 comes in contact with the upper surface of the spacer 27. To be more specific, the phosphor sheet 5 is pushed in with respect to the upper portions of a plurality of the LEDs 4 until the lower surface of the phosphor sheet 5 that is opposed to the region other than the placement regions 24 comes in contact with the upper surface of the spacer 27. The phosphor sheet 5 that is opposed to the region other than the placement regions 24 serves as the entering portions 31.

The pushing-in of the phosphor sheet 5 is controlled by the thickness T5 of the spacer 27. To be specific, the phosphor sheet 5 is pushed in until the lower surfaces of the entering portions 31 come in contact with the upper surface of the spacer 27 after the lower surface of the phosphor sheet 5 is in contact with the upper surfaces of the LEDs 4.

The pushing-in of the phosphor layer 7 is adjusted so as to ensure the space 30.

In the tenth embodiment, the same function and effect as that of the first embodiment can be achieved. Furthermore, compared to the embodiment in FIG. 1, the pushing-in of the phosphor sheet 5 is capable of being controlled by the thickness T5 of the spacer 27. That is, by accurately adjusting the thickness T5 of the spacer 27, the pushed-in amount of the phosphor sheet 5 is capable of being accurately adjusted.

### <Eleventh Embodiment>

In the above-described second embodiment, as shown in FIG. 6, the support substrate 2 is formed into a flat plate shape in which the upper surface thereof is flat. Alternatively, for example, as shown in FIG. 17, support concave portions 22 can be provided in the upper surface of the support substrate 2.

In FIGS. 17 and 18, the same reference numerals are provided for members and steps corresponding to each of those in the second embodiment, and their detailed description is omitted. In FIG. 18, a support protruding portion 23 (described later) is shown by hatching.

The eleventh embodiment includes a support sheet preparing step (ref: FIG. 17 (a)), an LED disposing step (ref: FIG. 17 (b)), a phosphor sheet disposing step (ref: FIG. 17 (c)), an LED encapsulating step (ref: FIG. 17 (d)), a cutting step (ref: the dashed lines in FIG. 17 (d)), and an LED peeling step (ref: the arrow in FIG. 17 (e)).

### [Support Sheet Preparing Step]

Each of the support concave portions 22 is provided so as to dent from the upper surface of the support substrate 2 downwardly. That is, each of the support concave portions 22 is defined as a concave portion having an opening upwardly. As shown in FIGS. 17 (a) and 18, the support concave portions 22 are provided so as to correspond to the placement regions 24 in the pressure-sensitive adhesive layer 3. To be specific, the support concave portions 22 are, in plane view, disposed in alignment at spaced intervals to each other in the front-rear and the right-left directions. Each of the support concave portions 22 is, when projected in the thickness direction, formed so as to include each of the placement regions 24. Each of the support concave portions 22 is formed into a generally rectangular shape in plane view that is slightly larger than each of the placement regions 24. In the support substrate 2, a portion other than the support concave portions 22 is defined as the support protruding portion 23. The support protruding portion 23 is, when projected in the thickness direction, formed into a generally grid shape in plane view.

A length L5 of one side of the support concave portion 22 is longer than the length of one side of the LED 4. To be specific, the length L5 of one side of the support concave portion 22 with respect to the length of one side of the LED 4 is, for example, above 100 %, preferably 110 % or more, more preferably 125 % or more, or further more preferably 150 % or more, and is, for example, 300 % or less. To be more specific, the length L5 of one side of the support concave portion 22 is, for example, 0.3 mm or more, or preferably 1.0 mm or more, and is, for example, 5.0 mm or less, or preferably 3.0 mm or less. A width L6 of the support protruding portion 23 is, for example, 0.3 mm or more, or preferably 0.5 mm or more, and is, for example, 5.0 mm or less, or preferably 3.0 mm or less.

A depth T6 of the support concave portion 22 (that is, a protruding depth T6 of the support protruding portion 23) is adjusted to the length that corresponds to a protruding length T7 of a pressure-sensitive adhesive protruding portion 25 to be described next (ref: FIG. 17 (c)). To be specific, the depth T6 of the support concave portion 22 is, for example, 0.01 mm or more, preferably 0.05 mm or more, or more preferably 0.1 mm or more, and is, for example, 1 mm or less, preferably 0.8 mm or less, or more preferably 0.5 mm or less.

The pressure-sensitive adhesive layer 3 is continuously provided on the support substrate 2 so as to be filled in all of the support concave portions 22 and to cover the upper surface of the support protruding portion 23. The upper surface of the pressure-sensitive adhesive layer 3 is formed into a flat shape.

### [Phosphor Sheet Disposing Step]

As shown in FIG. 17 (c), in the phosphor sheet disposing step, the phosphor sheet 5 is pushed in with respect to the upper portions of a plurality of the LEDs 4 until the lower surface of the phosphor sheet 5 comes in contact with the upper surface of the pressure-sensitive adhesive protruding portion 25 that corresponds to the support protruding portion 23 in the pressure-sensitive adhesive layer 3. That is, first, the lower surface of the phosphor sheet 5 comes in contact with the upper surfaces of a plurality of the LEDs 4 and thereafter, a plurality of the LEDs 4 are pressurized downwardly by the phosphor sheet 5, so that the pressure-sensitive adhesive layer 3 that is disposed in opposed relation to the lower side of the LEDs 4, that is, the pressure-sensitive adhesive layer 3 that is filled in the support concave potions 22 pressurizes the pressure-sensitive adhesive layer 3 that covers the upper surface of the support protruding portion 23 outwardly (in the right-left and the front-rear directions). Then, the pressure-sensitive adhesive layer 3 that covers the upper surface of the support protruding portion 23 is swollen upwardly by the support protruding portion 23. To be specific, the pressure-sensitive adhesive protruding portion 25 that protrudes toward the upper side with respect to the lower surfaces of the LEDs 4 (the upper surface of the surrounding pressure-sensitive adhesive layer 3) is formed. The pressure-sensitive adhesive protruding portion 25 is, in sectional view, formed into a shape that corresponds to the support protruding portion 23. To be specific, the pressure-sensitive adhesive protruding portion 25 is formed into a shape that protrudes in the form of a generally rectangular shape in sectional view toward the upper side with respect to the surrounding pressure-sensitive adhesive layer 3.

The pressure-sensitive adhesive protruding portion 25 is formed so as to ensure the space 30.

The protruding length T7 of the pressure-sensitive adhesive protruding portion 25 is set to be the thickness T2 of the space 30 (ref: FIG. 17 (c)), to be specific, the length obtained by subtracting the thickness T1 (the entering length) of the entering portion 31 from the thickness T0 of the LED 4.

In the method for producing the phosphor layer-covered LED 10 in the eleventh embodiment, the same function and effect as that of the second embodiment can be achieved. Furthermore, by accurately setting the protruding length T7 of the pressure-sensitive adhesive protruding portion 25 and consequently, the protruding length T6 of the support protruding portion 23, the pushed-in amount of the phosphor sheet 5 is capable of being accurately adjusted. In this way, the desired thickness T2 of the space 30 is capable of being accurately adjusted.

### <Modified Example>

In the eleventh embodiment, the pressure-sensitive adhesive protruding portion 25 is formed in the phosphor sheet disposing step (ref: FIG. 17 (c)). Alternatively, for example, the pressure-sensitive adhesive protruding portion 25 can be formed in the LED disposing step (ref: FIG. 18 (b)).

That is, as shown in FIG. 19 (b), in the LED disposing step, a plurality of the LEDs 4 are disposed on the pressure-sensitive adhesive layer 3, so that the pressure-sensitive adhesive protruding portion 25 is formed. To be specific, in the LED disposing step, when the LEDs 4 are disposed in the pressure-sensitive adhesive layer 3, the pressure-sensitive adhesive layer 3 is pressurized with respect to the LEDs 4 and in this way, the pressure-sensitive adhesive protruding portion 25 is formed around the placement regions 24.

Although not shown, the through holes 21 (ref: FIGS. 15 and 16) can be also provided in the support concave portions 22 in the support substrate 2 shown in FIGS. 17 and 18.

## Claims

1. A method for producing an encapsulating sheet-covered semiconductor element comprising:
a semiconductor element disposing step of disposing a plurality of semiconductor elements at spaced intervals to each other and
an encapsulating sheet disposing step of disposing an encapsulating sheet so as to cover a plurality of the semiconductor elements and to form a space over the semiconductor elements adjacent to each other.

2. The method for producing an encapsulating sheet-covered semiconductor element according to claim 1, wherein
the encapsulating sheet exposes a portion of opposed surfaces of the semiconductor elements that are opposed to each other.

3. The method for producing an encapsulating sheet-covered semiconductor element according to claim 1, wherein
the semiconductor element is an optical semiconductor element.

4. The method for producing an encapsulating sheet-covered semiconductor element according to claim 3, wherein
the optical semiconductor element is an LED.

5. The method for producing an encapsulating sheet-covered semiconductor element according to claim 1, wherein
the encapsulating sheet is a phosphor sheet containing a phosphor.

6. An encapsulating sheet-covered semiconductor element obtained by a method for producing an encapsulating sheet-covered semiconductor element comprising:
a semiconductor element disposing step of disposing a plurality of semiconductor elements at spaced intervals to each other and
an encapsulating sheet disposing step of disposing an encapsulating sheet so as to cover a plurality of the semiconductor elements and to form a space over the semiconductor elements adjacent to each other.

7. A method for producing a semiconductor device comprising the steps of:
preparing an encapsulating sheet-covered semiconductor element obtained by a method for producing an encapsulating sheet-covered semiconductor element including a semiconductor element disposing step of disposing a plurality of semiconductor elements at spaced intervals to each other and an encapsulating sheet disposing step of disposing an encapsulating sheet so as to cover a plurality of the semiconductor elements and to form a space over the semiconductor elements adjacent to each other and
mounting the semiconductor element of the encapsulating sheet-covered semiconductor element on a substrate or mounting a plurality of the semiconductor elements on a substrate in advance.

8. A semiconductor device obtained by a method for producing a semiconductor device comprising the steps of:
preparing an encapsulating sheet-covered semiconductor element obtained by a method for producing an encapsulating sheet-covered semiconductor element including a semiconductor element disposing step of disposing a plurality of semiconductor elements at spaced intervals to each other and an encapsulating sheet disposing step of disposing an encapsulating sheet so as to cover a plurality of the semiconductor elements and to form a space over the semiconductor elements adjacent to each other and
mounting the semiconductor element of the encapsulating sheet-covered semiconductor element on a substrate or mounting a plurality of the semiconductor elements on a substrate in advance.
